# EUROPEAN PATENT APPLICATION

(11) **EP 0 218 225 A2**
(43) Date of publication of application: **15.04.1987**
(21) Application number: 86113759.4
(22) Date of filing: 12.04.1984
(51) Int. Cl.: G01R 15/02, G01R 19/145

(54) **Transmission line mounted sensor module**

(30) Priority: 13.04.1983 US 484681
(62) Divisional of application: 84302514.9
(71) Applicant: NIAGARA MOHAWK POWER CORPORATION, Syracuse New York 13202 (US)
(72) Inventor: Fernandes, Roosevelt Adolfo, Liverpool New York 13088 (US); Smith-Vaniz, William Reid, Darien Connecticut 06820 (US); Burbank III, John Emerson, Ridgefield Connecticut 06877 (US); Sieron, Richard Leonard, Fairfield Connecticut 06430 (US)
(74) Representative: Blatchford, William Michael

(57) **Abstract**

Self contained radio transmitting state estimator modules are mounted on power conductors on both sides of power transformers in electrical substations and on power conductors at various places along electrical transmission lines. They are electrically isolated from ground and all other conductors. These modules are capable of measuring current, voltage, frequency and power factor (or the fourier components thereof) the temperature of the conductor, and the temperature of the ambient air. The modules transmit these parameters to local receivers. The receivers are connected by an appropriate data transmission link, to a power control center which allows determination of the state of the power system. Appropriate control signals are transmitted back to the electrical switchgear of the system to bring it to the appropriate optimum state. Direct local control may also be effected, for example, the prevention of overloading a transformer. A «donut» state estimator module comprises a novel hot stick operated hinge clamp and a novel voltage sensor which measures the current between an isolated capacitor plate and ground. The donut measures the fourier components of voltage and current over a number of cycles and transmites the components to the local receiver. The local receiver derives the desired electrical measurements such as voltage, current, power factor, power, and reactive power and transmits them to local or remote control stations. Up to 15 donut modules may transmit on a single channel to a single local receiver. Each transmits at intervals which are an integral number. The intervals between transmissions of all donuts do not have a common factor and the average interval is the desired transmission rate. Each donut uses the zero crossover of current of its conductor to establish its transmission interval. The system is self- calibrating using known reference signals within the donut module.

## Description

This invention relates to transmission line mounted sensor module, and particularly to such a module for use in a system for the monitoring and control of a bulk electrical power delivery system, and to transmission line mounted radio transmitting electrically isolated apparatus.

Various power line monitoring sensors have been disclosed in the prior art. For example, see United States Patent Nos. 3,428,896, 3,633,191, 3,983,477, 4,268,818. It has been proposed to use sensors of this type for dynamic line rating of electrical power transmission lines. See for example, papers numbered 82 SM 377-0 and 83 SM 378-8 entitled DYNAMIC THERMAL LINE RATINGS, PART I, DYNAMIC AMPACITY RATING ALGORITHM: and, DYNAMIC THERMAL LINE RATINGS, PART II, CONDUCTOR TEMPERATURE SENSOR AND LABORATORY FIELD TEST EVALUATION; papers presented at the International Association of Electrical and Electronic Engineers P.E.S. 1982 summer meeting. These papers are incorporated herein by reference. However, the full potential of this new technology has not been realised. Further sensors of the type shown in the above prior art are disclosed, albeit in a much improved form, in U.S. Patent No. 4,384,229, the contents of which are incorporated in this specification by reference.

Today, for control and protection, power supply to and from an electrical substation over various transmission lines is monitored by separate devices (current transformers, potential transformers and reactive power transducers) for measuring electrical potential, power factor and current in the conductors of the transmission line and the conductors connected to substation power transformers. These measurements are transmitted in analog fashion by various wires to a central console at the substation where their values may or may not be digitized and sent to a central station for control of the entire power system. The wiring of these devices is difficult and expensive, and every excess wire in a substation presents an additional electrical shock hazard or an induction point for electromagnetic interference on protection/telemetry circuits. Furthermore, when a failure occurs, these sensor lines may be abruptly raised to higher voltages, thus increasing the possibility of shock and failure in the measurement system.

The high cost of capital, uncertain utility load growth trends, coupled with increasing constraints in acquiring and licensing new facilities including right- of-way for transmission lines make greater use of existing power delivery facilities (remote generating stations, the EHV bulk power network, subtransmission and distribution facilities) a paramount consideration. With deferrals that have occurred in new generation and power transmission facilities, all elements of the power system will be strained to a greater degree than in the past. In order to maintain current reliability levels under these conditions, additional real-time monitoring will be required to assist the dispatch operator and other bulk network functions conducted through a modern Power Control Centre.

Some of the functions in a hierarchical modern Power Control Centre, operating through Regional Control Centres down to the distribution level, that require a real-time Supervisory Control and Data Acquisition System are as follows:-
1. State Estimation
2. On-Line Load Flow Detection
3. Optimum Power Flow Control for Real and Reactive Power Dispatch
4. Security (i.e. Stability) Constrained Economic Dispatch
5. Contingency Analysis
6. Automatic Generation Control and Minimum Area Control Error
7. Dynamic System Security Analysis
8. Energy Interchange Billing
9. System Restoration After an Emergency
10. Load Shedding and Generation Redispatch
11. Determination of Effects of Voltage Reduction and Real and Reactive Power
12. Synchronization of System Load Profiles to validate various computer models and to provide snap shots of maximum, minimum loads, peak day real and reactive powers on lines and equipment
13. Maintain Power Delivery Quality Including Harmonic Content for Critical Loads and Power Factor
14. Limit checking of voltage, line thermal loadings and rate of change under contingency conditions
15. Protective Relaying.

The key parameters that require measurement for a modern Power Control Centre State Estimator and On-Line Load Flow that provide the input data base for the various functions listed above are:
Line and Transformer Bank or Bus Power (MW) Flows Line and Transformer Bank or Bus Reactive Power (MVAR) Flow
Branch Currents (I), Bus Voltage and Phase Angles Bus MW and MVAR Injections
Energy (MWh) and Reactive Energy (MVAR-h) Circuit Breaker Status
Manual Switch Positions
Tap Changer Positions
Frequency (f)
Protective Relaying (Differential Currents, etc.) Operation
Power Line Dynamic Ratings Based on Conductor Thermal (Temperature) Limits or Sag
Ambient Temperature/Wind Speed
Line and Equipment Power Factors Sequence-of-Events Monitoring

One of the major problems in implementing a modern Power Control System is to add instrumentation throughout the bulk transmission network at Extra High Voltage (up to 765 kV) line voltages and at distribution substations and feeders. This must be done without disrupting existing operations of equipment and facilities that are largely in place.

According to a first aspect of the present invention, there is provided an electrical power line state estimator module comprising: (A) a generally toroidal shaped two-piece housing; (B) at least one sensor contained in said housing for measuring at least one characteristic of a power line; (C) a transmitter in said housing for transmitting through the air measurements made by said sensor; (D) a hinge clamp openable by a hot stick mounted tool connecting the two pieces of said housing together such that they may be clamped about an energized electrical power line. The module may be operable to measure all or one of the following characteristics: power line temperature, power line voltage, power line current, and cyclic characteristics of power transmitted on the power line.

According to another aspect of the invention there is provided an alternating current power line state estimator module comprising: (A) a generally toroidal shaped housing for mounting about a power line; (B) means for measuring the amplitude of at least one cyclic characteristic of the power on said line at a plurality of fixed and equally separated time phases of said cyclic characteristic; (C) means for calculating the Fourier components of said characteristic from said measurements; and (D) a transmitter for transmitting said components over a communications channel.

The power line may form part of an electric power delivery network including a plurality of power lines connected on the primary and secondary side of a power transformer, the sensor modules may be attached on both sides of the transformer, whereby the state of the transformer may be determined. Where the network has a plurality of substations, including power transformers, a plurality of sensor modules may be provided at one substation on the primary and the secondary side of the relevant power transformer, and, likewise, sensor modules may be provided on both sides of such a transformer at another substation coupled to the first substation by a transmission line. Both substations have associated therewith respective radio receivers and state determining apparatus for determining the state of the respective transformers, with the substation state determining apparatus being connected via communications link to a central station having system state determining apparatus. Control apparatus coupled to the system state determining apparatus is provided for controlling the network in accordance with the state of the network as determined by the system state determining apparatus.

In preferred embodiments of the system of the invention, the number of modules or transducers is limited to avoid altering the burden on existing current transformers and degrading accuracy of existing metering or relaying instrumentation. In a preferred embodiment, the modules comprise toroidal conductor State Estimator Modules associated with a ground station processor, and a receiver/transmitter. These units can be so arranged to eliminate the necessity for the multiple wiring of transducers required with conventional current and potential transformers and collect all the data required from lines and station buses with a compact system. Use of the system as described in the present specification can result in significant investment, installation labour and time savings. It completely eliminates the need for multiple transducers, hard-wiring to current transformers and potential transformers and any degrading effects on existing relaying or metering links. The system can be retrofitted on existing lines or stations or new installations with equal ease and measures:
Line Voltage
Power Factor or Phase Angle
Power Per Phase
Line Current
Reactive Power Per Phase
Conductor Temperature
Ambient Temperature
Wind Speed
Harmonic Currents
Frequency
MW-h and MVAR-h (processed quantities)
Profiles of above quantities from stored values

The state-estimator data collection system described in this application enables power utilities to implement modern power control systems more rapidly, at lower cost and with considerable flexibility, since the devices can be moved around using hot-sticks without having to interrupt power flow. The devices can be calibrated and checked through the radio link and the digital output can be multiplexed with other station data to a central processor via remote communication link.

In its preferred form the state estimator module includes a positive acting mechanism for hinging the two parts of the module and securely clamping and unclamping them about a live conductor while supported by a hot stick. The module allows measurement of the voltage of the conductor in a self-contained electrically isolated assembly which is small and light and uses a single radio channel in common with other modules so that up to fifteen may be used at a single substation.

Such hot stick activated hinge and clamp mechanisms do not exist in the prior art. The voltage transformers and capacitive dividers of the prior art are not electrically isolated. Separate measurements of all electrical quantities desired would require too much apparatus in the module. Synchronization of module transmissios would require a radio receiver in each module.

The main features of the preferred system are as follows.

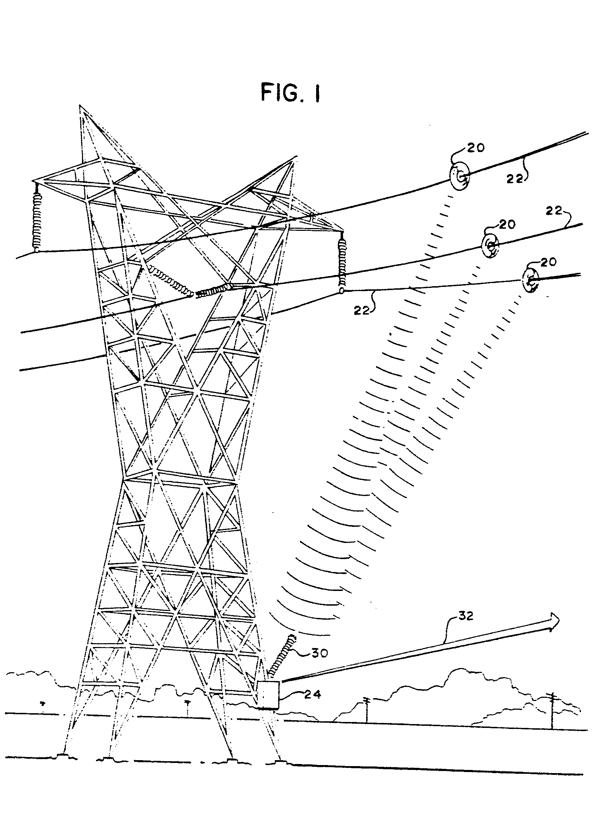

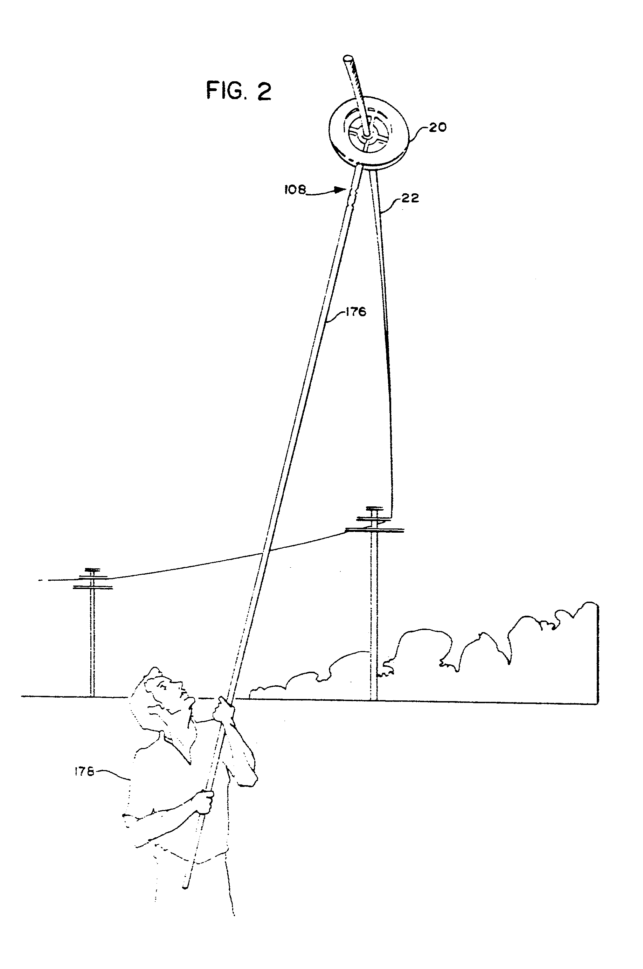

Referring to Figure 1, toroidal shaped sensor and transmitter modules 20 are mounted on live power conductors 22 by use of a special, detachable hot-stick tool 108 (see Figure 2) which opens and closes a positively actuated hinging and clamping mechanism. Each module contains means for sensing one or more of a plurality of parameters associated with the power conductor 22 and its surrounding environment. These parameters include the temperature of the power conductor 22, the ambient air temperature near the conductor, the current flowing in the conductor, and the conductor's voltage, frequency, power factor and harmonic currents. Other parameters such as wind velocity and direction and solar thermal load could be sensed, if desired. In addition, each module 20 contains means for transmitting the sensed information to a local receiver 24.

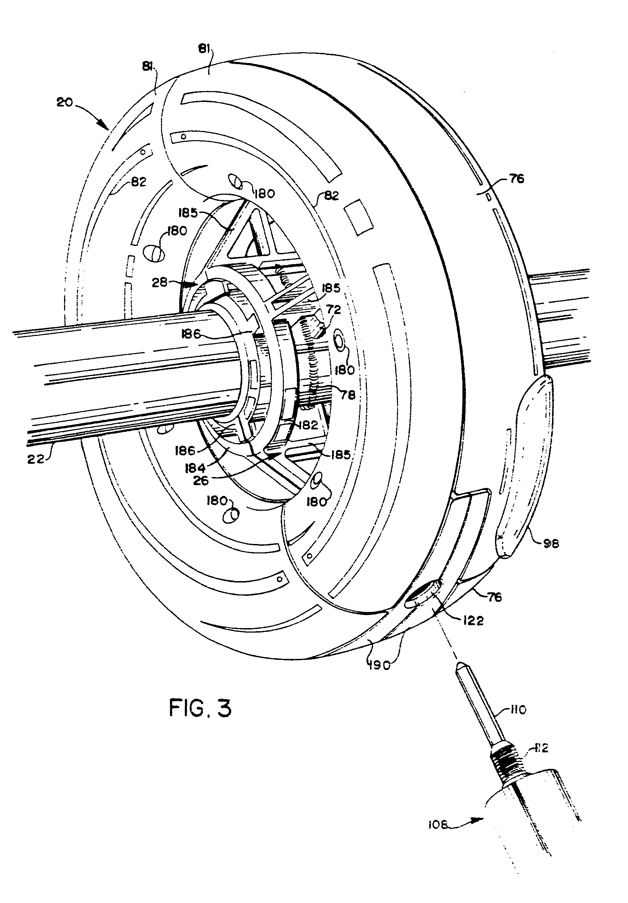

Referring to Figure 3, each toroidal module 20 is configured with an open, spoked area 26 surrounding the mounting hub 28 to permit free air circulation around the conductor 22 so that the conductor temperature is not disturbed. The power required to operate the module is collected from the power conductor by coupling its magnetic field to a transformer core encircling the line within the toroid. The signals produced by the various sensors are converted to their digital equivalents by the unit electronics and are transmitted to the ground receiver in periodic bursts of transmission, thus minimizing the average power required.

One or more of these toroidal sensor units, or modules, may be mounted to transmission lines within the capture range of the receiver and operated simultaneously on the same frequency channel. By slightly varying the intervals between transmissions on each module, keeping them integral numbers without a common factor and limiting the maximum number of modules in relation to these intervals, the statistical probability of interference between transmissions is controlled to an acceptable degree. Thus, one-receiver, ground station 24, can collect data from a plurality of modules 20.

The ground station 24, containing a receiver and its antenna 30, which processes the data received, stores the data until time to send or deliver it to another location, and provides the communication port indicated at 32 linking the system to such location. The processing of the data at the ground station 24 includes provisions for scaling factors, offsets, curve correction, waveform analysis and correlative and computational conversion of the data to the forms and parameters desired for transmission to the host location. The ground station processor is programmed to contain the specific calibration corrections required for each sensor in each module in its own system.

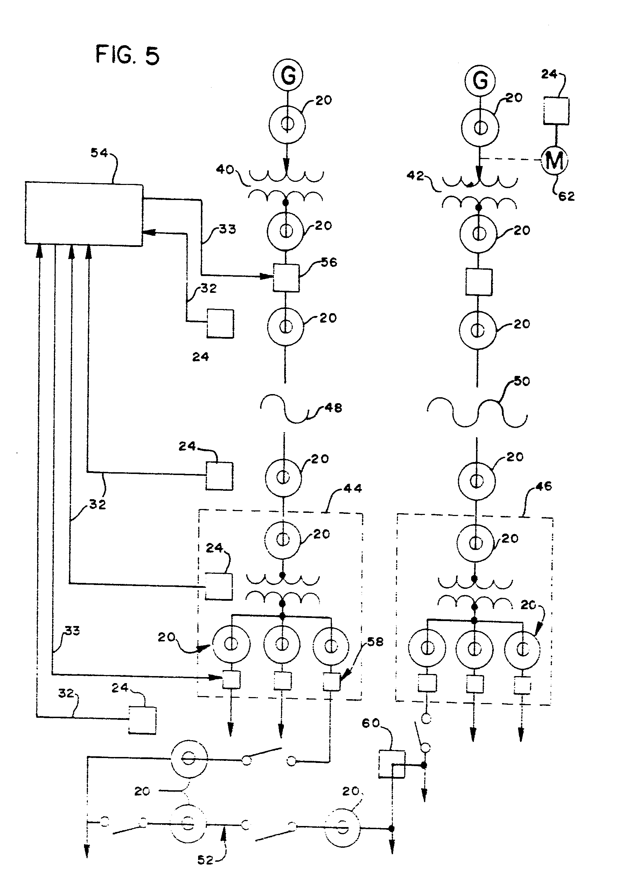

Referring to Figure 5, the ground stations 24 are connected to the Power Control Center 54 by appropriate data transmission links 32 (radio, land lines or satellite channels) where the measured data is processed by a Dynamic State Estimator which then issues'appropriate control signals over other transmission links 33 to the switchgear 58 at electrical substations 44. Thus the power supply to transmission lines may be varied in accordance with their measured temperatures and measured electrical parameters. Similarly, when sensors are located in both the primary and secondary circuits of power transformers, transformer faults may be detected and the power supplied to the transformer controlled by the Dynamic State Estimator through switchgear.

A Dynamic State Estimator may be located at one or more substations to control the supply of electrical power to the transformers located there or to perform other local control functions.

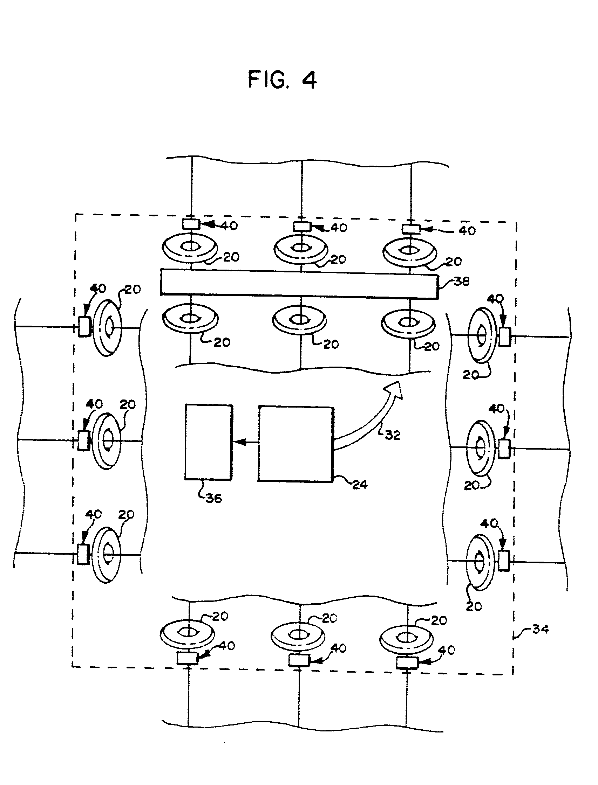

Thus, as shown in Figure 4, an electrical substation 34 may be totally monitored by the electrically isolated modules 20 of the invention. Up to 15 of these modules may be connected as shown transmitting to a single receiver 24. The receiver may have associated therewith local control apparatus 36 for controlling the illustrative transformer bank 38 and the electrical switchgear indicated by the small squares 40. The modules 20 may be mounted to live conductors without the expense and inconvenience of disconnecting any circuits and require no wiring at the substation 34. The receiver 24 also transmits via its transmission link 32 the information received, from the modules 20 (for determining the total state of the electrical substation) to the Central Control Station 54 of the electrical delivery system.

The system is adapted for total monitoring and control of a bulk electrical power delivery system as illustrated in Figure 5. Here, modules 20 are located throughout the delivery system monitoring transformer banks 40 and 42, substations 44 and 46, transmission lines generally indicated at 48 and 50, and feeder sections generally indicated at 52.

A number of modules are preferably located along transmission lines such as lines 48 and 50, one per phase at each monitoring position. By monitoring the temperature of the conductors they indicate the instantaneous dynamic capacity of the transmission line. Since they are located at intervals along the transmission line they can be utilized to determine the nature and location of faults and thus facilitate more rapid and effective repair.

The ground stations 24 collect the data from their local modules 20 and transmit it to the Power Control Center 54 on transmission links 33. The Power Control Center, in turn, controls automatic switching devices 56, 58 and 60 to control the system.

As illustrated in Figure 5, ground station 24 located at transformer bank 42 may be utilized to control the power supplied to transformer bank 42 via a motorized tap system generally indicated at 62.

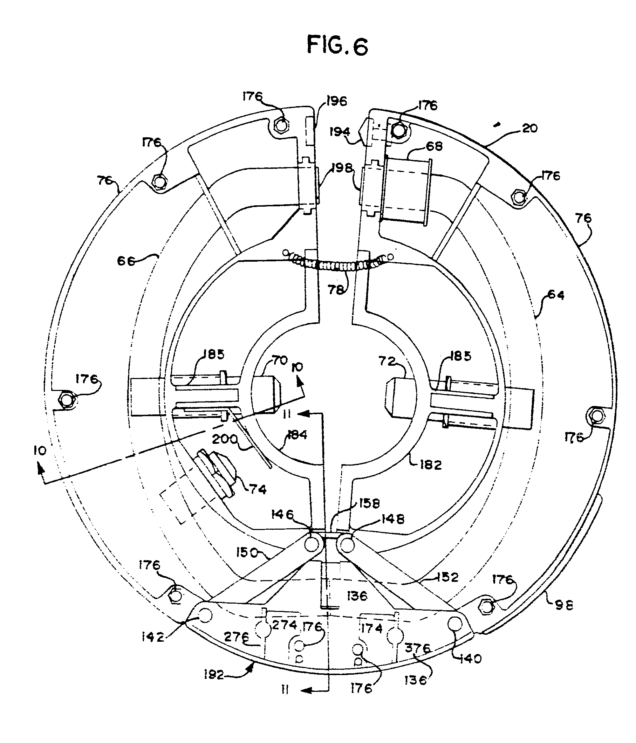

As shown in Figure 6, the module 20
comprises two halves of a magnetic core 64 and 66, and a power takeoff coil 68, and two spring loaded temperature probes 70 and 72 which contact the conductor and an ambient temperature probe 74.

In order to insure that the case 76 is precisely at the potential of the conductor 22 when the conductors are contacted by the probes 70 and 72, a spring 78 is provided, which engages the conductor 22 and remains engaged with the conductor and connects it to the case 76 before and during contact of the probes 70 and 72 with the conductor. Alternatively, or simultaneously, contact may be maintained through conductive inputs in the hub 28.

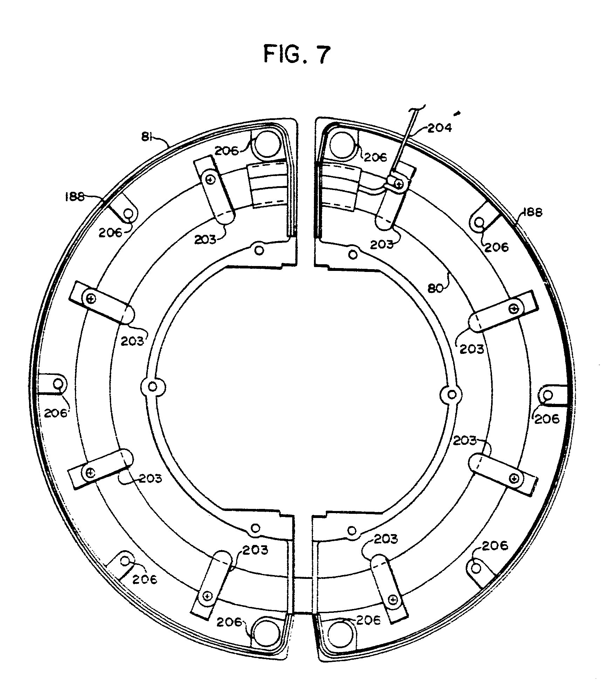

The electrical current in the conductor is measured by a Rogowski coil 80 shown in Figure 7.

The voltage of the conductor is measured by a pair of arcuate capacitor plates 82 in the cover portions of the donut, only one of which is shown in Figures 8 and 9. The electronics is contained in sealed boxes 84 within the donut 20 as shown in Figure 10.

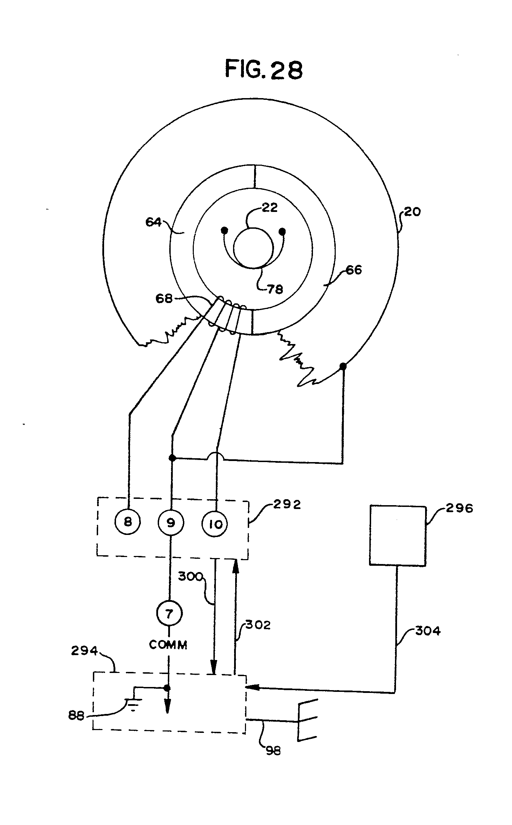

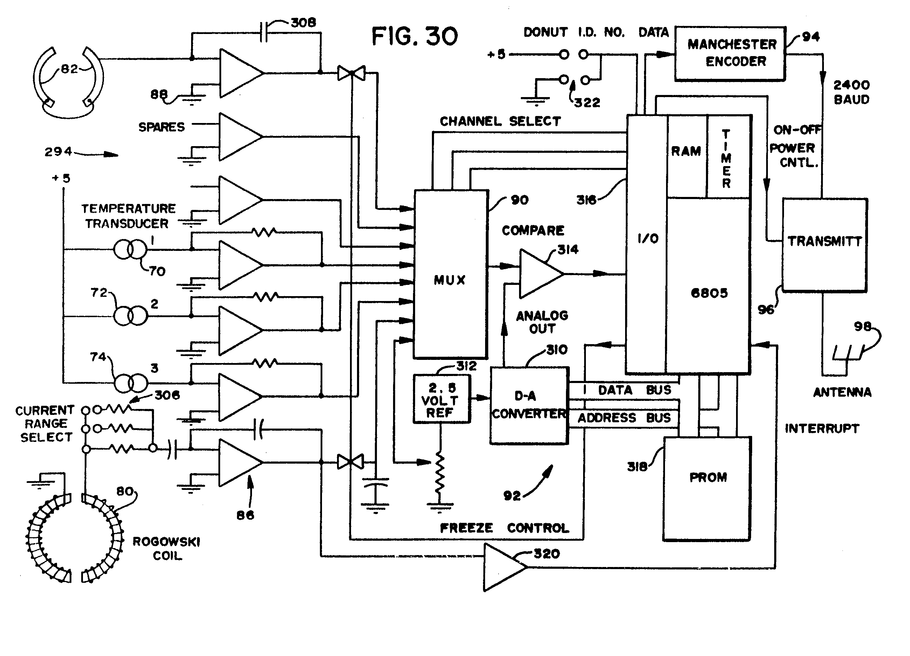

Block diagrams of the electronics of the donut 20 are shown in Figures 28 and 30.

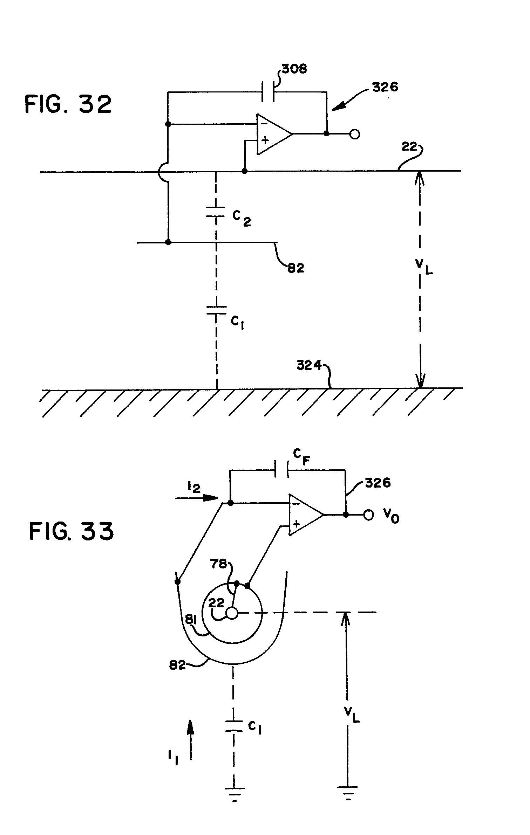

Referring to .Figure 30, the voltage sensing plates 82 are connected to one of a plurality of input amplifiers generally indicated at 86. The input amplifier 86 connected to the voltage sensing plates 82 measures the current between them and local ground indicated at 88, which is the electrical potential of the conductor 22 on which the donut 20 is mounted. Thus the amplifier 86 provides a measure of the current., flowing between the plates 82 and the earth through a capacitance C₁ (see Figures 32 and 33). That is, it measures the current collected by the plates 86 which would otherwise flow to local ground. This is a direct measure of the voltage of the conductor with respect to earth.

As also shown in Figure 30, the temperature transducers 70, 72, and 74, and Rogowski coil 80 are each connected to one of the input amplifiers 86. An additional temperature transducer may be connected to one of the spare amplifiers 86 to measure the temperature of the electronics in the donut. The outputs of the amplifiers are multiplexed by multiplexer 90 and supplied to a digital-to-analog converter and computer generally indicated at 92, coded by encoder 94, and transmitted by transmitter 96 via antenna 98, which may be a patch antenna on the surface of the donut as illustrated in Figure 3.

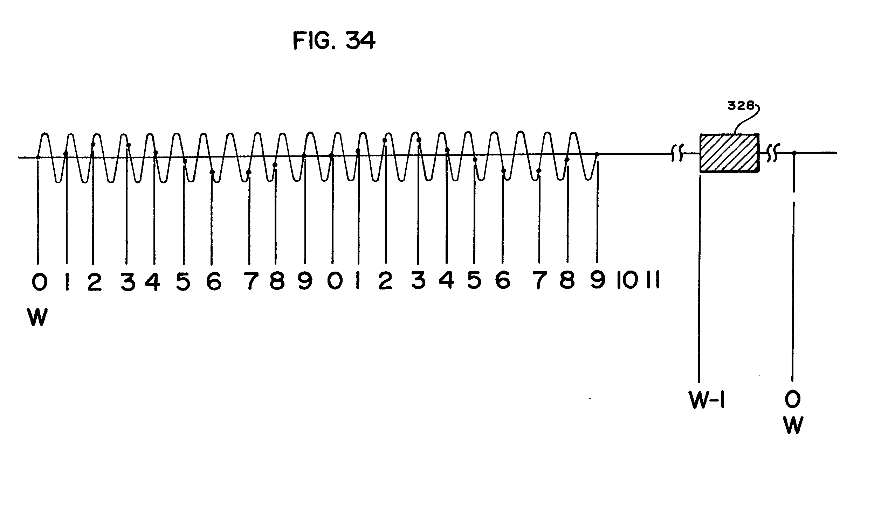

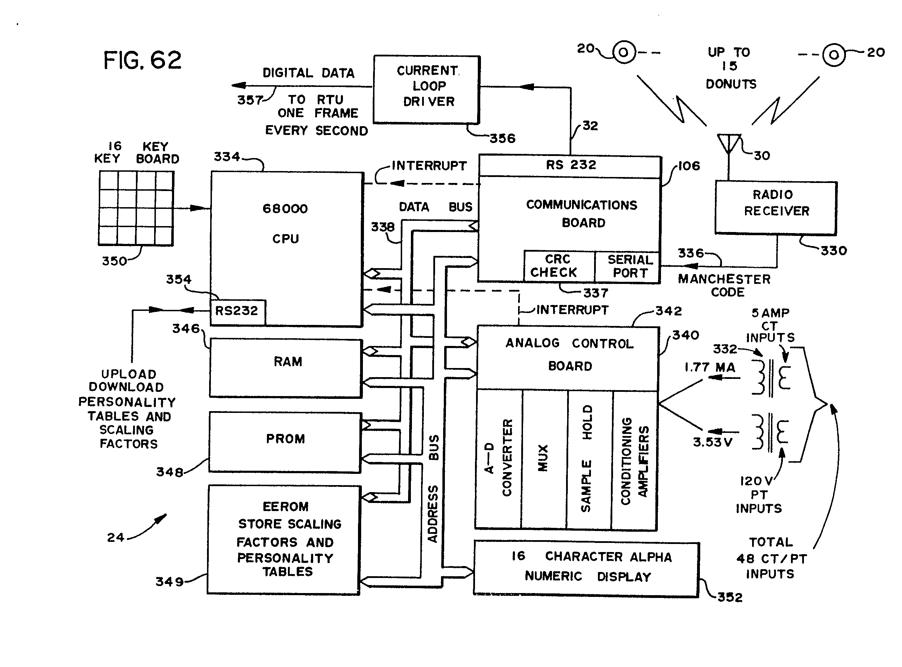

As illustrated in the timing diagram of Figure 34, the current and voltage are sampled by the computer 92 nine times at one-ninth intervals of the current wave form; each measurement being taken in a successive cycle. The computer initially goes through nine cycles to adjust the one-ninth interval timing period to match the exact frequency of the current at that time, and then makes the nine measurements. These measurements are transmitted to the ground station 24 and another computer 334 at the ground station (Figure 62) calculates the current, voltage, power, reactive power, power factor, and harmonics as desired; provides these to a communications board 106; and thus to a communications link 32.

For a maximum of fifteen donuts for which it is desired to transmit information each second or two, the relative transmission intervals can be chosen to be between 37/60ths and 79/60ths of a second; each transmission interval being an integral number of 60ths of a second which do not have a common factor. This form of semi-random transmission
will insure 76% successful transmission with less than two seconds between successful transmissions from the same donut in the worst case.

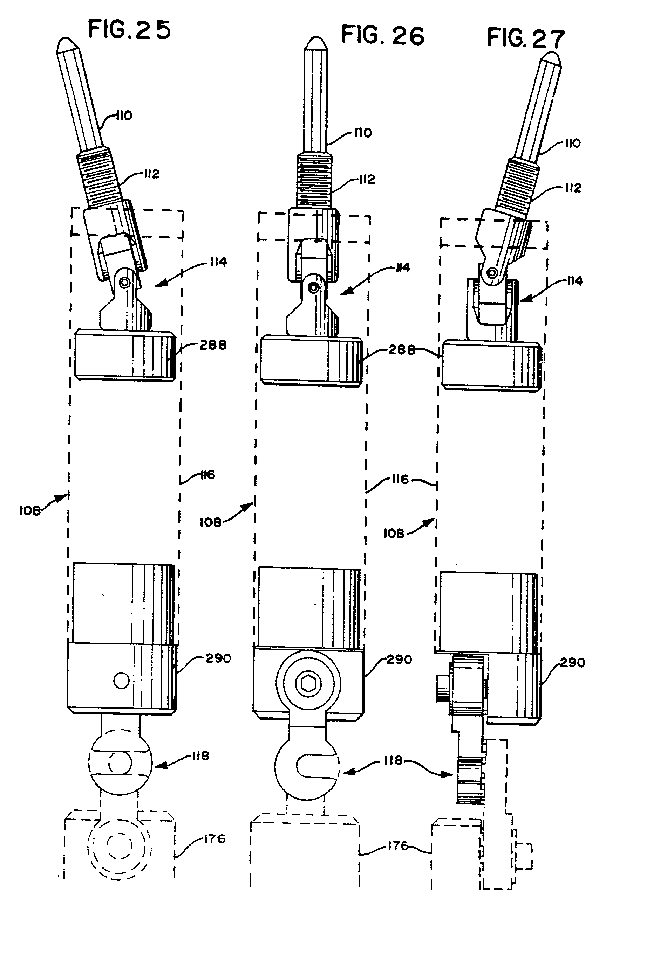

The hot stick mounting tool generally indicated at 108 in Figure 3 is shown in detail in Figures 25, 26, and 27. It comprises a Allen wrench portion 110 and a threaded portion 112, mounted to a universal generally indicated at 114. Universal 114 is mounted within a shell 116 which in turn is mounted to a conventional hot stick mounting coupling generally indicated at 118; and thus the hot stick 176.

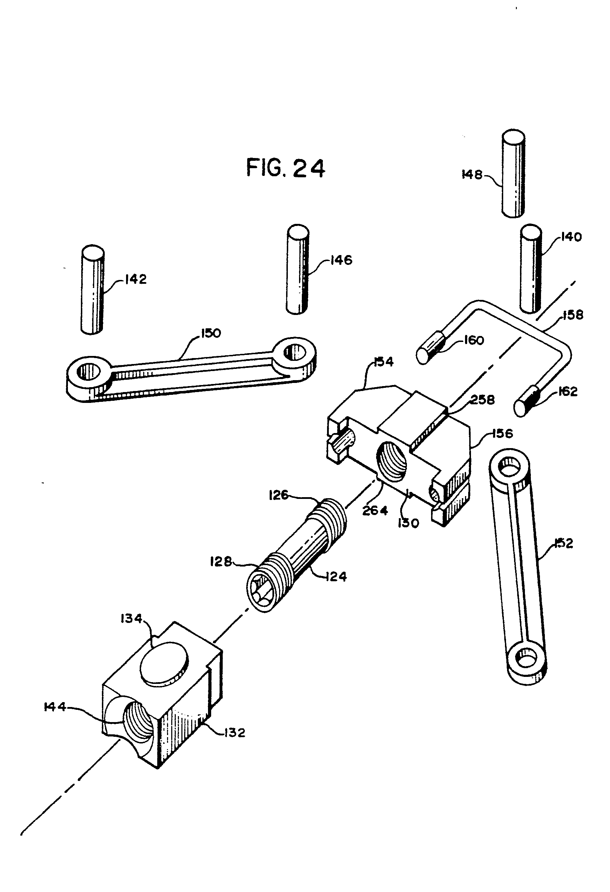

When the hot stick tool 108, as shown in Figure 3, is inserted into the opening 122 in the donut 20, the Allen wrench portion engages barrel 124 (Figure 24) which is oppositely threaded on each of its ends 126 and 128. Threaded portion 126 is engaged with a mating threaded portion of a cable clamp 130 and threaded portion 128 engages a mating threaded portion 144 of a nut 132. The nut 132 is fixed by means of bosses 134 in plates 136 and 138, mounted to hinge pins 140 and 142 (Figure 23). Thus, when the hot stick tool 108 is inserted, and barrel 124 rotated in one direction, cable clamp 130 is brought towards nut 132, while when barrel 124 is rotated in the other direction, cable clamp 130 moves away from nut 132. Threaded portion 144 of nut 132 engages the threaded portion 112 of the hot stick tool 108, such that when cable clamp 130 and nut 132 are spread apart the threaded portion 112 of the hot stick tool is threaded into nut 132 so that the donut module 20 may be supported on the tool 108.

Since hinge pins 140 and 142 are located near the outer edge of the donut 20 and fixed pins 146 and 148 are affixed to the donut more inwardly, if the pins 146 and 148 are spread apart, the donut will open to the position shown in Figure 6 and if the pins 146 and 148 are brought together, the donut will close. The pins 142 and 146 and 140 and 148 are joined by respective ramp arms 150 and 152. When cable clamp 130 is separated from nut 132, the ramp arms, and thus pins 146 and 148, are spread apart by the wedge portions 154 and 156 of cable clamp 130. At the same time the threaded portion 112 of the hot stick tool 108 engages the threaded portion 144 of nut 132 so that the donut 20 is securely mounted to the tool 108. A cable 158 passes around pins 146 and 148 and is held in cable clamp 130 by cable terminating caps 160 and 162. Thus when cable clamp 130 and nut 132 are brought together, the cable 158 pulls fixed pins 146 and 148 together to securely close the donut 20 and clamp it about the conductor 22. Shortly after it is drawn tight, the threaded portion of the hot stick tool 108 disengages the threaded portion 144 of nut 132 by continued turning in the same direction.

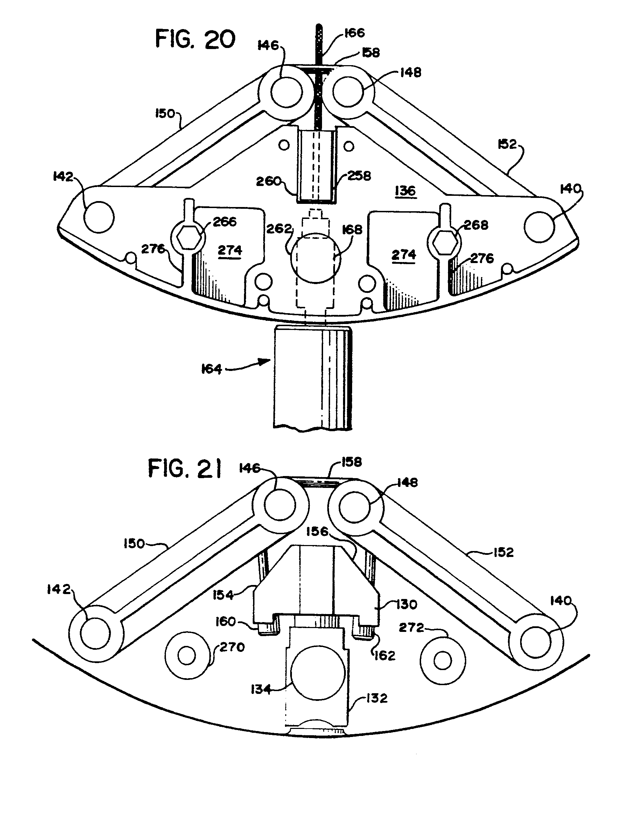

If for any reason the donut 20 cannot be removed from a conductor 22 by using the hot stick tool 108, another hot stick tool generally indicated at 164 in Figure 20 may be used to cut the cable 158. Tool 164 has a file 166 mounted thereon for this purpose. It may also be provided with a threaded portion 168 to engage the threaded portion 144 of nut 132 after the cable 158 has been severed.

The preferred embodiment of the invention provides a system predominantly employing radio transmitting modules mounted to power conductors so as to reduce greatly, if not eliminate, the use of wiring to transmit measurements at an electrical substation. The state of a substation and the power delivery system is determined dynamically. In addition thermal line ratings are determined dynamically. Also provided is a system for monitoring and controlling the status of electrical power station equipment, and in which the sensors are capable of measuring, as required, current, voltage, frequency, phase angle, the Fourier components of current and voltage from which other quantities may be calculated, the temperature of the conductor to which they are attached, or the temperature of the ambient air surrounding the conductor to which they are attached.

The preferred state estimator module senses various power quantities including those necessary for dynamic line ratings, and can be rapidly, safely and reliably installed and removed from an energized high voltage transmission facility, up to 345KV line to line. Such installation and removal makes use of standard utility "hot stick" tools with an adaptor tailored for the module and for operation by a single lineman or robot.

The "hot stick" mountable unit is light in weight, compact in size, can be remotely calibrated, and is toroidal in shape with a metallic housing comprising of a central hub suitable for various conductor sizes with the "hot stick" tool capable of opening and closing the toroidal housing around the conductor. The hub is provided with ventilating apertures and thermally insulated inserts which grip the transmission line. Such a module of the above character can be brought to conductor potential before delicate electric equipment contacts the conductor. The module maintains positive engagement with a hot stick mountable tool except when it is "snap shut" around the conductor. A hinge clamp is preferably used that may be opened by an alternative hot stick mounted tool in case of failure of the hinge clamp.

The preferred system provides an electrically isolated voltage sensor for a state estimator module of the above form. Further, the system incorporates an unsynchronized single channel radio transmission system for a plurality of modules of the above form.

The invention will now be described by way of example with reference to the drawings in which:-
Figure 1 is a perspective view of a state estimator module installed on an electrical transmission line;
Figure 2 is a perspective view showing how the state estimator module may be hot stick mounted to a live conductor;
Figure 3 is a perspective view of the state estimator module mounted to a conductor;
Figure 4 is a diagrammatic view of a substation;
Figure 5 is a diagrammatic schematic view of a monitored and controlled power delivery system in accordance with the invention;
Figure 6 is a top view of a state estimator module with its covers thereof removed;
Figure 7 is a bottom view of the covers of the state estimator module;

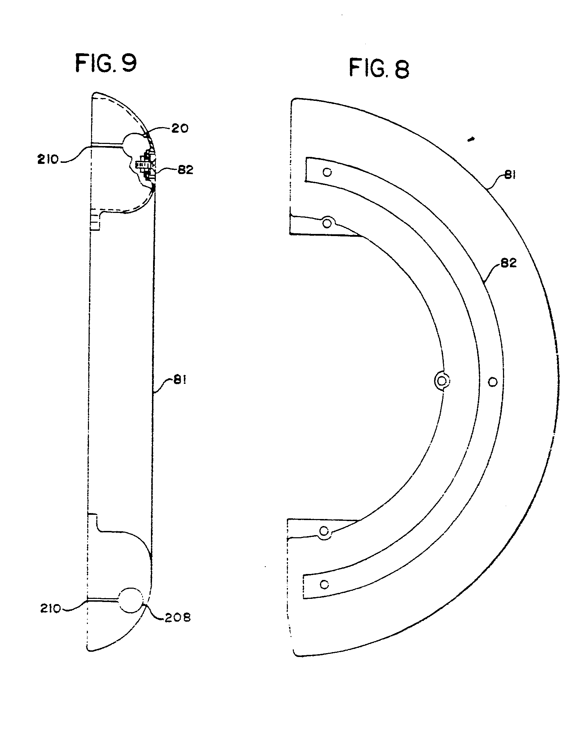

Figure 8 is a top view of one of the covers;
Figure 9 is a side view of one of the covers, partly in cross section;

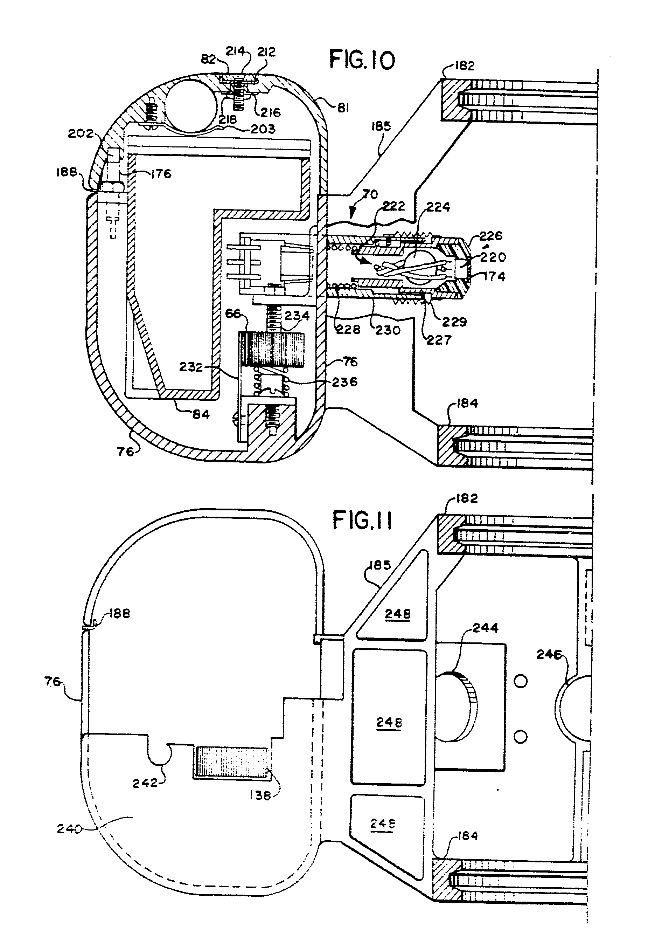

Figure 10 is an enlarged cross sectional view taken along the line 10-10 of Figure 6 with the cover in place;

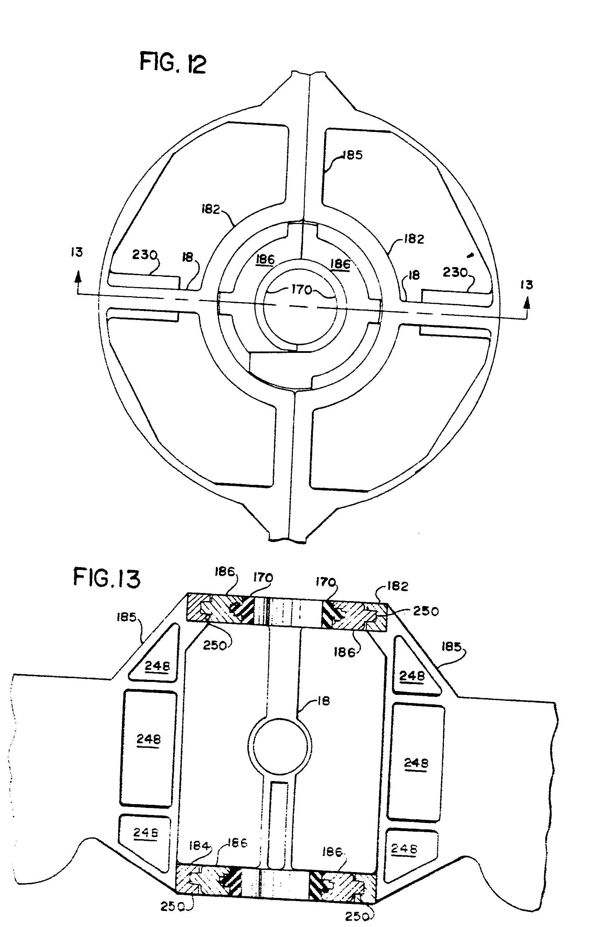

Figure 11 is an enlarged cross sectional view taken along the line 11-11 of Figure 6 with the cover in place;
Figure 12 is an enlarged fragmentary view of the hub portion of the state estimator module of Figure 6;
Figure 13 is a cross sectional view taken along the line 13-13 of Figure 12;

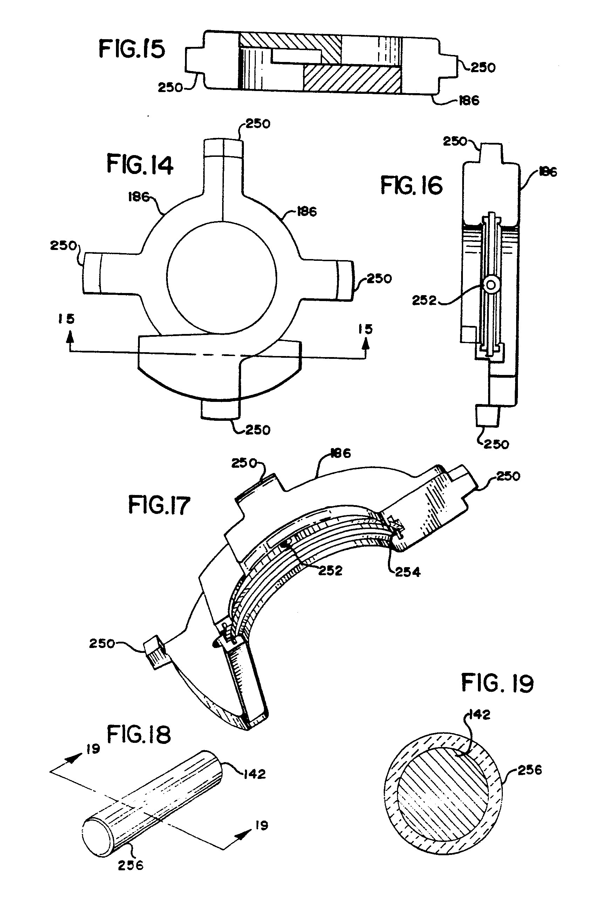

Figure 14 is an enlarged view of the conductor clamping jaws shown in Figure _{12;}
Figure 15 is a cross section taken along the line 15-15 of Figure 14;
Figure 16 is a side view showing the inside of one of the jaws shown in Figure 14;
Figure 17 is a enlarged perspective view of one of the jaws of Figure 14;
Figure 18 is a view of one of the pins of a hinge clamp mechanism ;
Figure 19 is a cross sectional view thereof taken along the line 19-19 of Figure 18;
Figure 20 is a fragmented partially diagrammatic top view of the hinge clamp and the tool utilized to open it if it jams;
Figure 21 is a top view similar to Figure 20 showing the hinge clamp mechanism when the state estimator module is clamped about a conductor;

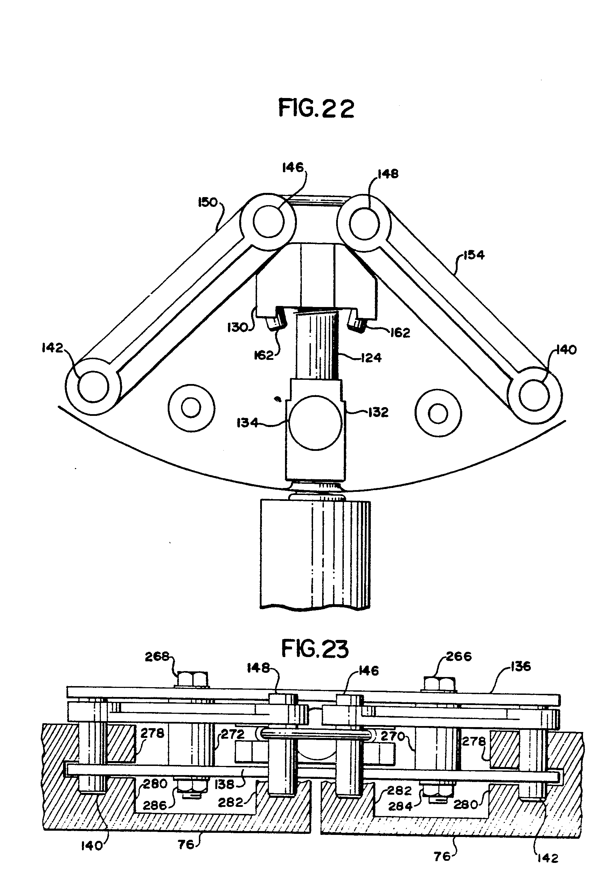

Figure 22 is a view similar to Figure 21 showing the hinge clamp mechanism when the state estimator module
   is opened for engagement or removal from a conductor;
Figure 23 is a fragmentary side view, partially in cross section taken from the top of Figure 22;
Figure 24 is an exploded cross sectional view of the working mechanism of the hinge clamp;
Figure 25 is a diagrammatic front view of a hot stick hinge clamp operating tool;
Figure 26 is a back view thereof;
Figure 27 is a side view thereof;
Figure 28 is a schematic block diagram of the electronics of a state estimator ;

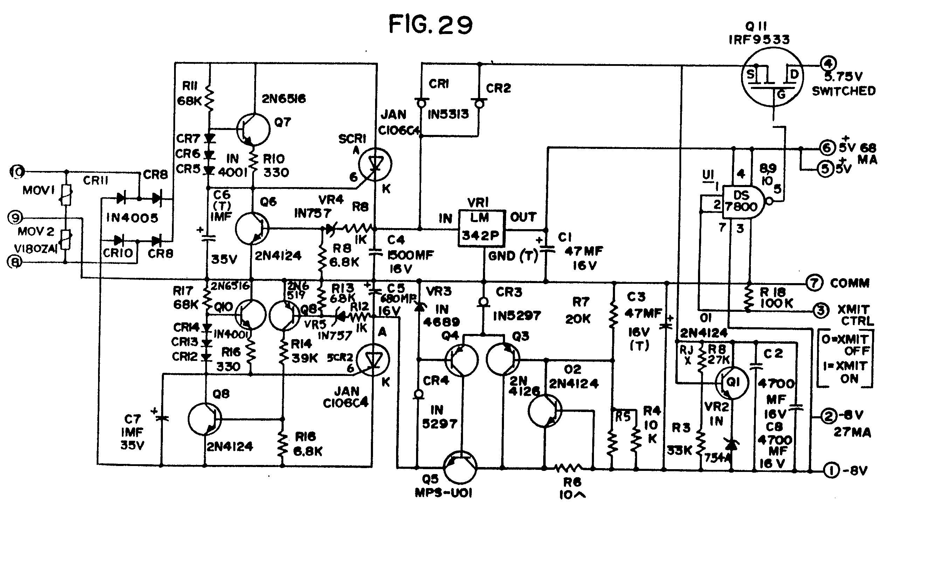

Figure 29 is a detailed schematic electrical circuit diagram of the power supply of the state estimator.
Figure 30 is a detailed electrical schematic block diagram of a portion of the electronics illustrated in Figure 28;

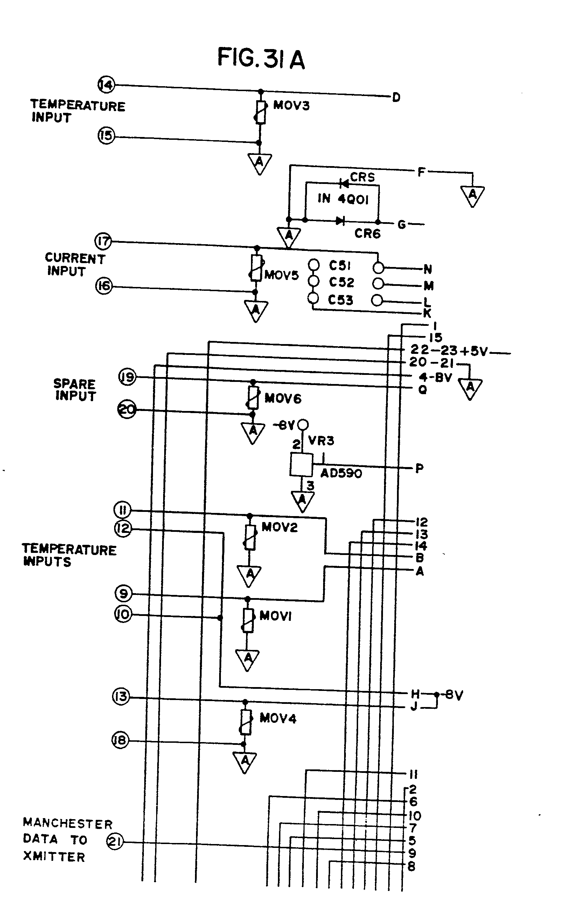

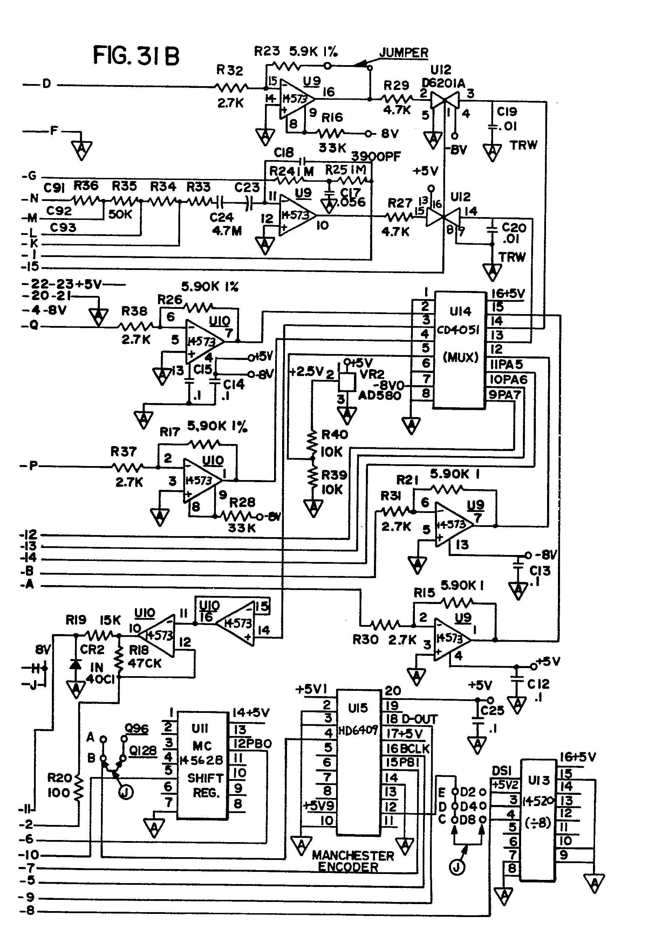

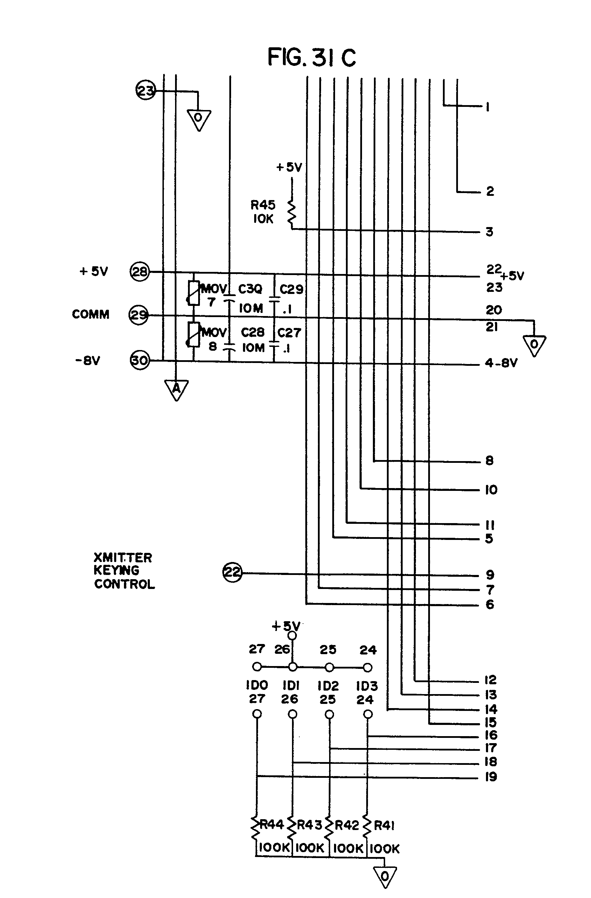

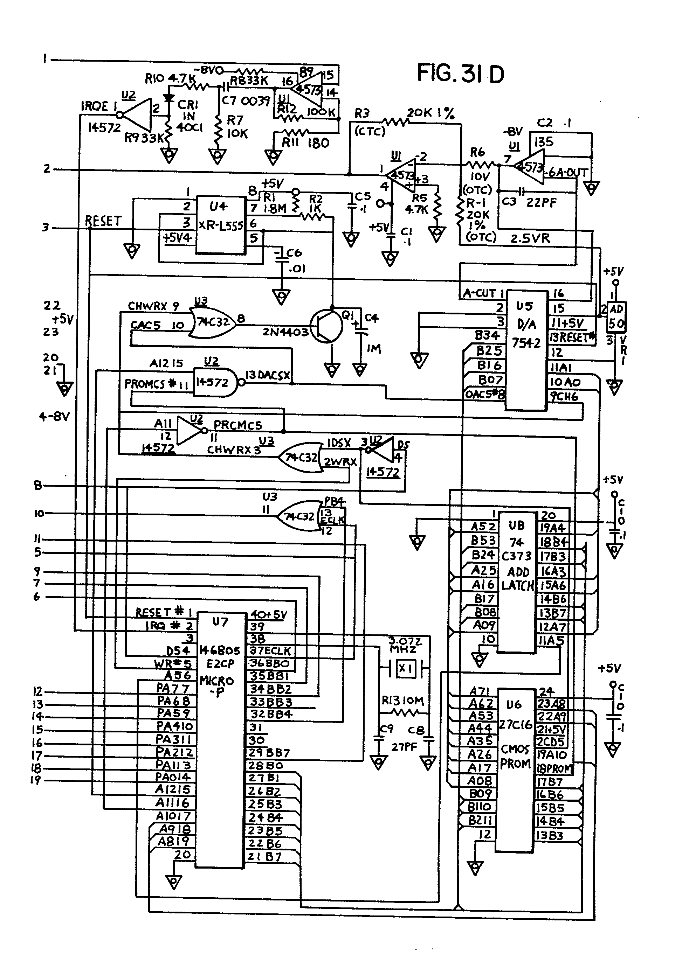

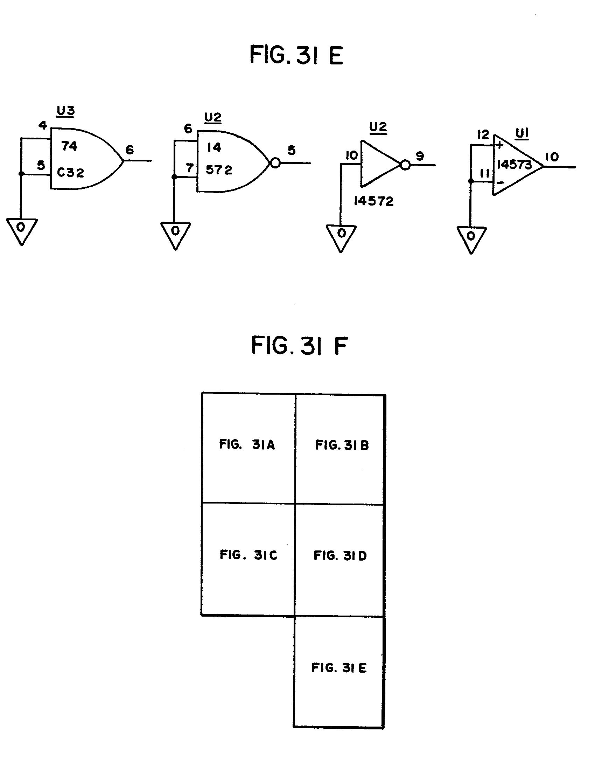

Figure 31, comprising Figures 31A through 31D which may be put together as shown in Figure 31E, is a detailed schematic electrical circuit diagram of the electronics shown in Figure 30;
Figures 32 and 33 are schematic electrical circuit diagrams illustrating a voltage measurement system;
Figure 34 is a timing diagram of the electronics illustrated in Figure 30;

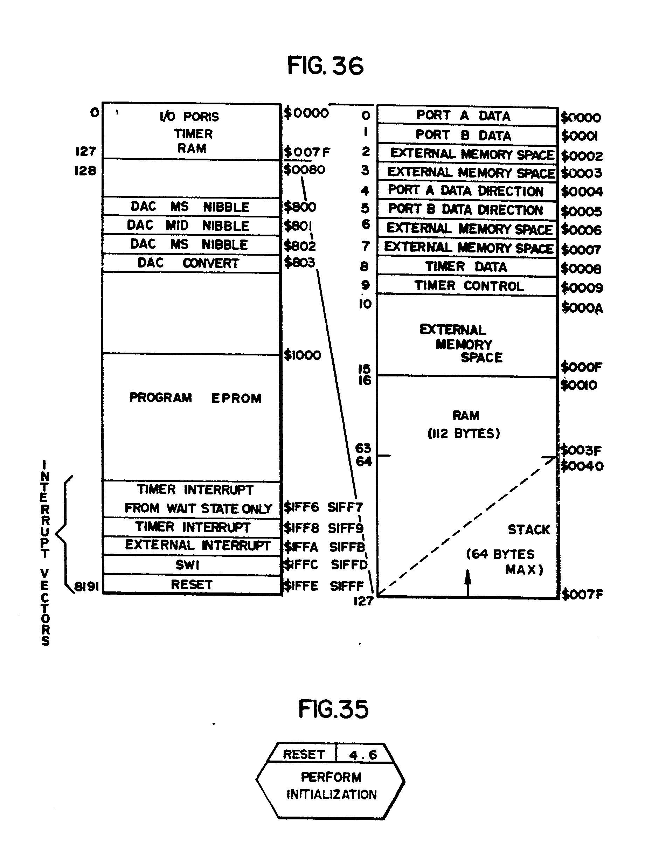

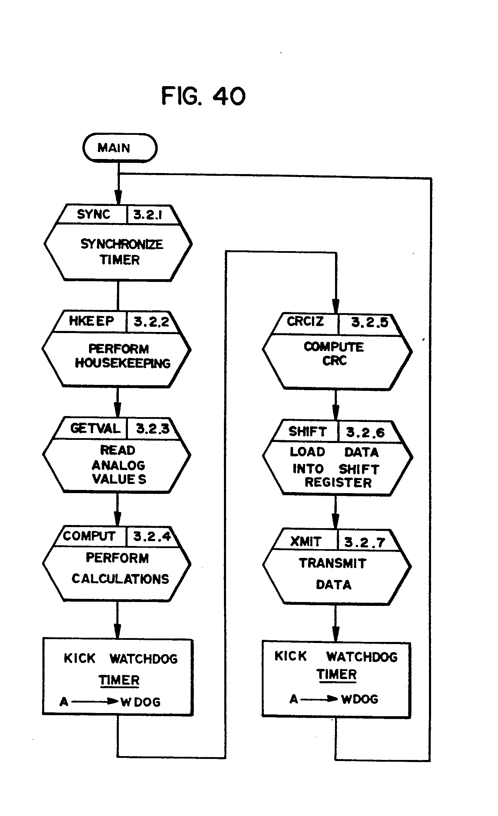

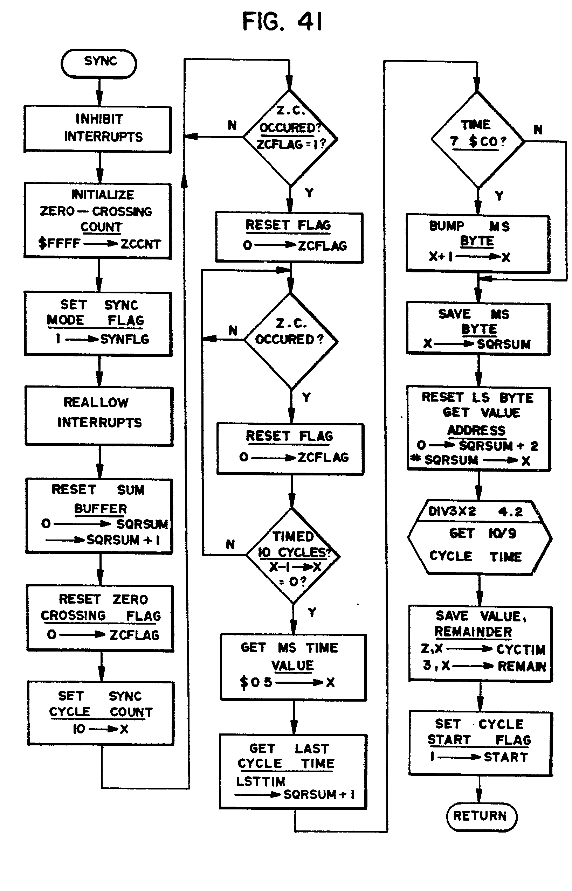

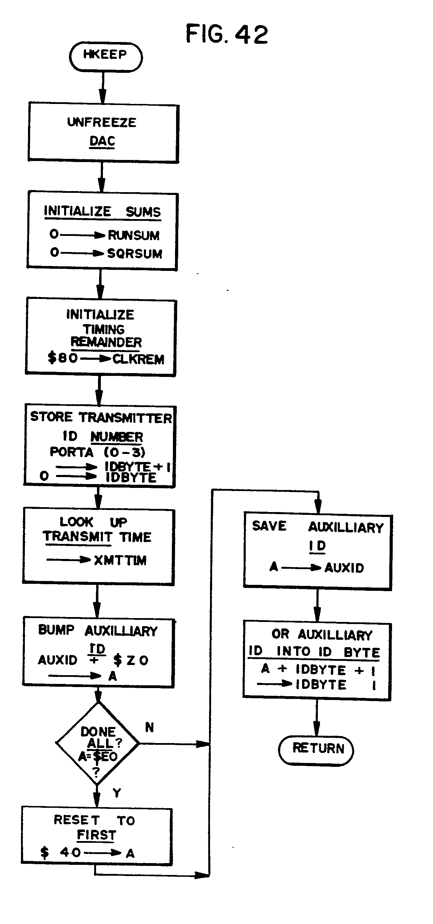

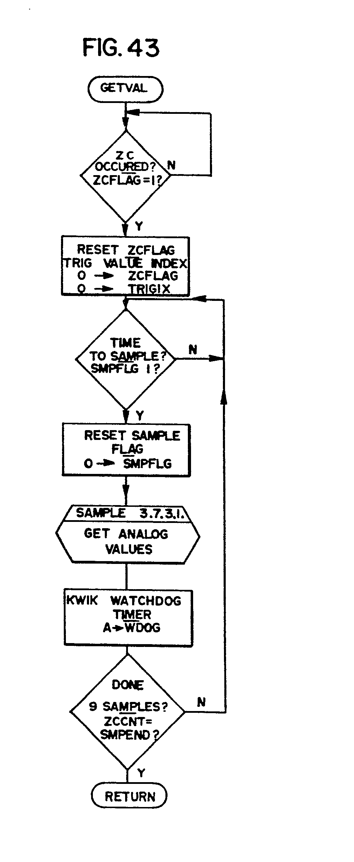

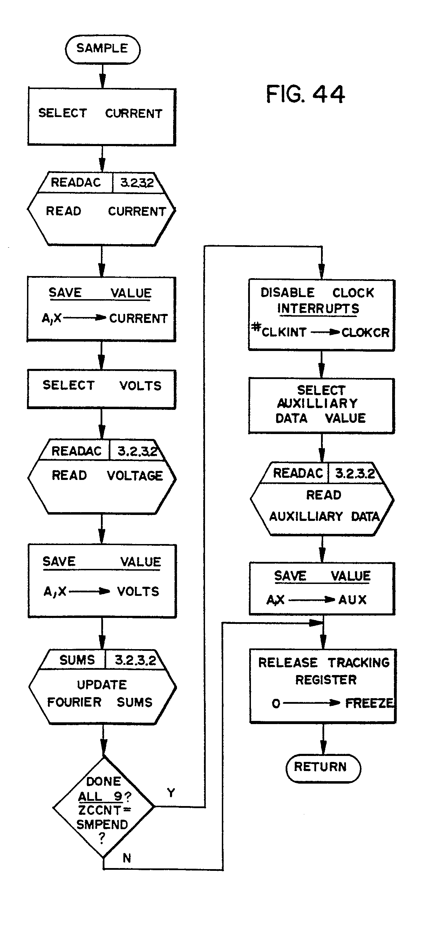

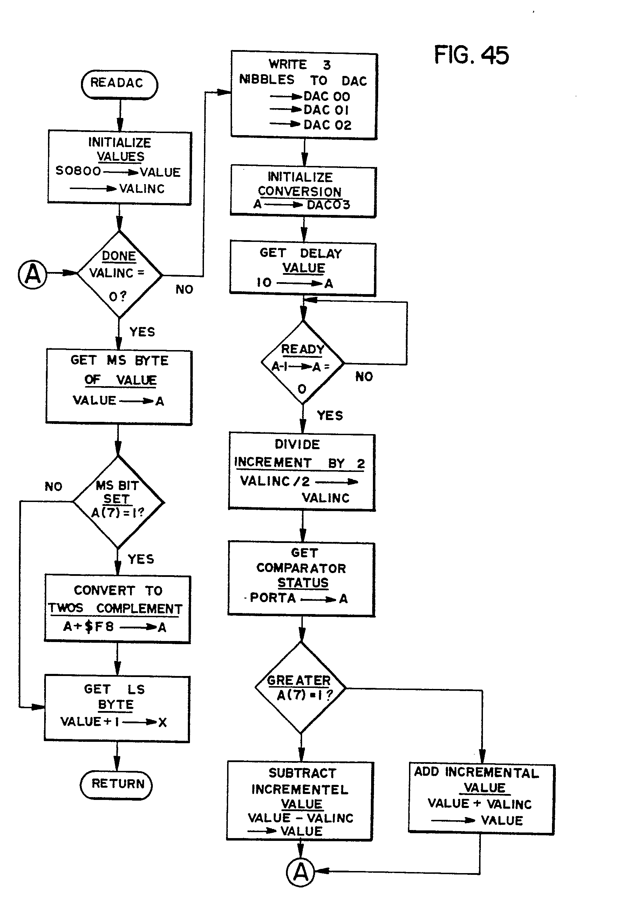

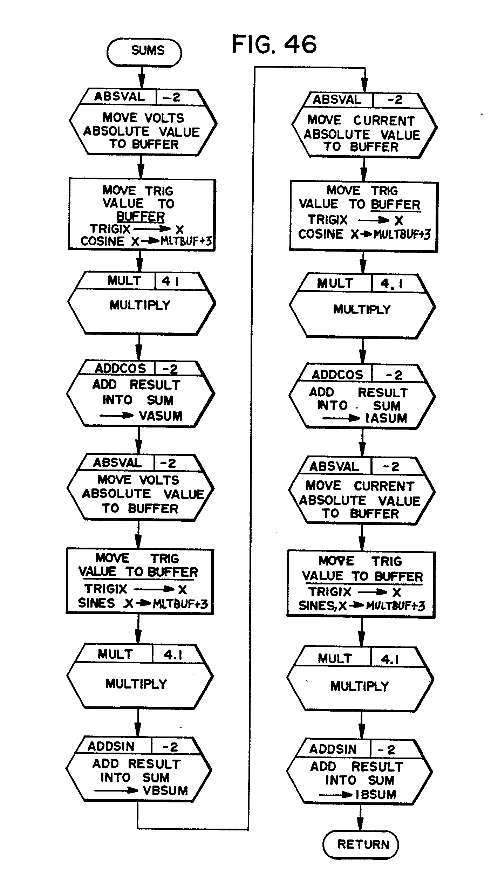

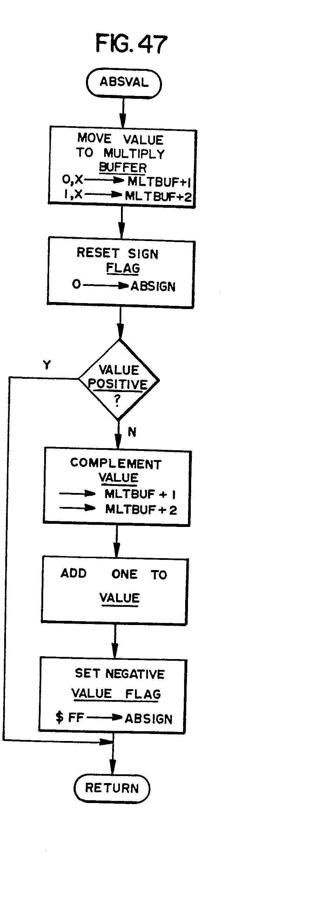

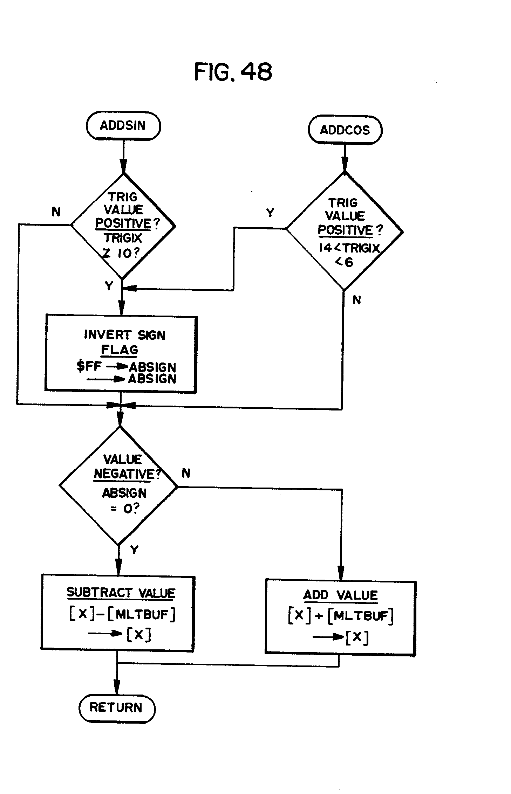

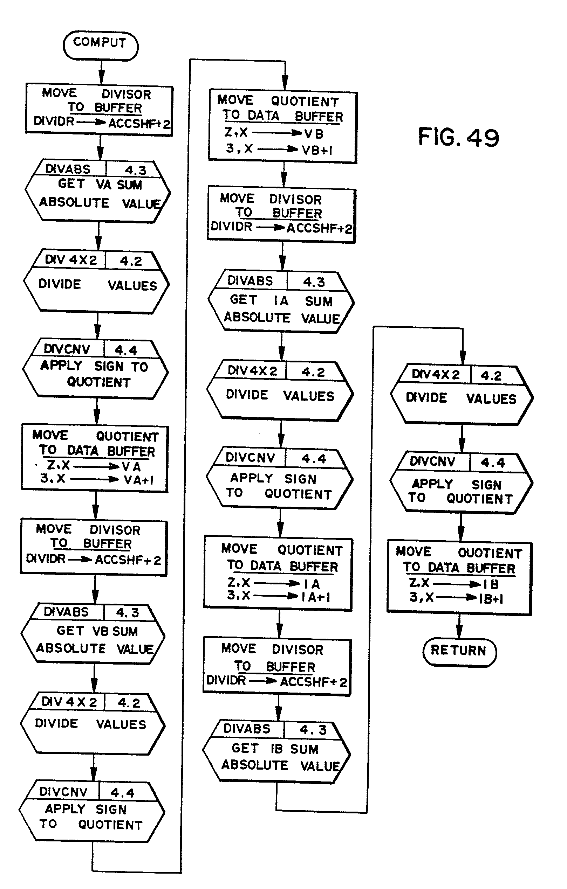

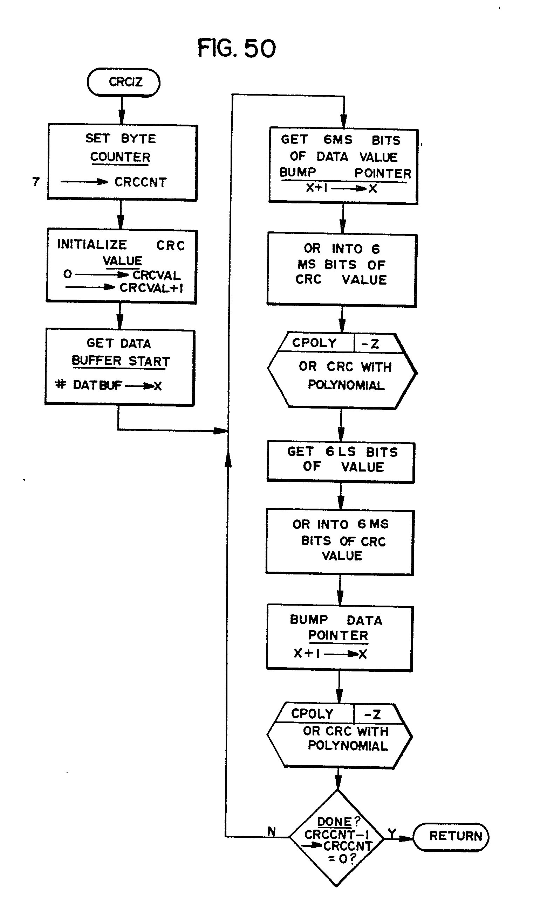

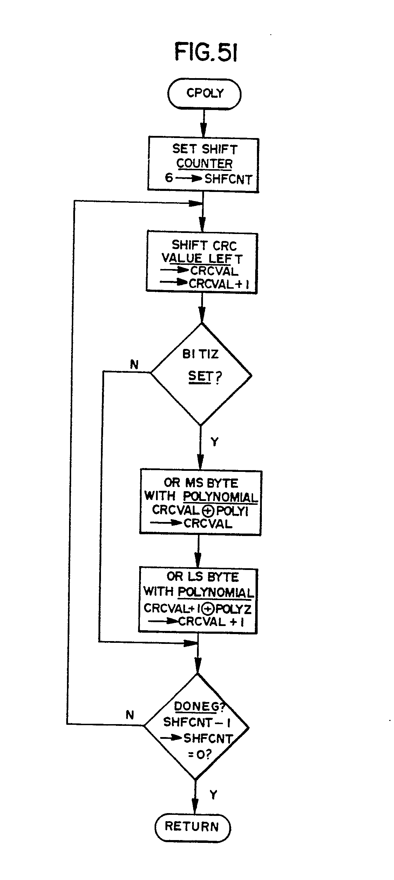

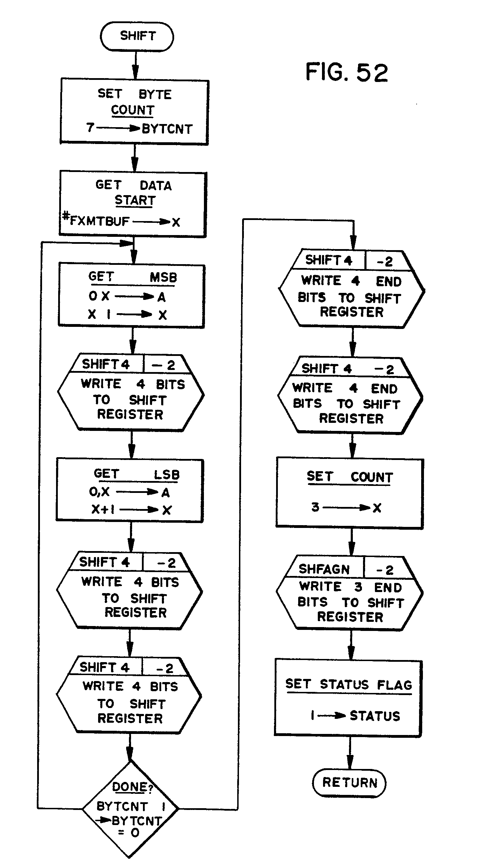

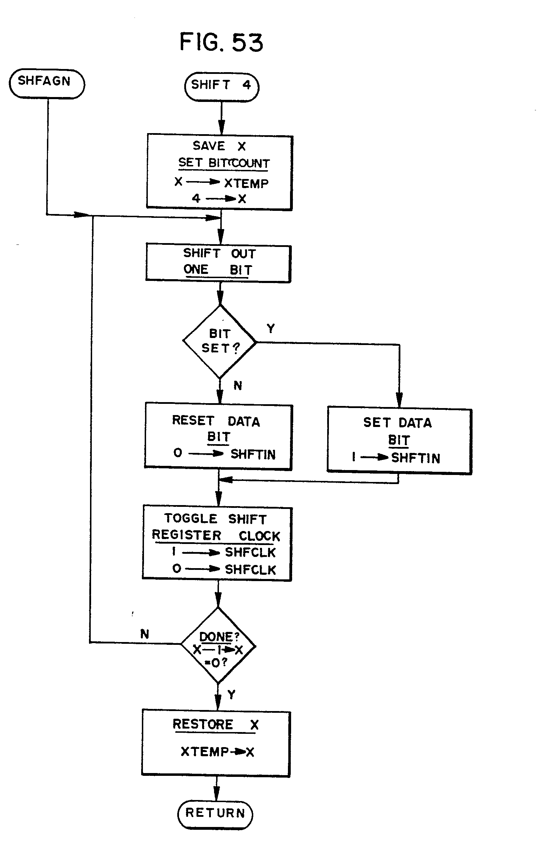

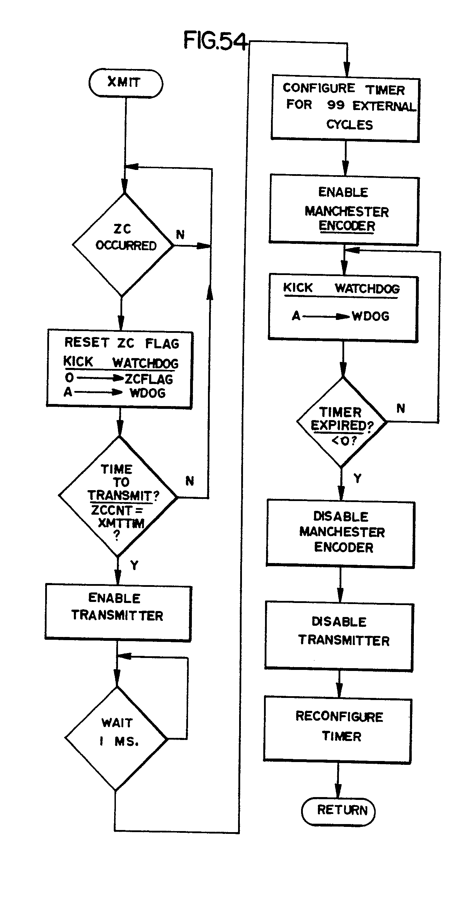

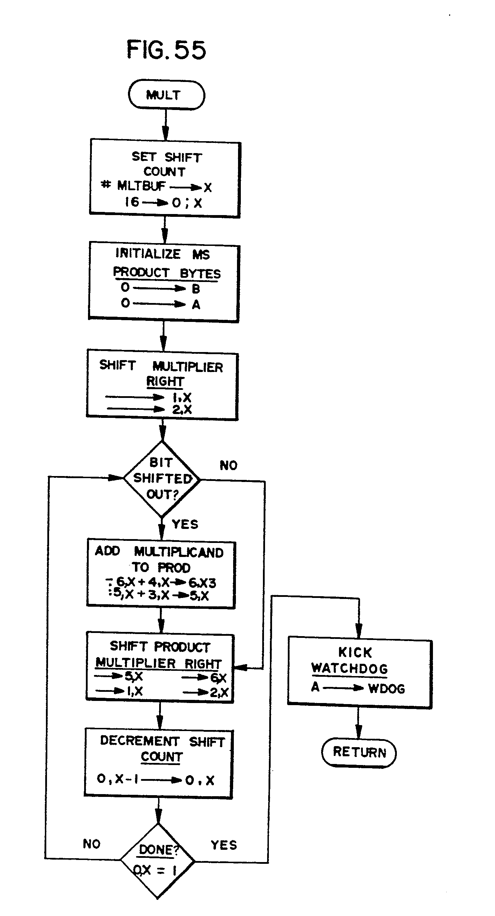

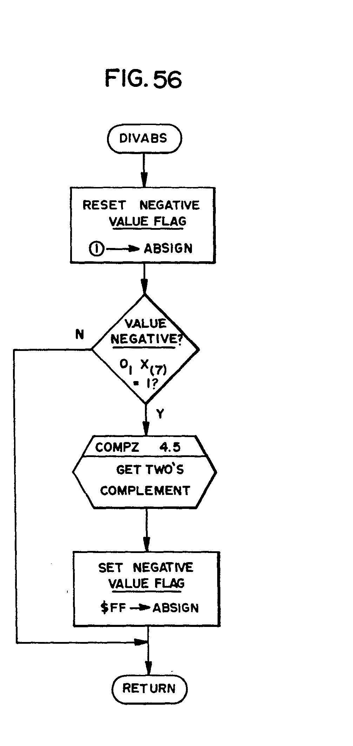

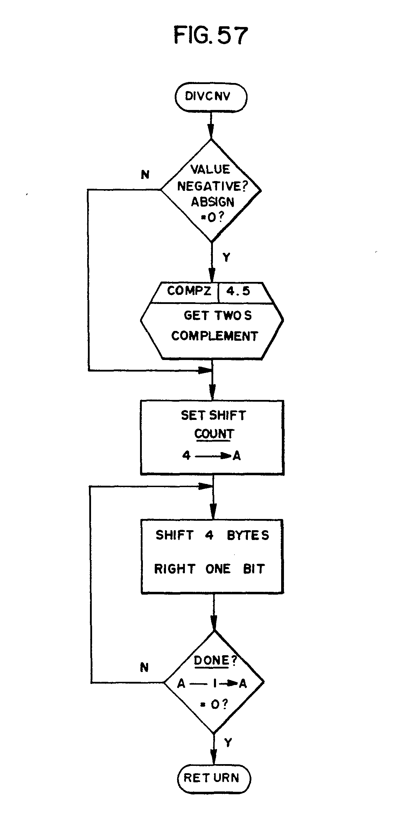

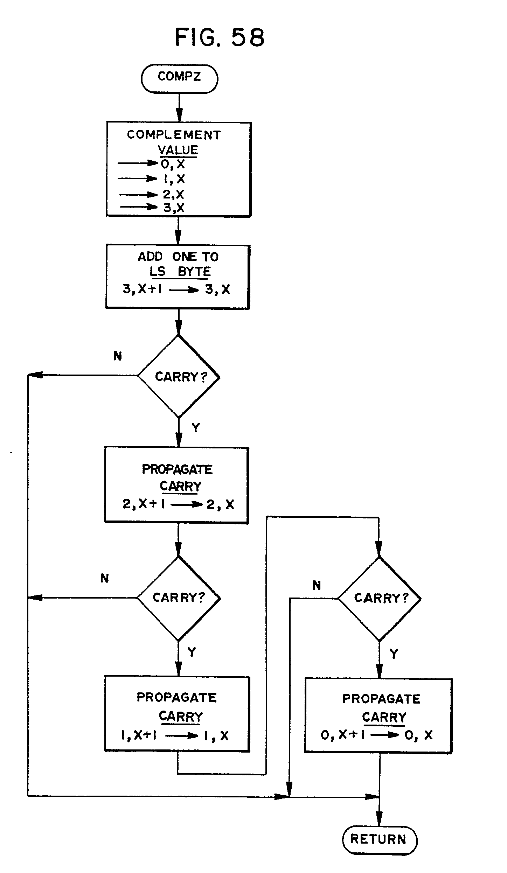

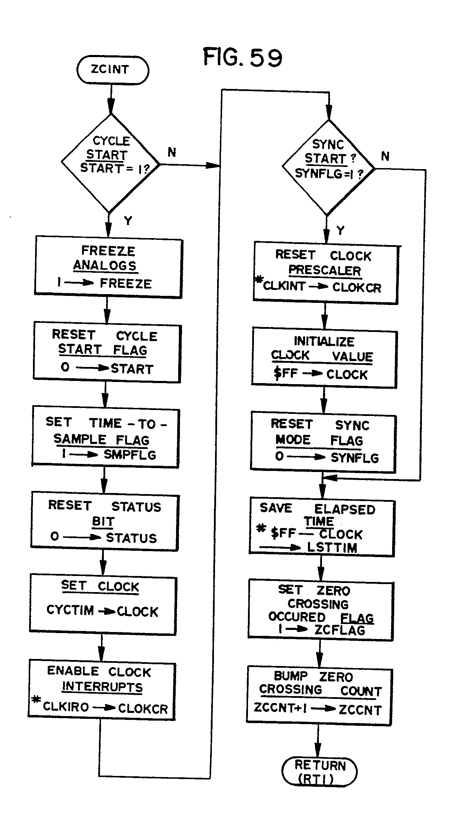

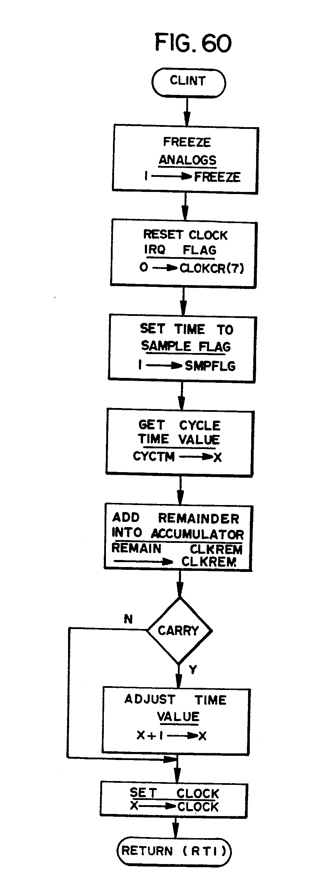

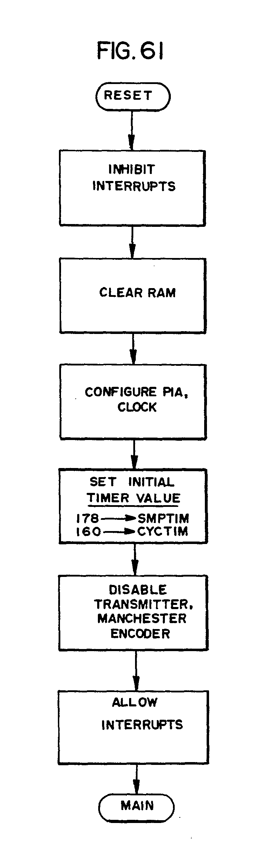

Figure 35 shows a sub-routine call as utilized in the flow charts of Figures 40 through 61;
Figure 36 is a memory map of the program;

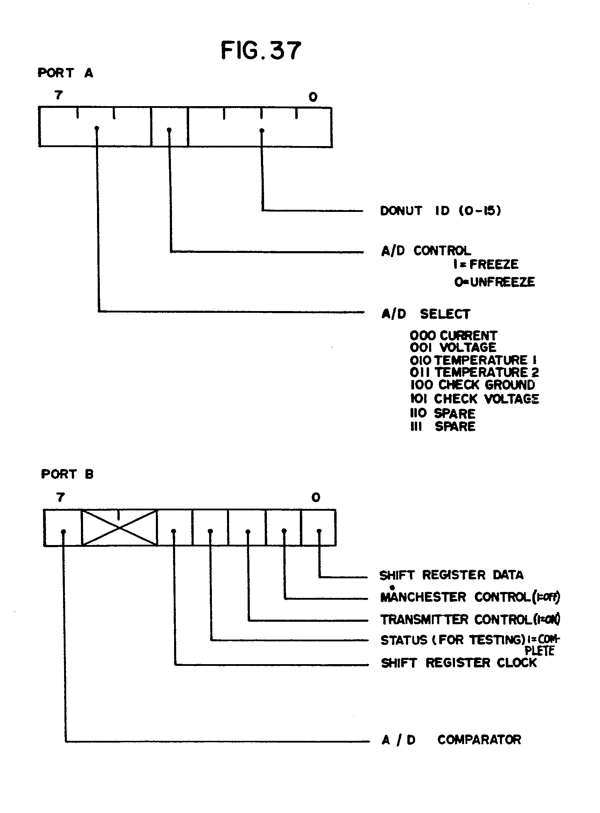

Figure 37 is a diagram of PIA port assignments of the program;

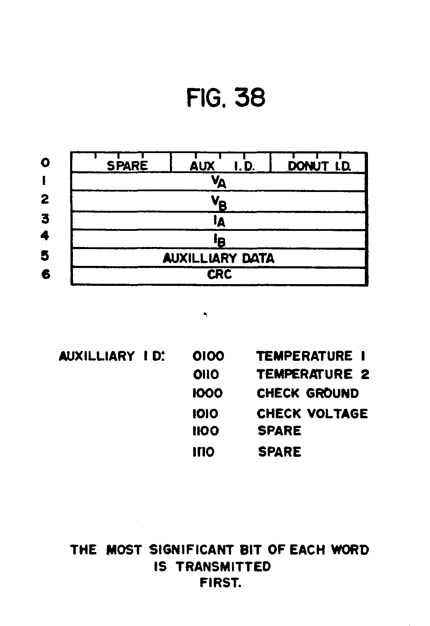

Figure 38 is a diagram of the message transmitted by the donuts 20;

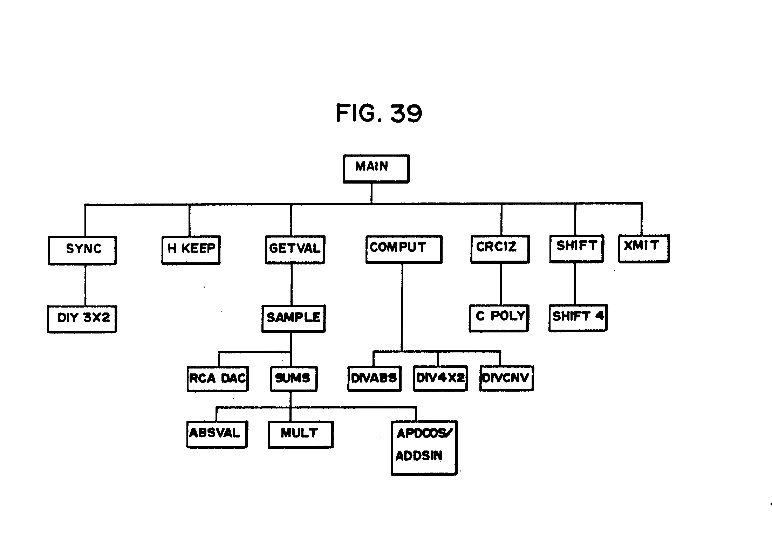

Figure 39 is a diagram of task management of the program;
Figures 40 through 61 are flow charts of the sub- routines of a program that may be utilized in the donuts 20;
Figure 62 is an overall block diagram of a ground station receiver remote terminal interface;

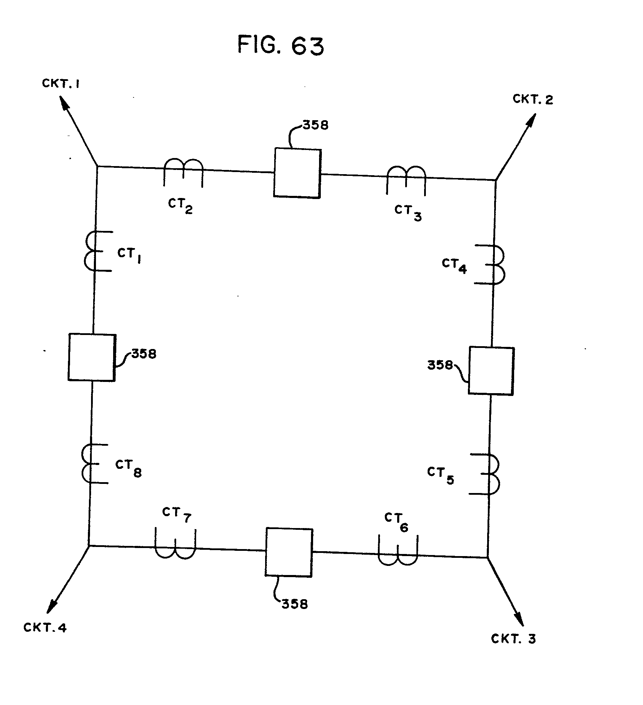

Figure 63 is a diagram of a type of substation that may be monitored by the electronics shown in Figure 62;

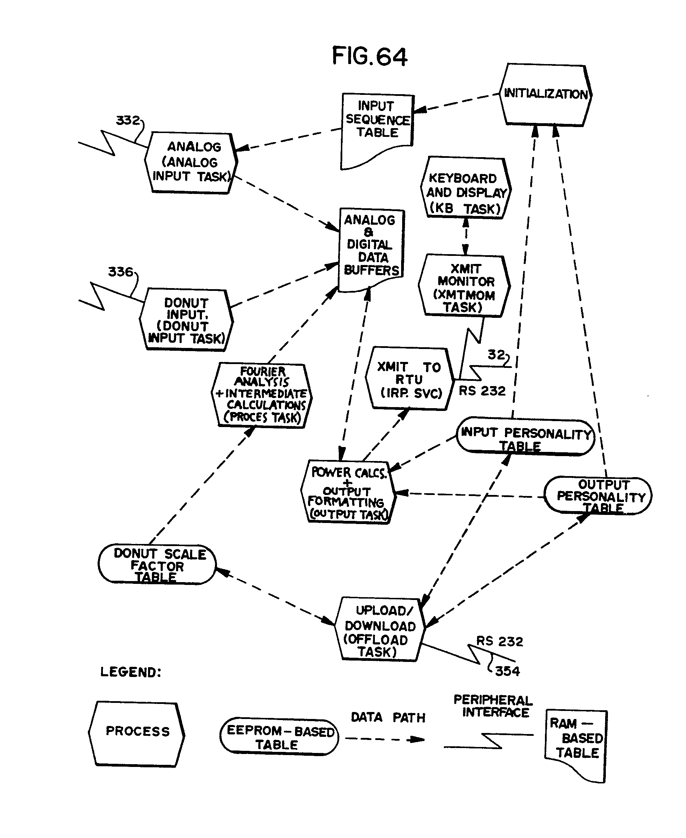

Figure 64 is a state diagram of a program that may be utilized in the receiver 24; and

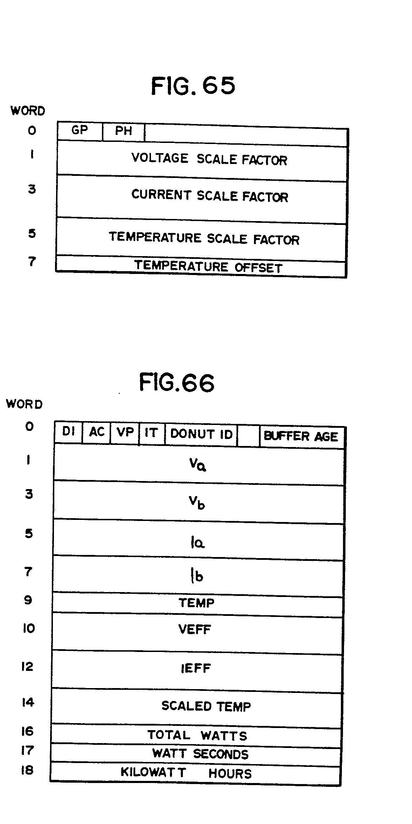

Figures 65, 66, 67, and 68 are diagrams of tables and buffers utilized in the program of Figure 64.

The same reference characters refer to the same elements throughout the several views of the drawings.

### The State Estimator Module

### General

The state estimator modules 20 ("Donuts") clamp to a high-tension power conductor 22 and telemeter power parameters to a ground station 24 (Figure 1). Each module obtains its operating power from the magnetic field generated by the current flowing in the high-tension conductor 22. Each module is relatively small and shaped like a donut, with a 12 5/8" major diameter and a maximum thickness of 4 3/4". It weighs approximately 16 pounds and may be mounted in the field in a matter of minutes using a "hot stick" (Figure 2).

Typically, three donuts 20 are used on a circuit; one for each phase. Each donut is equipped to measure line current, line to neutral voltage, frequency, phase angle, conductor temperature and ambient temperature. Digital data is transmitted by means of a 950 MHz FM radio link in a 5-10 millisecond burst. A microcomputer at the ground station 24 processes data from the 3 phase set and calculates any desired power parameter such as total circuit kilowatts, kilo- vars, and volt-amps. Individual conductor current and vol- ta^{g}e is also available. This data may then be passed on to a central monitoring host computer (typically once a second) over a data link 32.

One ground station 24 may receive data from as many as 15 donuts 20, all on the same RF frequency (Figure 4). Each donut transmits with a different interval between its successive transmission bursts, ranging from approximately 0.3 seconds to 0.7 seconds. Thus, there will be occasional collisions, but on the average, greater than 70% of all transmissions will get through.

Environmental operating conditions include an ambient air temperature range of -40°F to +100°F; driving rain, sleet, snow, and ice buildup; falling ice from conductor overhead; sun loading; and vibrations of conductors 22.

Current measurements over a range of 80-3000 amperes must be accurate to within 0.5%. Voltage measurements over a range of 2.4-345KV (line-line) must be accurate to within 0.5%. Conductor diameters range from 0.5 to 2 inches.

All exterior surfaces are rounded and free from sharp edges so as to prevent corona. The module weighs approximately 16 pounds. It is provided with clamping inserts for different conductor diameters which are easily removeable and replaceable. The conductor clamping does not damage the conductor, even after prolonged conductor vibration due to the use of neoprene conductor facings 170 in the inserts 186 (Figure 13).

The special hot stick tool 108 is inserted into the donut 20. Turning of the hot stick causes the donut to split so that it may be placed over a conductor. Turning the hot stick in the opposite direction causes the donut to close over a conductor and clamp onto it tightly. The tool 108 may then be removed by simply pulling it away. Reinsertion and turning will open the donut and allow it to be removed from the line.

Conductor temperature probes 70 and 72 (Figure 6) are spring loaded against the conductor when the donut is installed. The contacting tip 174 (Figure 10) is beryllia and inhibits corrosion and yet conducts heat efficiently to the temperature transducer within. It is also a non-conductor of electricity so as not to create a low resistance path from the conductor to the electronics.

The hub and spoke area in the center of the donut 20 and the temperature probe placement are designed with as much free space as possible so as not to affect the temperature of the conductor.

All electronics within the donut are sealed in watertight compartments 84 (Figure 10).

The radio frequency transmitter power of the donut 20 is typically 100 milliwatts. However, it may be as high as 4 watts. The donut 20 is protected against lightning surges by MOV devices and proper grounding and shielding practice. All analog and digital circuitry is CMOS to minimize power consumption.

No potentiometers or other variable devices are used for calibration in donut 20. All calibration is done by the ground station 24 by scaling factors recorded in computer memory.

Each donut is jumper programmable for current ranges of 80-3000 amperes or 80-1500 amperes.

Current is measured by using a Rogowski coil 80 (Figure 7). Voltage is measured by two electrically insulated strips of metal 82 (Figure 8) imbedded flush on the exterior of one face of the donut. These strips act as one plate of a capacitor at the potential of the conductor. The other plate is the rest of the universe and is essentially at calibrated ground (neutral) potential with respect to the donut. The amount of current collected by the donut plate from ground is thus proportional to the potential of the donut and the conductor on which it is mounted.

Power to operate donut electronics is derived from a winding 68 on a laminated iron core 64-66 which surrounds the line conductor. This core is split to accommodate the opening of the donut when it clamps around the conductor. The top and bottom portions of the aluminum outer casing of the donut are partially insulated from each other so as not to form a short circuited turn. The insulation is shunted at high frequency by capacitors 176 (Figure 10) to insure that the top and bottom portions 76 and 81 are at the same radio frequency potential.

The data is transmitted in Manchester code. Each message comprises the latest measured Fourier components of voltage and current and another measured condition called the auxiliary parameter, as well as an auxiliary parameter number to identify each of the five possible auxiliary parameters. Thus, each message format is as follows:
Donut Identification Number 4 bits
Auxiliary Parameter Number 4 bits
Voltage Sine Component (Fourier Fundamental) 12 bits
Voltage Cosine Component (Fourier Fundamental) 12 bits
Current Sine Component (Fourier Fundamental) 12 bits
Current Cosine Component (Fourier Fundamental) 12 bits
Auxiliary Parameter 12 bits
Cyclic Redundancy Check 12 bits

The auxiliary parameter rotates among 5 items on each successive transmission as follows:
Auxiliary

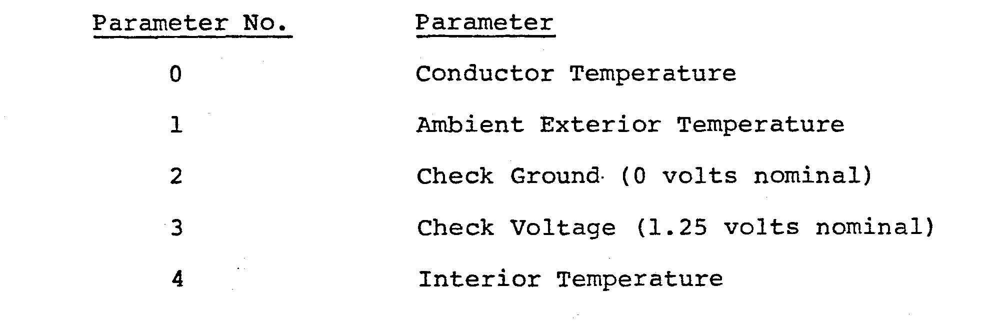

More specifically, and referring to Figure 2, the hot stick tool 108 may be mounted on a conventional hot stick 176 so that the module 20 may be mounted on an energized conductor 22 by a man 178.

In Figure 3 it can be 'seen how the hot stick tool 108 provided with an Allen wrench portion 110 and a threaded portion 112 fits within a hole 122 provided in the donut 20 mounted on conductor 22. The donut comprises two bottom portions 76 and two covers, or top portions 81, held together by six bolts 180. Each bottom portion 76 is provided with a top hub 182 and a bottom hub 184 (see also Figure 13), supported on three relatively open spokes 185.

Conductor temperature probes 70 and 72 (see also Figure 6) are aligned within opposed spokes 185.

Identical clamping inserts 186 are held within opposed hubs 182 and 184 (see Figure 13) and clamp conductor 22 with hard rubber facings 170 provided therein. The tops 81 (Figure 3) are each provided with an arcuate flat flush conductor 82 insulated from the housing for measuring voltage and one of the bottom portions 76 is provided with a patch antenna 98 for transmitting data to the ground station.

Although the top portions 81 are each provided with a non-conductive rubber seal 188 (Figure 7) and the area around the hinge is closed by cover plates 190, water escape vents are provided in and around the access opening 122, which due to the hot stick mounting is always at the lower portion of the donut 20 when installed on a conductor 22.

Now referring to Figure 6, a hinge mechanism is provided, generally indicated at 192. It comprises hinge pins 140 and 142, mounted in a top plate 136 and a bottom plate 138 (see Figure 23). When opening or closing, the bottom portions 76 along with their covers 81 rotate about pins 140 and 142. The two halves of the donut 76-76 are drawn together to clamp the conductor by bringing fixed pins 146 and 148 together by means of cable 158. They are separated by pushing a wedge against wedge arms 150 and 152 to separate pins 146 and 148 which are affixed to the bottom portion 76-76.

To make certain that the bottom portions 76-76 of the donut 20 are at the potential of the conductor, a spring 78 is provided which continuously contacts the conductor during use and contacts it before it comes in contact with the temperature probes 70 and 72, protecting them against arcing.

To insure that the unit comes together precisely, a locating pin 194 and locating opening 196 are provided. The multi-layer power transformer cores 64 and 66 come together with their faces in abutting relationship when the unit is closed. They are spring loaded against' each other and mounted for slight relative rotations so that the flat faces, such as the upper faces 198 shown in Figure 6 will fit together with a minimum air gap when the unit is closed. The temperature probes 70 and 72 are spring loaded so that they press against the conductor when the unit is closed. The ambient probe 74 is provided with a shield 200 covering the hub area so that it looks at the temperature of the shield 200 rather than the temperature of the conductor.

The temperature probes 70 and 72 are located in alignment with opposed spokes 185 so as to provide the least amount of wind resistance so that the conductor at the probes 70 and 72 will be cooled by the ambient air in substantially the same way as the conductor a distance away from the module 20.

The ten radio frequency shunting capacitors 176 can also be seen in Figure 6, as well as the patch antenna 98.

Now referring to Figure 7, a Rogowski coil 80 is affixed to the covers 81 by eight brackets 202 and is connected by lead 203 to the electronics in the bottom portions 76 (Figure 10). The non-conductive rubber seal 188 may be seen in Figure 7, as well as recesses 206 for stainless steel fiber contacting pads 202 which contact the RF shunting capacitors 176 (Figure 10).

Now referring to Figures 8 and 9, the capacitor plate 82 can be seen mounted flush with the surface of one of the covers 81. It may also be seen in Figure 9 how the openings 206-208 for the Rogowski coil are provided with slots 210 to prevent the formation of a short circuiting path around it.

Now referring to Figure 10, the arcuate capacitor plates 82 are insulated from the case 81 by teflon or other non-conducting material 212. The surface gap between the capacitor plate 82 and the surface of the case 81 is .005 inches. The plates 82 are mounted to the tops 81 by means of screws 214 passing through insulated bushings 216 and nuts 218, or by other comparable insulated mounting means. Connection between the capacitor plates 82 and the electronics may be made by means of the screws 214. A stainless steel wool pad 202 may be seen in Figure 10 connecting to the shunt capacitor 176 which may be in the form of a feed through capacitor. The insulating seal 188 is shown next to the shunt capacitor 176.

The temperature probe 70 comprises an Analog Device AD-590 sensor 220 mounted against a beryllia insert 174 which contacts the conductor 22. The three conductors generally indicated at 222 connect the electronics to the sensor 220 through an MOV 224.

The sensor 220 and beryllia insert 174 are mounted in a probe head 226 which in turn is mounted to a generally cylindrical carriage 227 pushed out by spring 228 to force the beryllia insert 174 against the conductor. A rubber boot 229 protects the interior of the probe 70. The probe head 226 is formed of an electrical and heat insulating material. The probe 72 is mounted in a cylindrical post 230 which preferably is adjustable in and out of the lower casing 76 for adjustment to engage conductors of differing diameters. The other conductor temperature probe 72 is identical.

An electronics box 84 is mounted within each of the two bottom portions 76 and top portion 81. The boxes 84 are hermetically sealed. The power pickup transformer core 66 and its mating transformer core 64 (Figure 6) in the other half of the module is pressed by leaf spring 232 against the mating core 64 and is pushed against post 234 by means of spring 236 so that the flat faces 198 of the two cores 64 and 66, shown in Figure 6, will come together in a flat face to face alignment when the module is closed.

Referring now to Figure 11, it can be seen how the end face 238 of the core 66 passes through the end plate 240 of lower portion 76. Opening 242 is provided for electrical wiring connecting the sealed circuit containers 84 in both halves of the device. It should be noted how opening 242 is open, again to prevent encircling the wiring.

The opening 244 for the ambient sensor 74 and the opening 246 for the conductor sensor 70 may be seen in Figure 11. The hubs 182 and 184 and spokes 185 may be seen in Figures 10 and 11 although the openings 248 in the spoke 185 of Figure 10 are not shown in order that the temperature probe 70 may be shown in detail.

Now referring to Figure 12 and 13, it can be seen how the clamping inserts 186 fit within the hubs 182 and 184 and how the facings 170 fit within the inserts 186. The inserts 186 are made in sets having differing inner diameters to accommodate conductors 22 of differing diameters.

As shown in Figures 15 through 17, the clamping inserts 186 are provided with alignment tabs 250 which fit into the hubs 182 and 184. Each of the inserts 186 is identical, one being upside down with respect to the other when installed as shown in Figure 14. Each is provided with a screw hole 252 for screw mounting them within hubs 182 and 184 and are provided with a raceway 254 for insertion of and to hold the hard conducting neoprene rubber facings 170, which may be of material, having a hardness of 70 durometer on the Shore A scale. The facings 170 are preferably filled with a conducting powder, such as graphite, to establish electrical contact with the conductor 22.

One of the pins 142 of the hinge is shown in Figure 18. All of the pins are provided with a non-conducting ceramic coating 256 which may be plasma sprayed thereon, so that the pins do not provide, together with the plates 136 and 138 of the hinge (Figure 23), a shorted turn.

Now referring to Figure 20, an emergency hot stick mountable tool 164 can be used to open the donut 20 if for any reason the hinge clamp jams. This tool comprises an elongated file 166 used to cut the cable 158. After the cable 158 has been cut, a threaded portion 168 of the emergency tool may be threaded into the thread portion 144 of nut 132 (see Figure 24) to remove the opened donut 20.

Also, in Figure 20, it can be seen how the cable clamp 130 is provided with a raised key portion 258 which guides the cable clamp's motion in a guideway opening 260 in the top plate 136. Also, the circular opening 262 in the top plate 136 may be seen, in which the boss 134 of nut 132 fits to keep it from moving. A similar boss on the bottom of the nut 132 fits into a circular opening in bottom plate 138, as does a similar key 264 on the bottom of cable clamp 130 fit into a guiding opening in bottom plate 138. The plates 136 and 138 are secured together by bolts 266 and 268 and are held apart by spacers 270 and 272 (Figures 21 and 23) about the bolts 266 and 268. Cover plate 136 is machined with openings 274 and ribs 276 to make it as strong and light as possible.

Figure 21 shows the hinge clamp mechanism with the top plate 136 removed and the donut 20 closed, the cable 158 pulling pins 146 and 148 tightly together.

In Figure 22 the hinge clamp mechanism is shown with top plate 136 removed and the cable clamp 130 spread apart from the nut 132 by the barrel 124. The wedges 154 and 156 have pushed ramp arms 150 and 154 to spread apart fixed pins 146 and 148, to open the donut.

In Figure 23 it can be seen how hinge pins 140 and 142 fit into receiving portions 278 and 280 of each bottom portion 76 of the donut 20. Similarly, fixed pins 146 and 148 fit into portions 282 which are shown partly cut away in Figure 23. Portions 282 are located closer to the central axis of the donut 20 than hinge pins 142.

Also seen in Figure 23 are the nuts 284 and 286 on the bolts 266 and 268.

As previously described the hot stick tool 108 (Figures 25, 26 and 27) for mounting to a conventional hot stick 176 comprises a conventional hot stick mounting coupling 118, a barrel portion 116, a universal joint 114 which accommodates misalignment of the line of the stick 120 and the receiving opening 122 (see Figure 3) in the donut 20. Also seen in Figures 25, 26, and 27 are the donut engaging Allen wrench portion 110 and threaded portion 112 of the hot stick tool 108, and the sleeve 116 which holds the base 288 of the universal 114 rigidly to the mounting 290 for the hot stick tool mounted portion of the coupling 118.

### State Estimator Module Electronics

The state estimator module electronics are shown in their overall configuration in Figure 28. They comprise a power supply 292, digitizing and transmitting electronics 294, sensors indicated by the box 296, and antenna 98.

The center tap 9 of the power pickoff coil 68 is connected to the aluminum shell of the module 20, which in turn is connected directly to the power conductor 22 by spring 78 and by the conducting facings 170 (Figures 12 and 13). Thus, the power conductor 22 becomes the local ground as shown at 88 for the electronics 294. The power supply supplies regulated +5 and -8 volts to the electronics 294 and an additional switched 5.75 volts for the transmitter as indicated at 300. The electronics 294 provides a transmitter control signal on line 302 to control the power supply to the transmitter. The sensors 296 provide analog signals as indicated at 304 to the electronics 294. The detailed schematic electrical circuit diagram of the power supply 292 is shown in Figure 29.

Figure 30 is a schematic block diagram of the electronics 294. As shown therein, the Rogowski coil 80 is connected to one of a plurality of input amplifiers 86 through current range select resistors 306. The voltage sensing plates 82 are connected to the uppermost amplifier which is provided with a capacitor 308 in the feedback circuit which sets gain and provides an amplifier output voltage in phase with line to neutral high tension voltage. It also provides integrator action for the measurement of current the same way as the amplifier connected to the Rogowski coil. Thus amplifier 86 connected to the voltage sensing plate 82 is a low impedance current measuring means connected between the power conductor 22 (i.e., ground 88) and the plates 82.

Each of the temperature transducers 72 and 74 is connected to a separate one of the amplifiers 86 as shown. Spare amplifiers are provided for measurement of additional characteristics such as the interior temperature of the donut 20. Each of the amplifiers 86 is connected for comparison with the output of digital analog converter means 310, 2.5 volt reference source 312 at comparator 314 by the multiplexer 90 under control of the digital computer 316. The digital computer may be a Motorola CMOS 6805 microprocessor having I/O, RAM, and timer components. A programmable read only memory 318 is connected thereto for storing the program. A zero crossing detector 320 detects the zero crossings of the current in the Rogowski coil 80 and provide basic synchronization. The donut ID number is selected by jumpers generally indicated at 322. The digitized data assembled into appropriate messages is encoded in Manchester code by the encoder 94 and supplied to a 950 megahertz transmitter 96 which then supplies it to the antenna 98.

The schematic electrical circuit diagram of the electronics 294 is shown in Figure 31, comprising Figures 31A through 31D which may be put together to form Figure 31 as shown in Figure 31E. The grounds therein are shown as triangles. A inside the triangle indicates an analog ground and D a digital ground. Both are connected to the common terminal-as indicated in Figures 28 and 31C.

### The Voltage Sensor

The operation of the voltage sensor may be understood with reference to Figure 32. We wish to measure the alternating current voltage V between the conductor 22 and the ground 324. The metal plates 82 form one plate of a capacitive divider between conductor 22 and ground, comprising the equivalent capacitor Cl between ground and plate 82 and equivalent C2 between conductor 22 and the plate 82.

The voltage V_{L} between ground and the conductor 22 is thus divided across the equivalent capacitor Cl and C2.

Prior art methods have attempted to measure the potential developed across capacitance C2. However this capacitance can change value and affect the accuracy of the measurement. It may also develop a spurious voltage across it due to the high electric field in the vicinity of the high voltage conductor 22. The low impedance integrating operational amplifier of the invention, generally indicated at 326, shunts capacitance C2 and effectively eliminates it from the circuit. The potential of plates 82 is therefore made to be the same as that of conductor 22 through the operational amplifier 326. Now the potential between the plates 82 and ground 324 is the potential V_{L} between the line 22 and the ground 324. Therefore, the current in the capacitance C₁ is now directly proportional to the voltage V_{L}. Therefore, the low impedance integrater connected operational amplifier 326 will provide an AC output voltage exactly proportional to the current in the capacitance Cₗ and thus directly proportional to the high voltage V_{L} on the conductor 22.

Now referring to Figure 33, all of the circuitry including the integrater connected operational amplifier 326 is housed within a metal housing 81, which is connected to the conductor 22 via the spring 78. The plates 82 are on the outside of the housing 81 and must be electrically insulated from it. The plates 82 cannot protrude from the housing 81 since this would invite corona on very high voltage lines. It therefore must either be flush with the surface of the housing 81 or recessed slightly in it.

Unfortunately rain water or snow collecting on the surface will provide a path of high dielectric constant shunting the high electric field about the conductor 22 so that the current I₂ to the operational amplifier 326 will not be equal to the current I_{I} in the capacitance Cₗ. Thus the measurement will be in error.

In order to minimize this effect the width and length of the sensing plates must be made very large in comparison with the width of the gap separating them from the housing and if any protective coating is used over the sensing plate it must have no appreciable thickness. Furthermore, the outer surface of the sensing plate must conform, as closely as possible, with the outer surface of the housing 81.

Thus the sensing plates 82 shown in Figures 8, 9, and 10, are made very long and have gaps to the housing at their ends of only .020 inches and gaps 212 along them of .005 inches in width. The plates 82 are approximately 3/8ths of an inch in width, which is of course very much greater than the gaps of .05 inches and .020 inches.

When constructed in this manner, water droplets covering the metallic sensing plate and bridging the adjacent housing do not materially affect the measurement of V_{L}. This is true because:
1. the sensing plates 82 are directly exposed and water overlying them which has a high dielectric constant, simply conducts the capacitive current I_{I} directly to the plate;
2. the amount of current shunted by water at the gap between the plates 82 and the housing 81 is very small in proportion to the amount collected by the much larger area sensing plates themselves;
3. the alternating current lost through the shunt path across the gap between the plates 82 and housing 81 is very small because of the low input impedance of the integrater connected operational amplifier 326.

### Deriving the Fourier Components of Current and Voltage

Since the state estimator module 20 is mounted in isolation on a high-tension transmission line it is desirable to derive as much information as possible from the sensors contained within it with a minimum of complexity and to transmit this raw data to the ground station 24 (Figure 1). Calculation of various desired quantities may then be made on the ground.

It is therefore convenient to sample and hold both the current and voltage simultaneously and to send these quantities to the ground sequentially by pulse code modulation.

When it is desired to derive phase and harmonic data rather than merely transmitting the root mean square of the voltage and current to the ground, the shape of the waveforms and their relative phase must be transmitted.

We do this by transmitting Fourier components. We sample the waveform of both current and voltage at intervals of 1/9th of a cycle. However, rather than doing this during one cycle, we do this making one measurement at each cycle, changing the interval over nine cycles.

The ground station can then easily compute the ^{q}uan- tities of interest, for example, RMS amplitude of voltage and current, their relative phase and harmonic content.

Since current and voltage are sampled simultaneously, their relative phases are the same as the relative phases of the sample sequence. The harmonic structures are also the same, so that, except for brief phenomena, any desired analysis may be made by the ground station.

The data transmissions take place in a five to ten second millisecond interval, which is synchronized with the zero crossing of the donut 20. With this information, the relative phase of three phases of a transmission line as shown in Figure 1 may be derived.

In the embodiment disclosed herein we only compute the fundamental Fourier components of V_{A} and V_{B} and I_{A} and I_{B} which are: 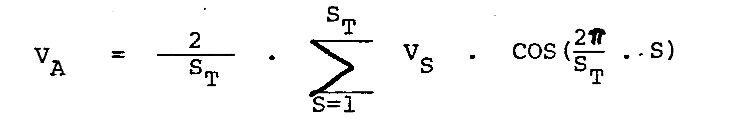 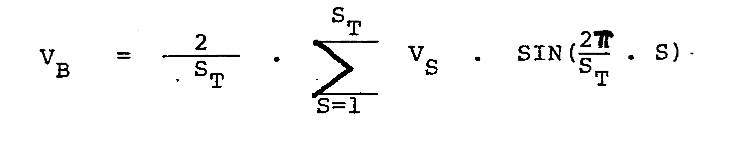 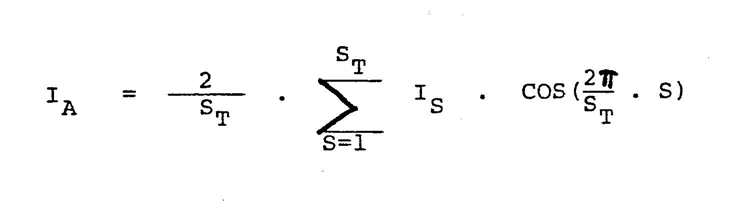 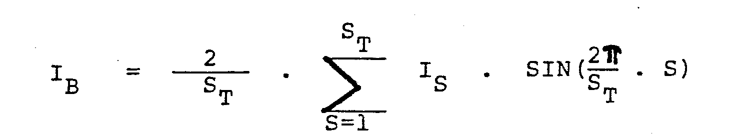 where S equals the total number of samples in the apparatus disclosed 9, S equals the sample, and V_{S} and I_{S} are the value of the measured voltage and current at each sample S. From these the RMS voltage V and current I may be derived by the formulas: 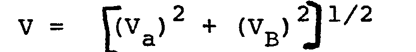 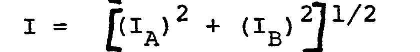 real power is: 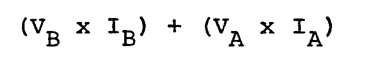 and reactive power is:

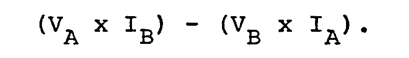

If it is desired to have information about the shape of the waveform (that is harmonic data) more samples may be taken and the desired Fourier harmonic components calculated and transmitted.

### "Random" Transmissions on a Single Radio Channel

As shown in Figure 4, a single substation 34 may have as many as fifteen donuts 20 transmitting data to a single receiver 24. Since radio receivers are expensive and radio frequency channel allocations are hard to obtain, it is desirable to have all units share a single channel. For weight and economy it is desirable to minimize the equipment in the donuts 20 at the expense of complicating the receiver 24.

Idealy, all donuts 20 transmitting on a single channel would transmit, in turn, in assigned time slots. Unfortunately, the only way to synchronize them according to the prior art would be to provide them each with a radio receiver.

Our donuts 20 are programmed to send out short burst transmissions at "random" with respect to each other, and to do so often enough that occasional interference between two or more transmissions does not destroy a significant portion of the data. This is accomplised by assigning to each donut 20 transmitting to a single receiver 24 a fixed transmission repetition interval so that no synchronization is required. The interval between transmissions of each of the donuts is an integral number and these numbers are chosen so that no two have a common factor.

For example, for fifteen donuts, we choose the intervals W measured in sixtieths of a second according to the following table:

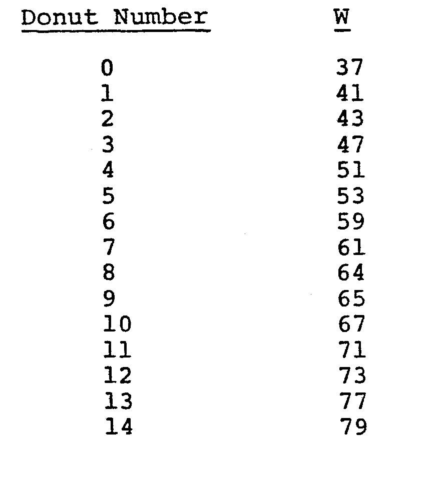

It is desirable that the message length be reduced to a bare minimum in order to minimize simultaneous message transmission. One way we accomplish this is to transmit "auxiliary" information in repeating cycles of five transmissions.

### Timing of the Measurements and Transmissions

A timing diagram is shown in Figure 4, where the sine wave is the current as measured by the Rogowski coil. At zero crossing labeled Ø timing is started. During the next cycle labled 1 and succeeding cycles through the eighth, the nine successive Fourier measurements I_{S} and Vₛ are made. During the ninth cycle the period of the previous eight cycles is utilized to define the sampling interval and the Fourier samples of the current and voltage are again taken during the next eight cycles. These measurements are utilized to compute V_{A}, V_{B}, I_{A} and I_{B}. At the end of the next cycle labeled 9 at the Ø crossings, twenty-one cycles have occurred. During the followup period of time, up to a total of W - 1 cycles, the program loads shift registers with the identification number of the donut, the auxiliary number, the Fourier components V_{A}, V_{B}, I_{A}, I_{B}, the digitized auxiliary parameters and the CRC (a check sum). At W - 1 the transmission 328 begins and takes place over a short interval of 5 to 10 milliseconds, (approximately 5 milliseconds in the apparatus disclosed). Then at the Ø crossing at the end of the cycle beginning at W - 1, that is after W cycles, the program is reset to Ø going back to the left hand side of the timing diagram of Figure 34.

In the program discussed below there is a timer labeled Z which is set to Ø at the far left, beginning Ø cross over. It is reset to Z = 21 at the end of the twenty-first cycle, the second nine to the right in Figure 34.

### The Donut Software

### Copyright© 1983,

### Product Development Services, Incorporated (P_{D}S)

### Scope

The state estimator module 20 (sometimes called herein the substation monitor) is a MC146805E2 microprocessor device.

### Introduction

The "Donut" software specification is divided into three major sections, reflecting the three tasks performed by the software. They are:
Data structures,

The background processing that performs the bulk of the "Donut" operations. Included are transmitter control, sample rate timing, analog value conversion, and general "housekeeping",
Common utility sub-routines,

The interrupt processing. that handles A.C. power zero-crossing interrupts and maintains the on-board clock which is used for cycle timing, and

The restart processing that occurs whenever the microprocessor is restarted.

### Notation Conventions

### a) Logic Statements

Program modules are described via flowcharts and an accompanying narrative. The flowcharts use standard symbols, and within each symbol is noted the function being performed, and often a detailed logic statement.

Detailed statements conform to the following conventions:
IX Index Register
SP Stack Pointer
PC Program Counter
A,B Register A or B
CC Condition Codes
Y Contents of register or contents of memory location Y.
(y) Contents of memory location addressed by the contents of register or contents of memory location y.
A,X Contents of location whose address is A - IX.
y(m-n) Bits m-n of the contents of register
y or the contents of memory location y. a→b a replaces b. The length of the move (one or two bytes) is determined by the longer of a or b.

For instance:
ABC→XYZ Move the contents of memory location ABC to memory location XYZ.
IX→XYZ Save the Index Register in location XYZ.
(IX)→XYZ Store the contents of the address pointed to by the Index Register in location XYZ.
ØX→XYZ Same as above.
XYZ+2 , X3→SP Move the bytes in location XYZ+2+(IX) and XYZ+3+(IX) to the Stack Pointer.
IX→(XYZ) Store the Index Register in the memory location pointed to by location XYZ.
(IX)→(XYZ) Store the contents of the memory location pointed to by the Index Register in the memory location pointed to by location XYZ.
ABC (2-3) Bits 2-3 of memory location ABC.

### b) Subroutine Calls

Subroutine calls contain the name of the subroutine, a statement of the sub-outline, a statement of its function, and the flowchart section which describes it as shown in Figure 35.

### Data Structures

The memory map is shown in Figure 36, the PIA Definitions in Figure 37, and the Data Transmission Format in Figure 38.

### Background Processing

The Background Processing Hierarchy is shown in Figure 39.

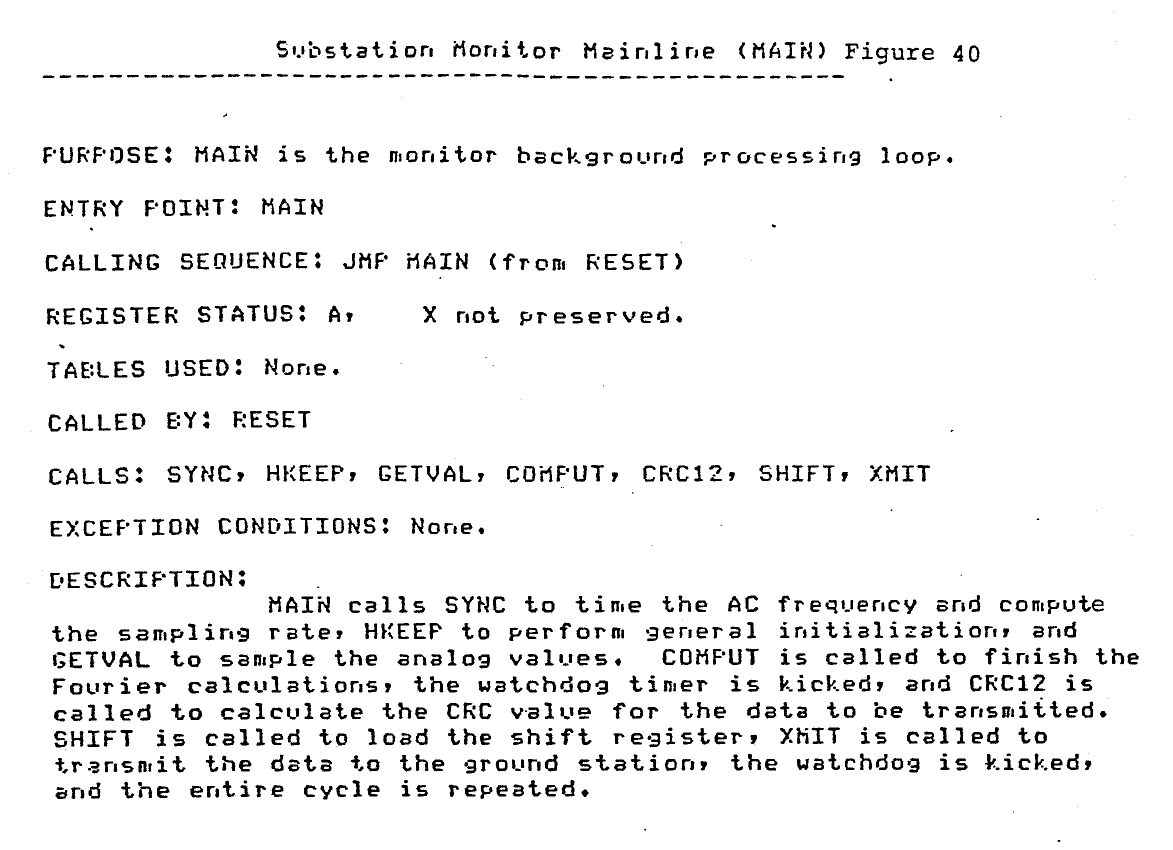

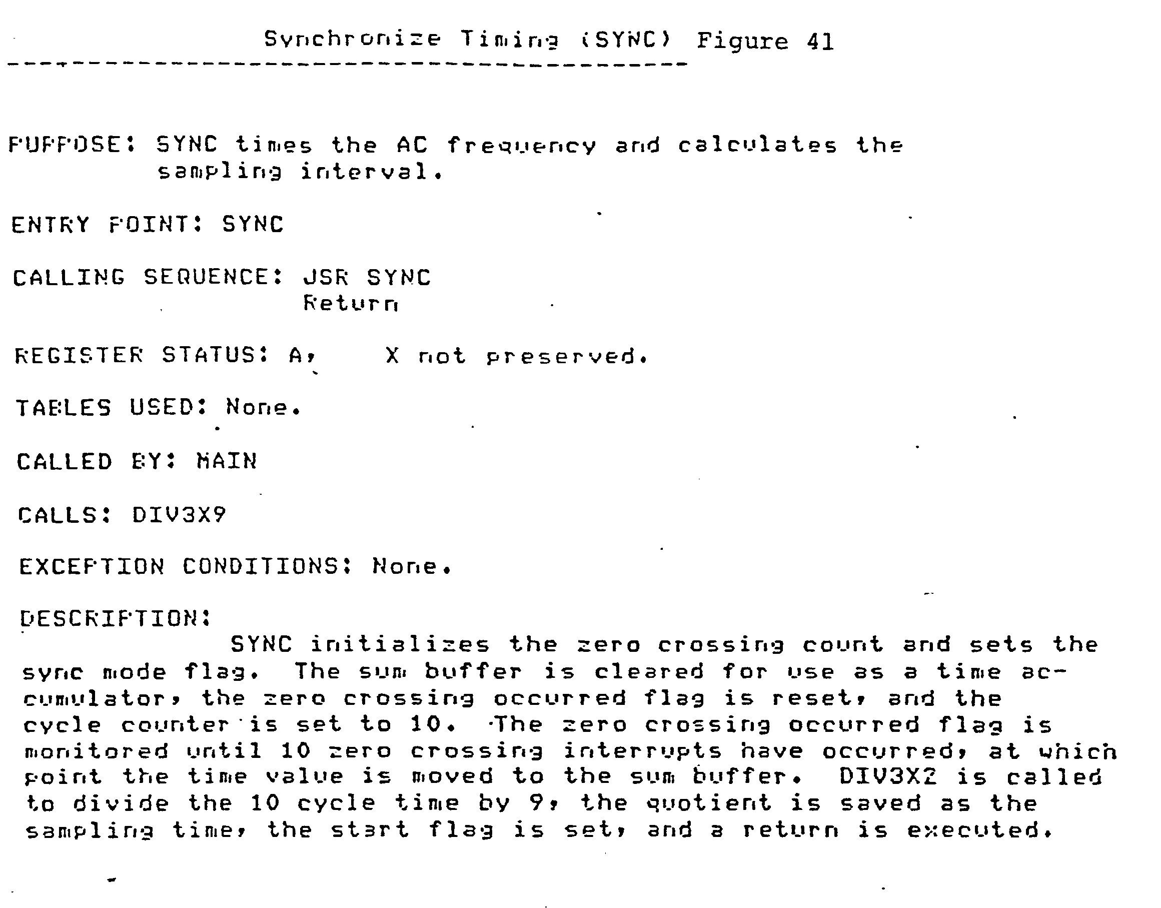

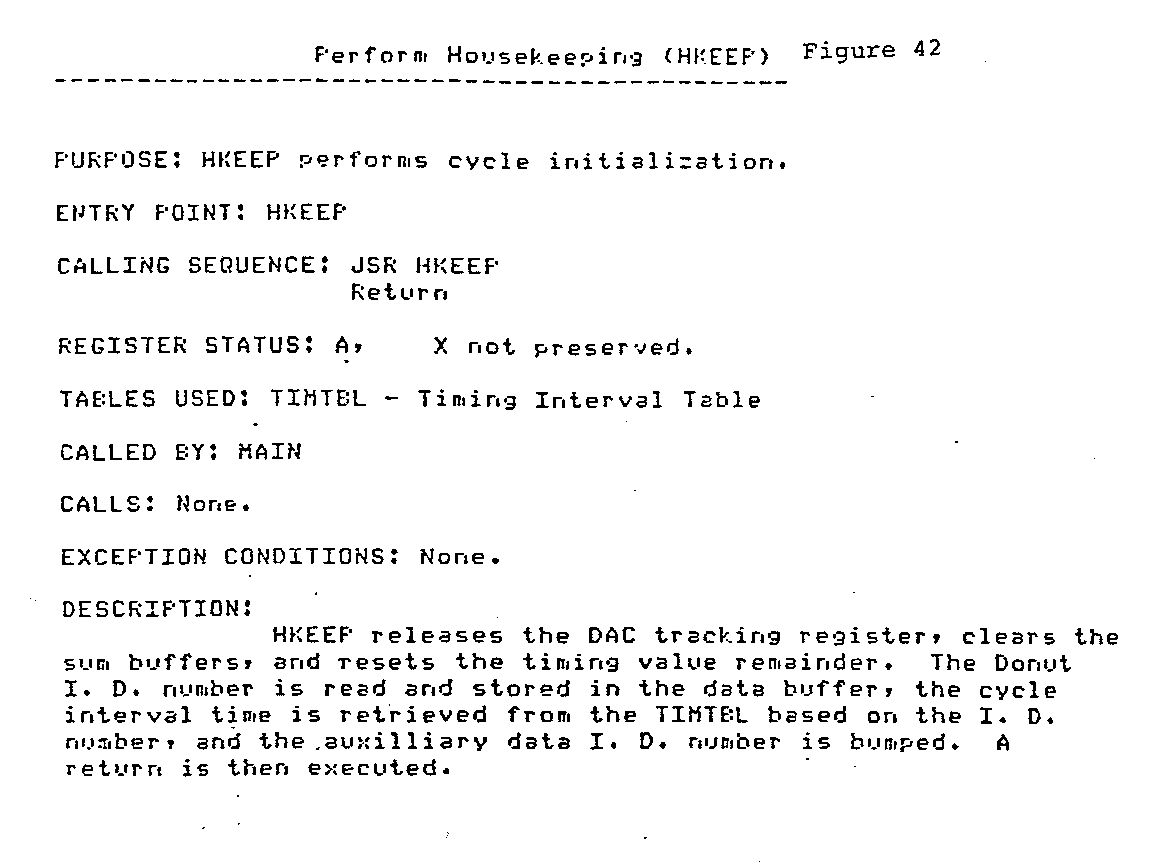

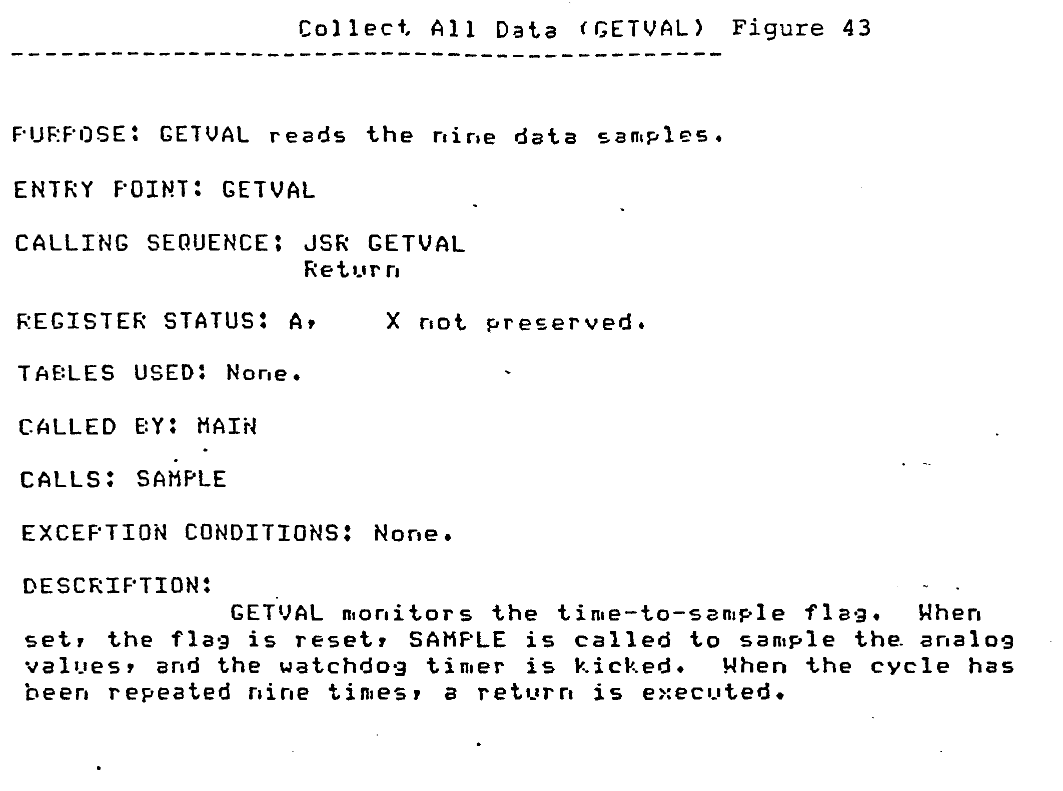

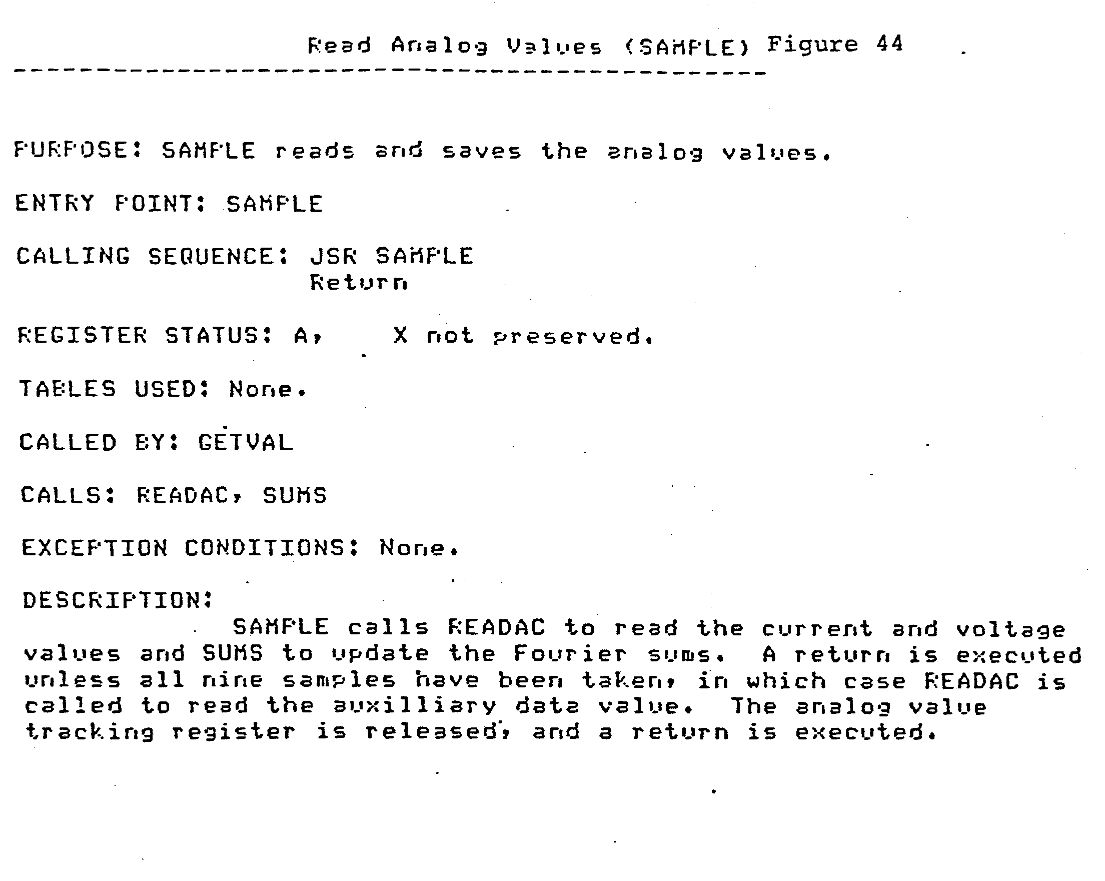

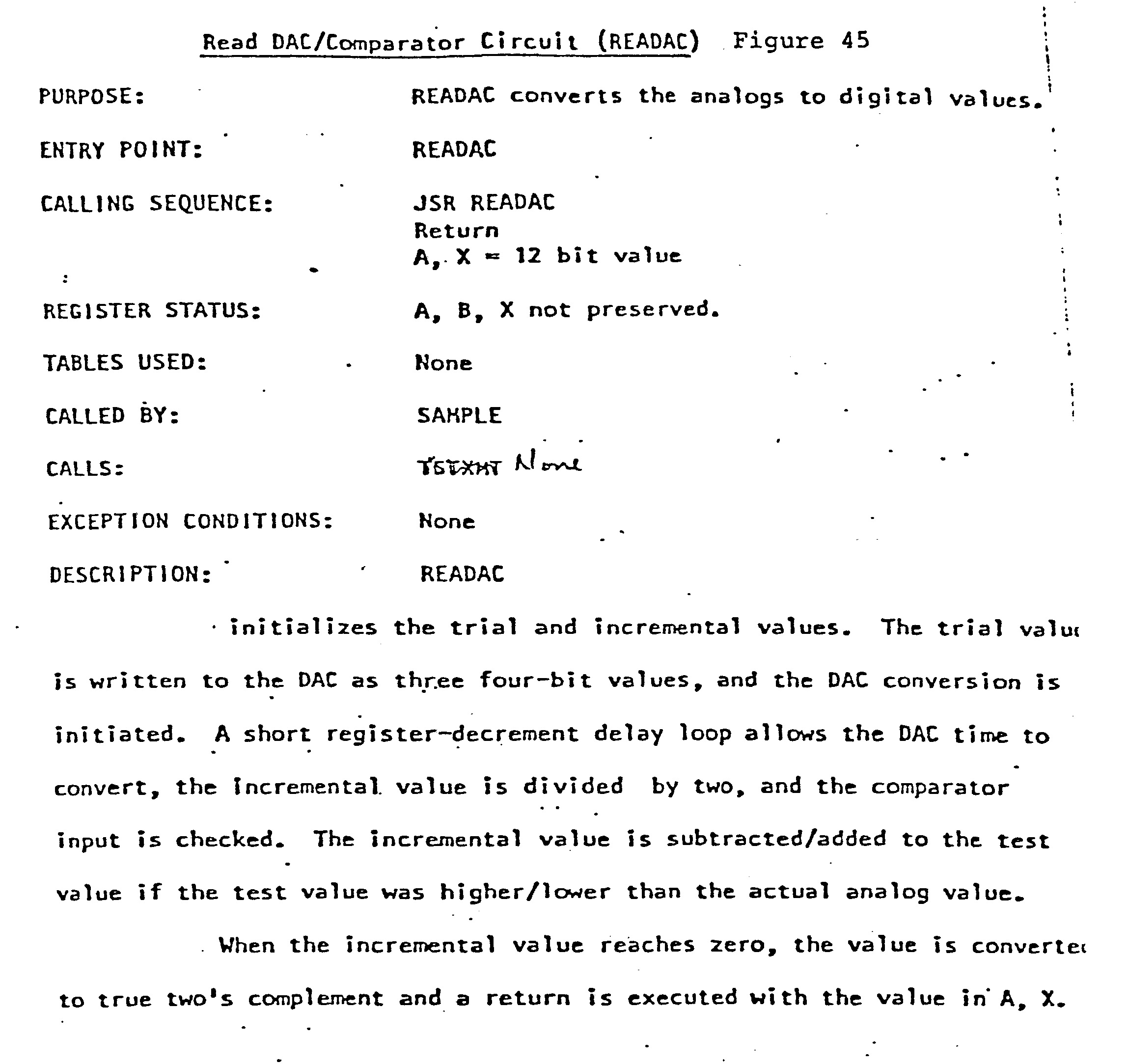

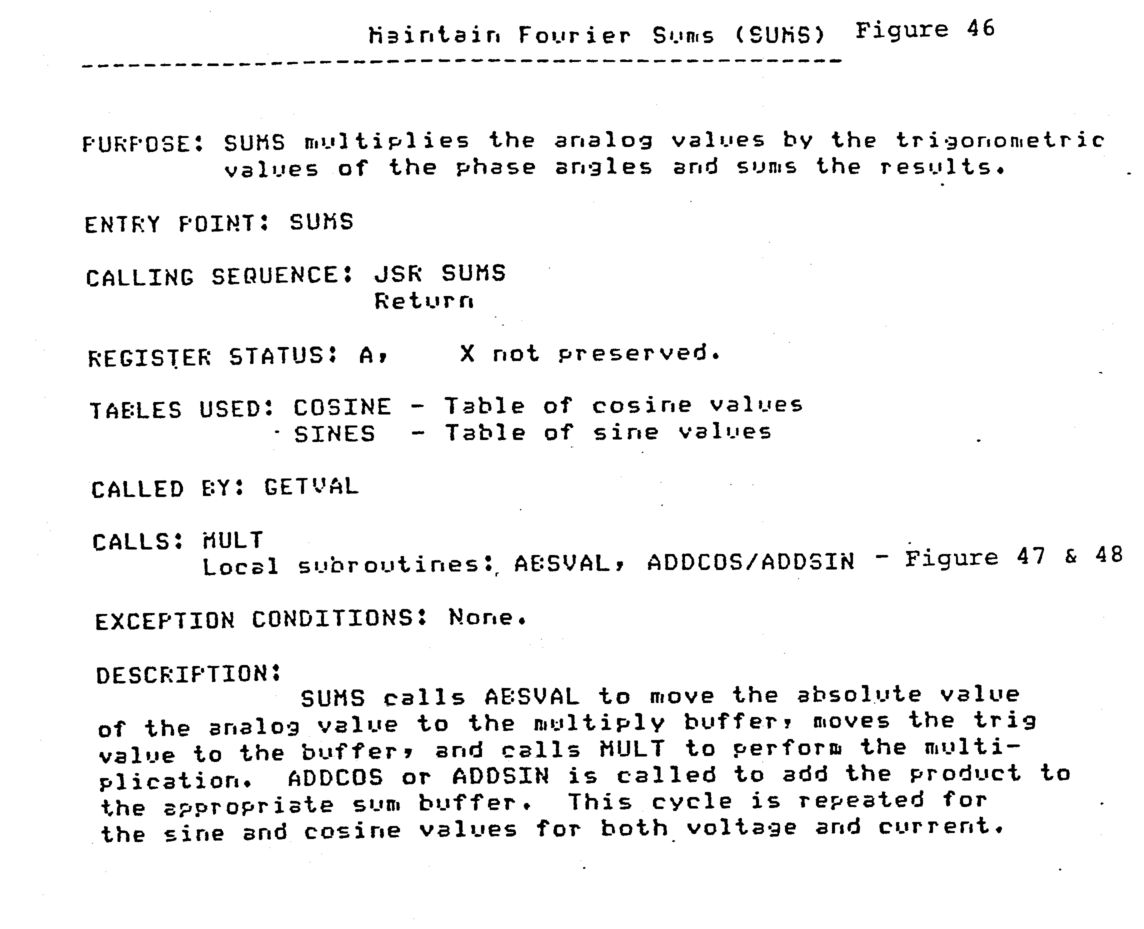

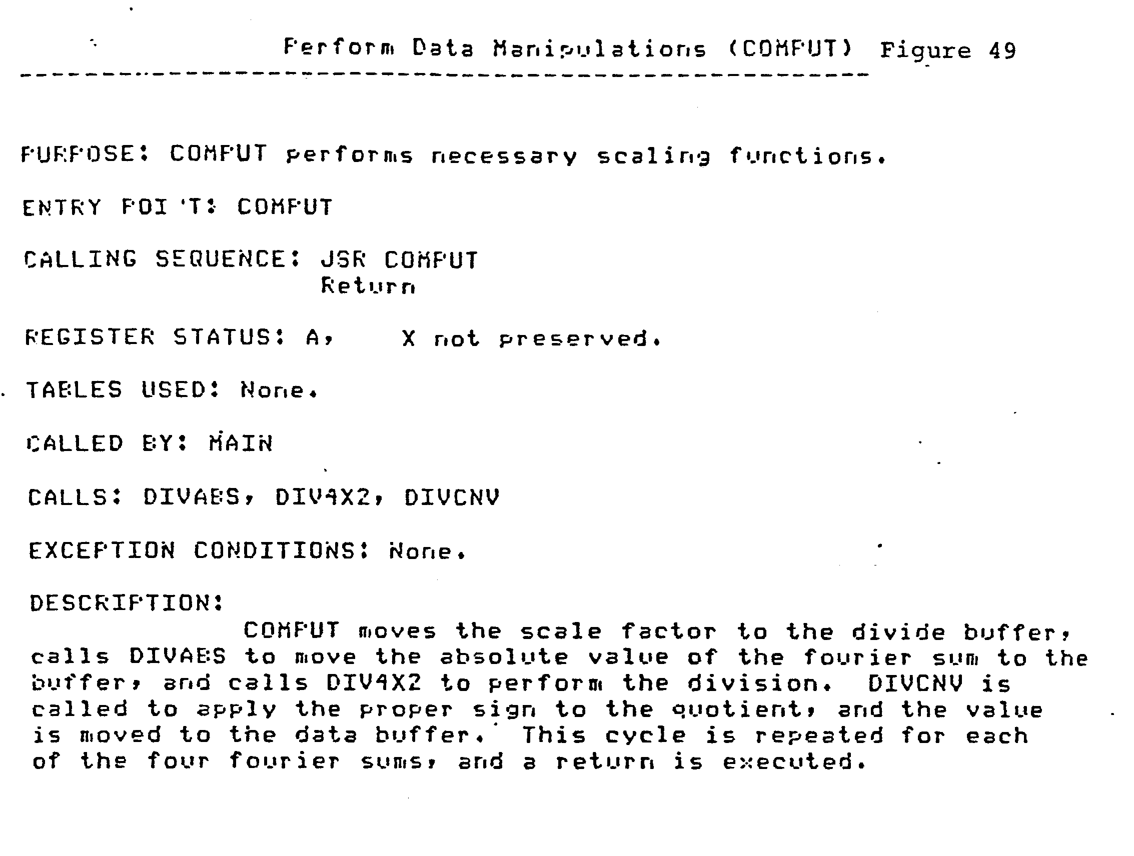

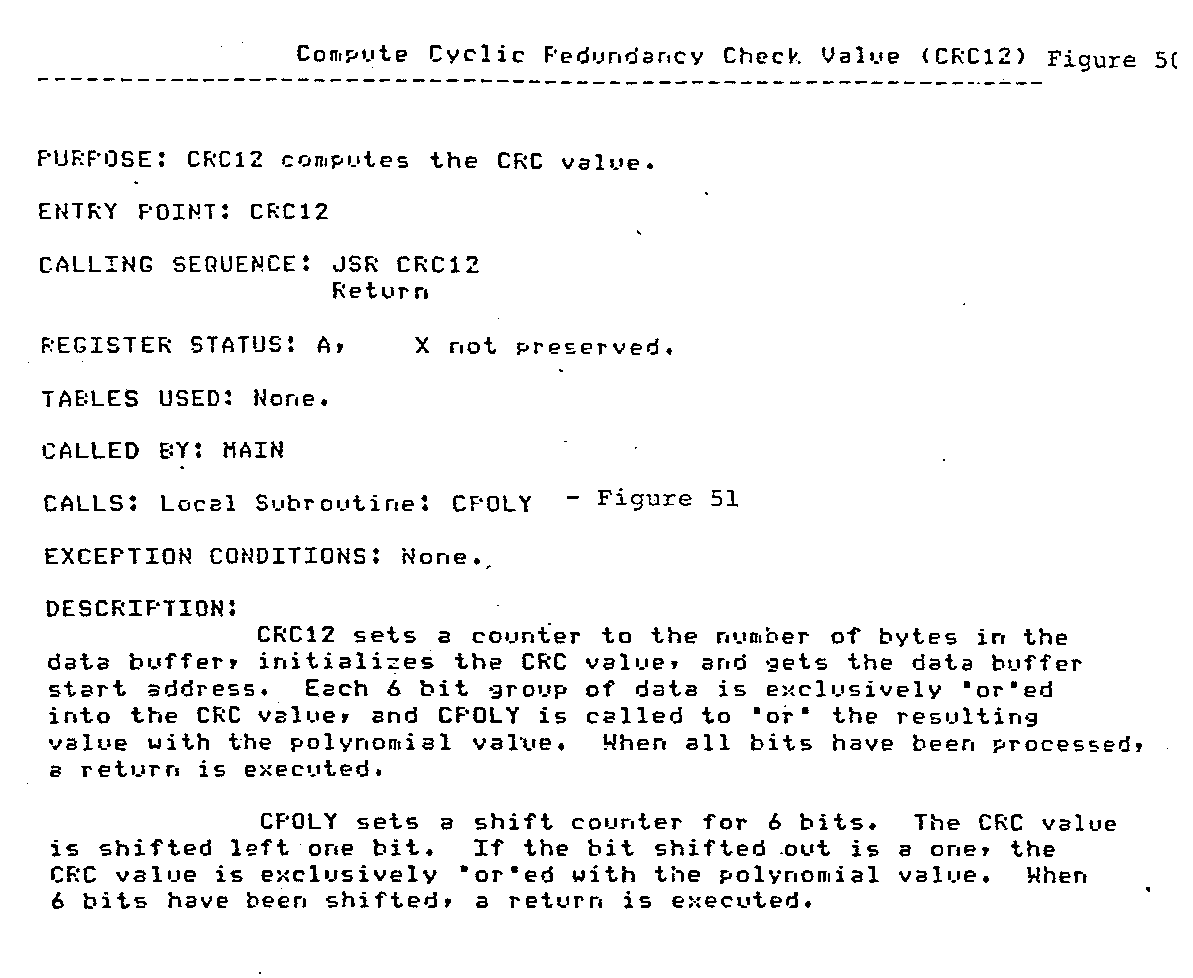

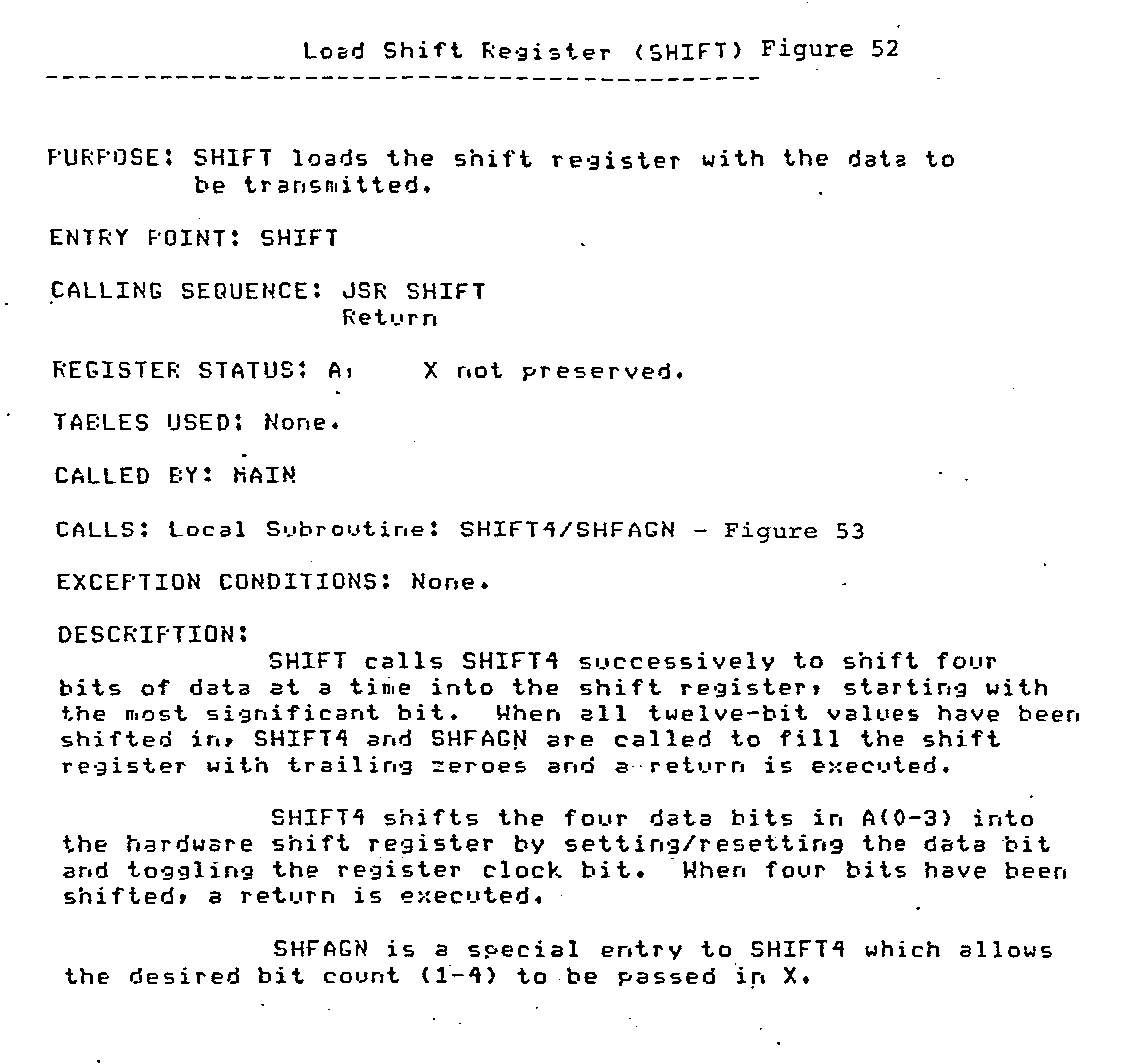

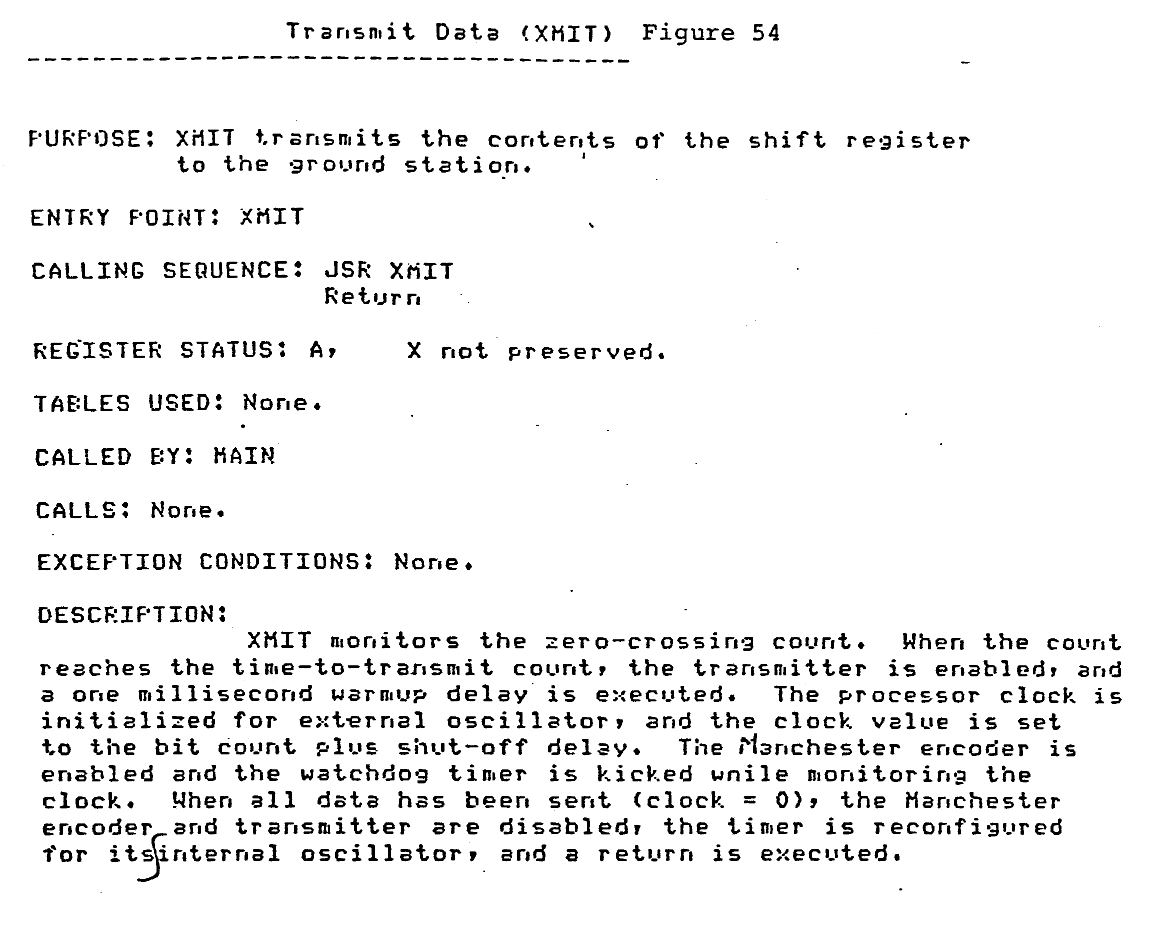

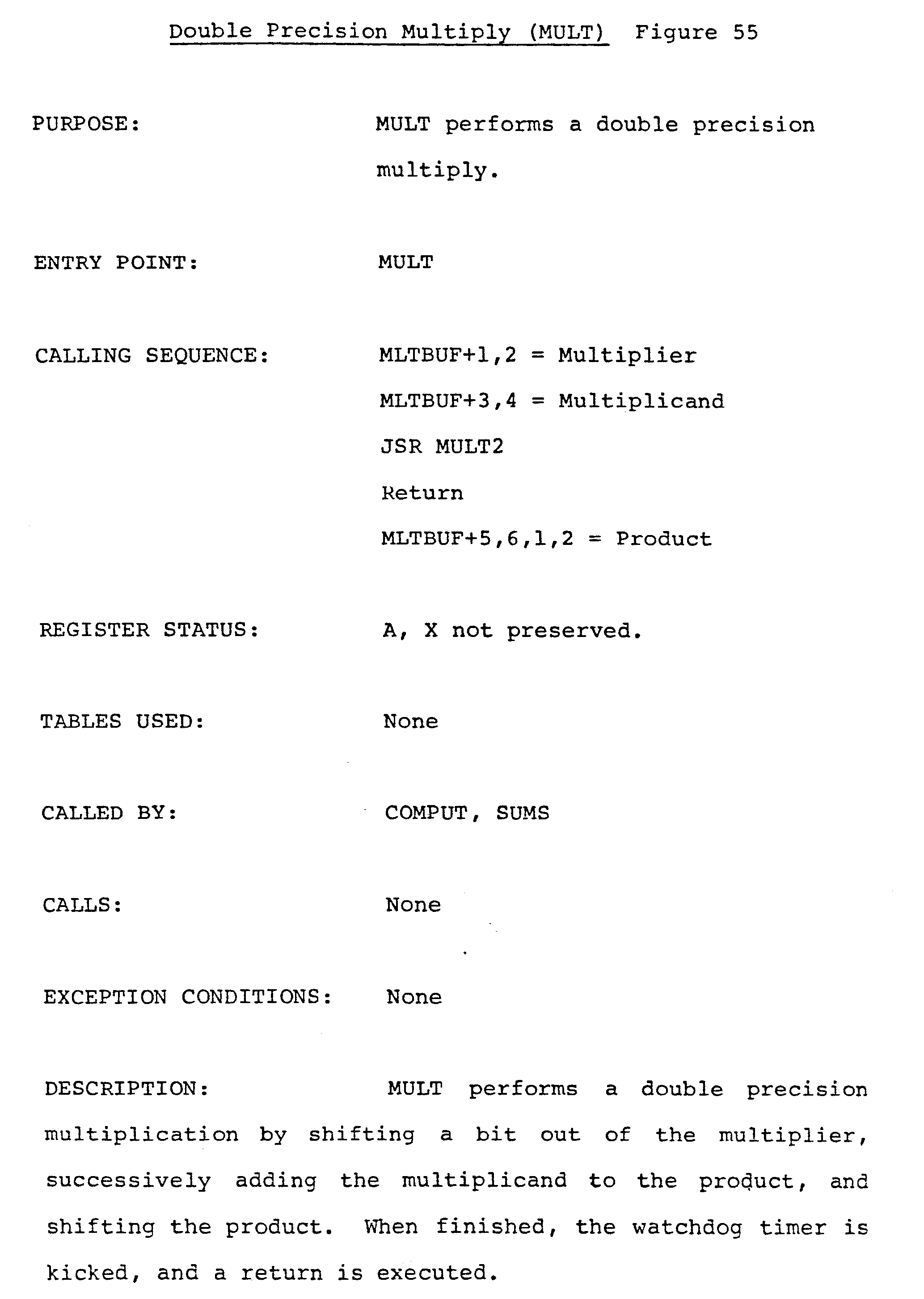

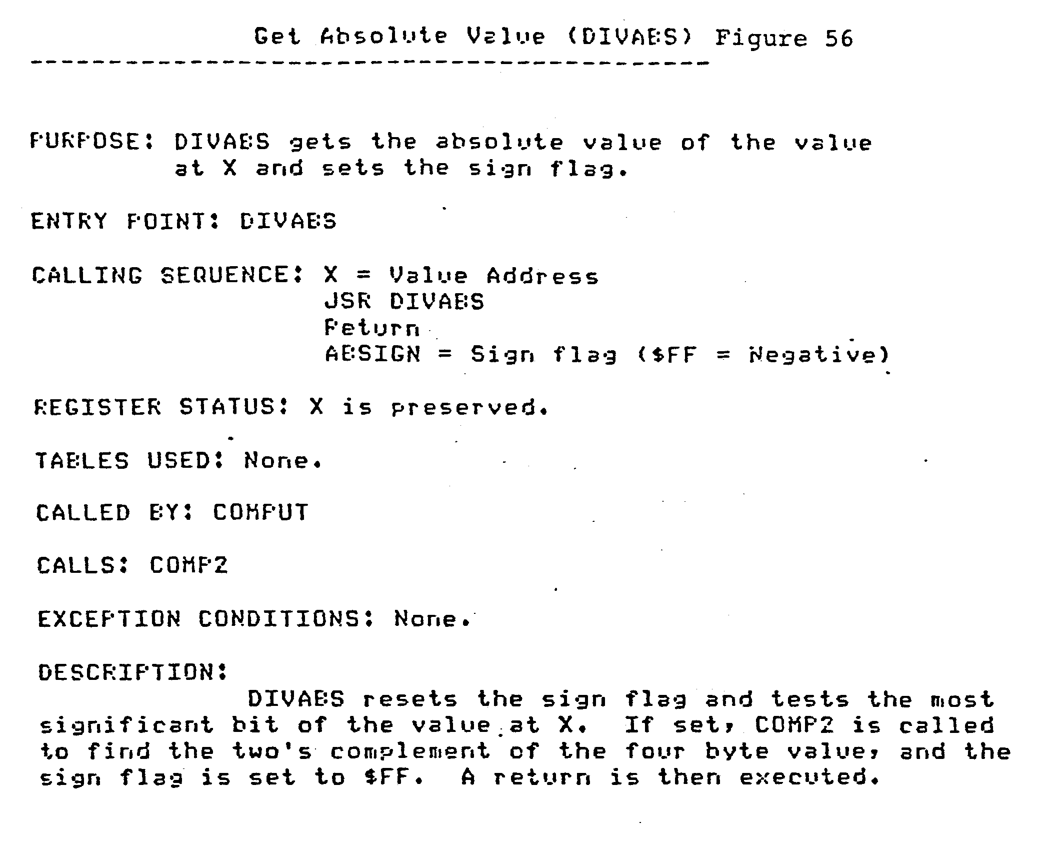

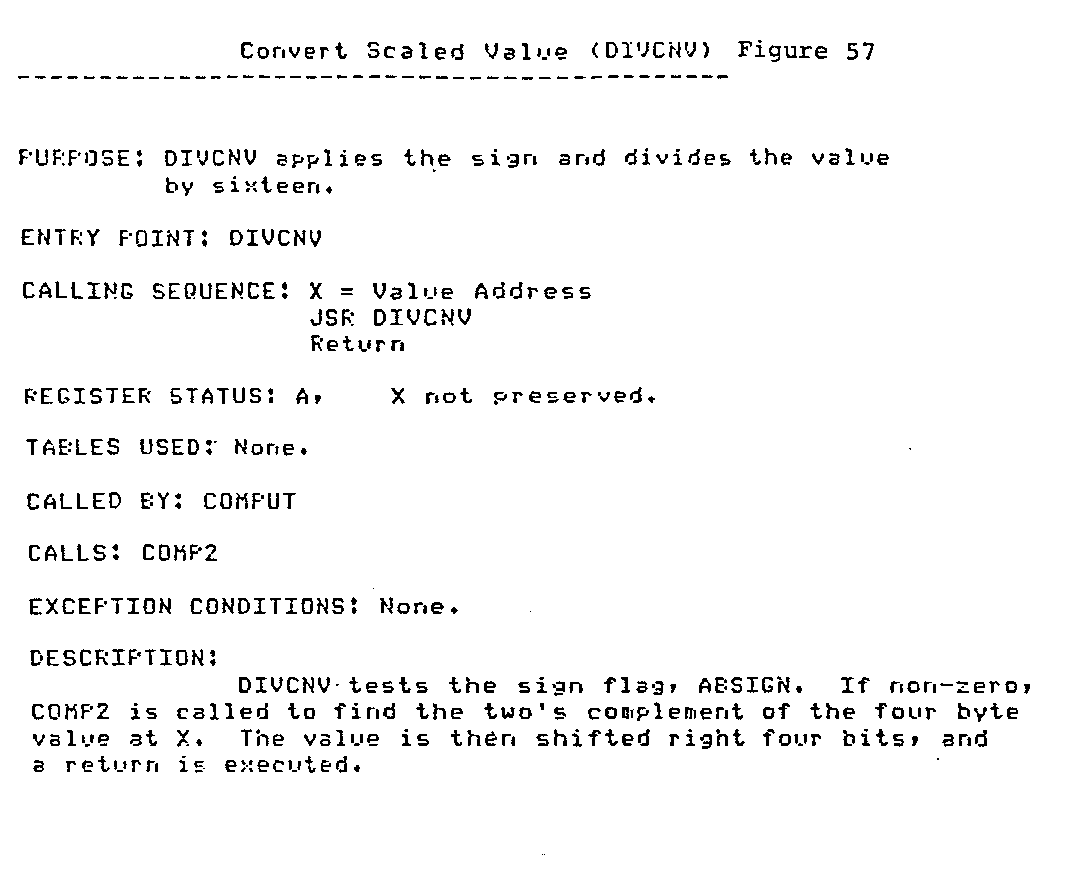

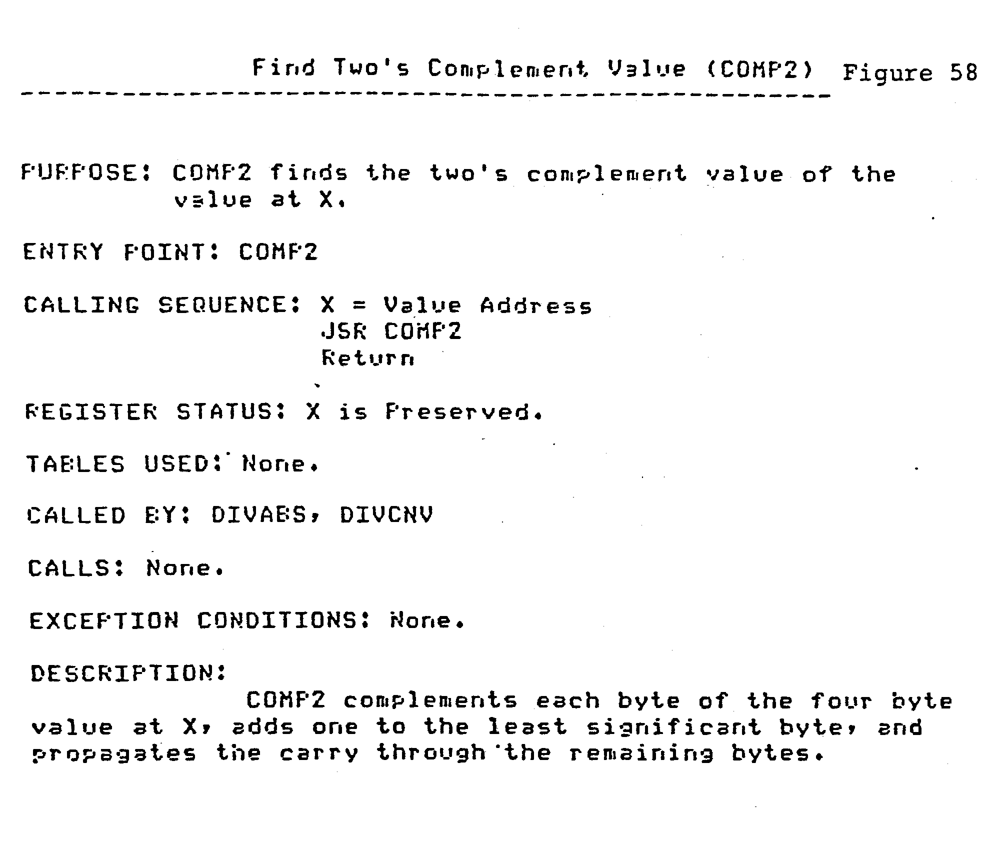

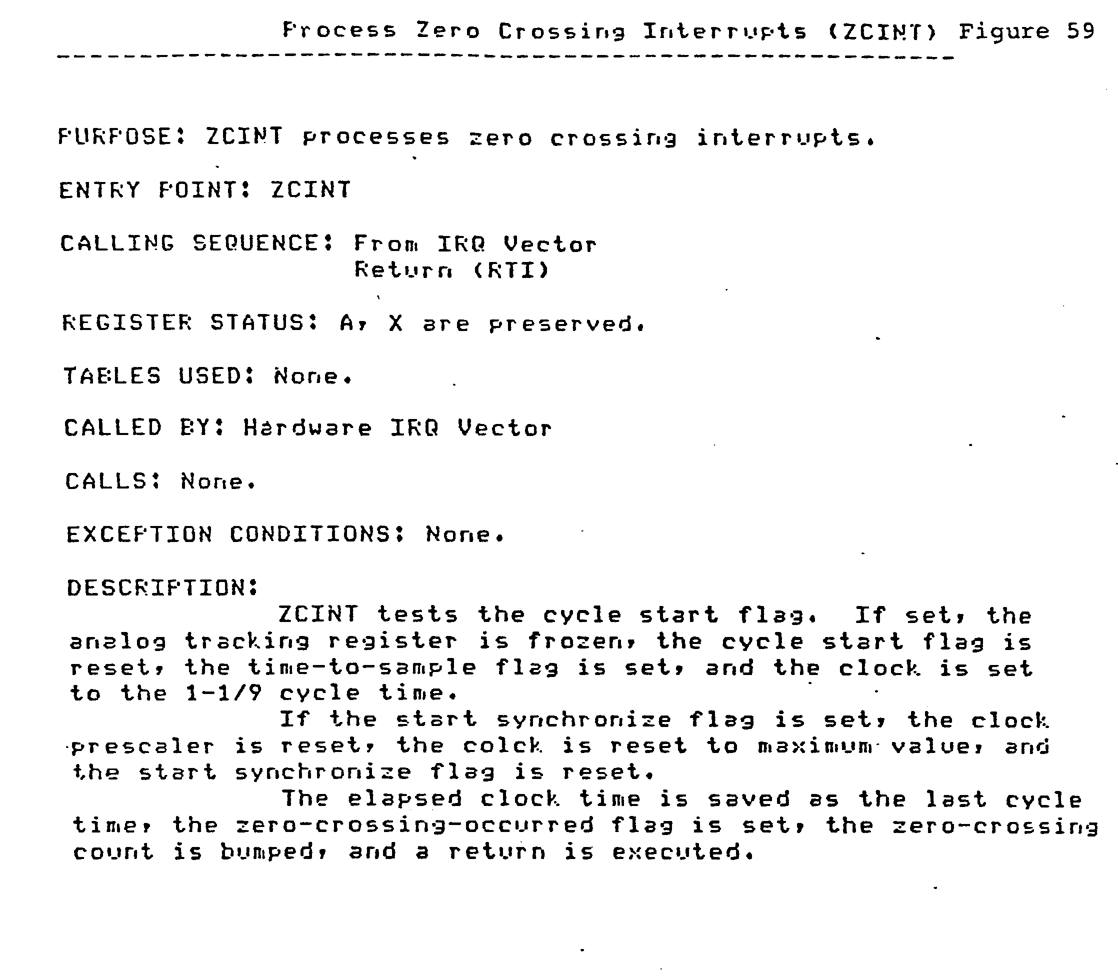

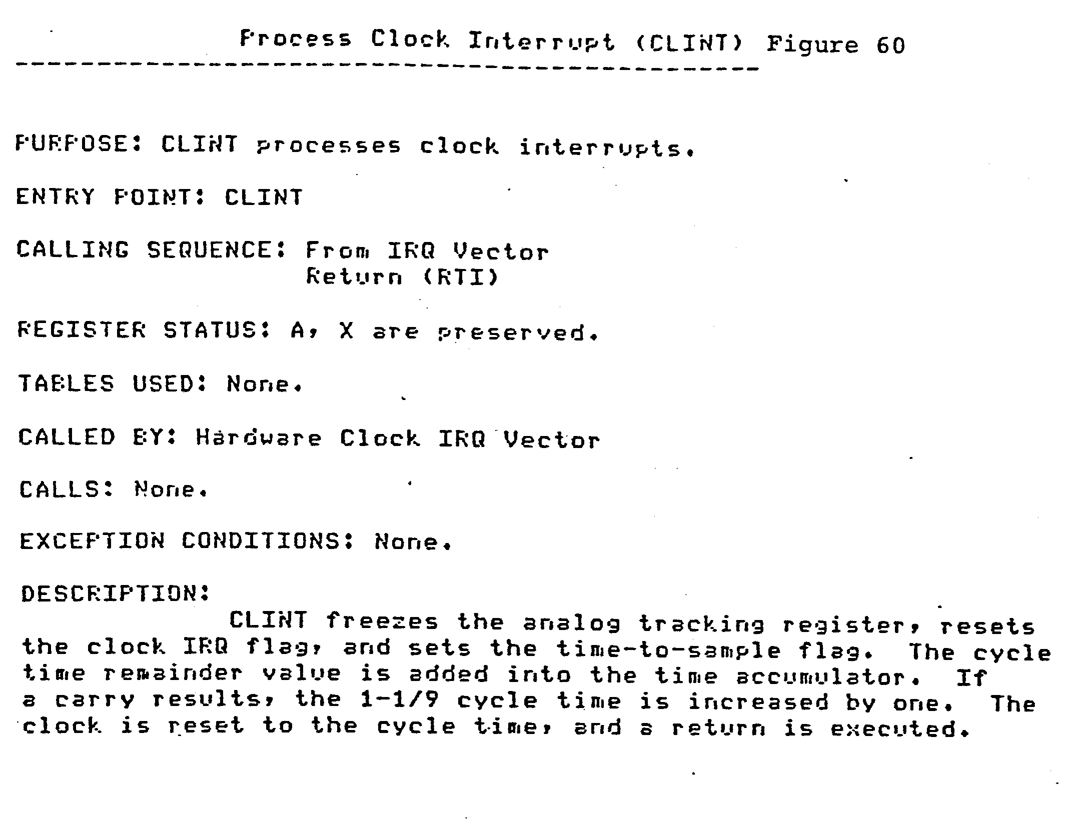

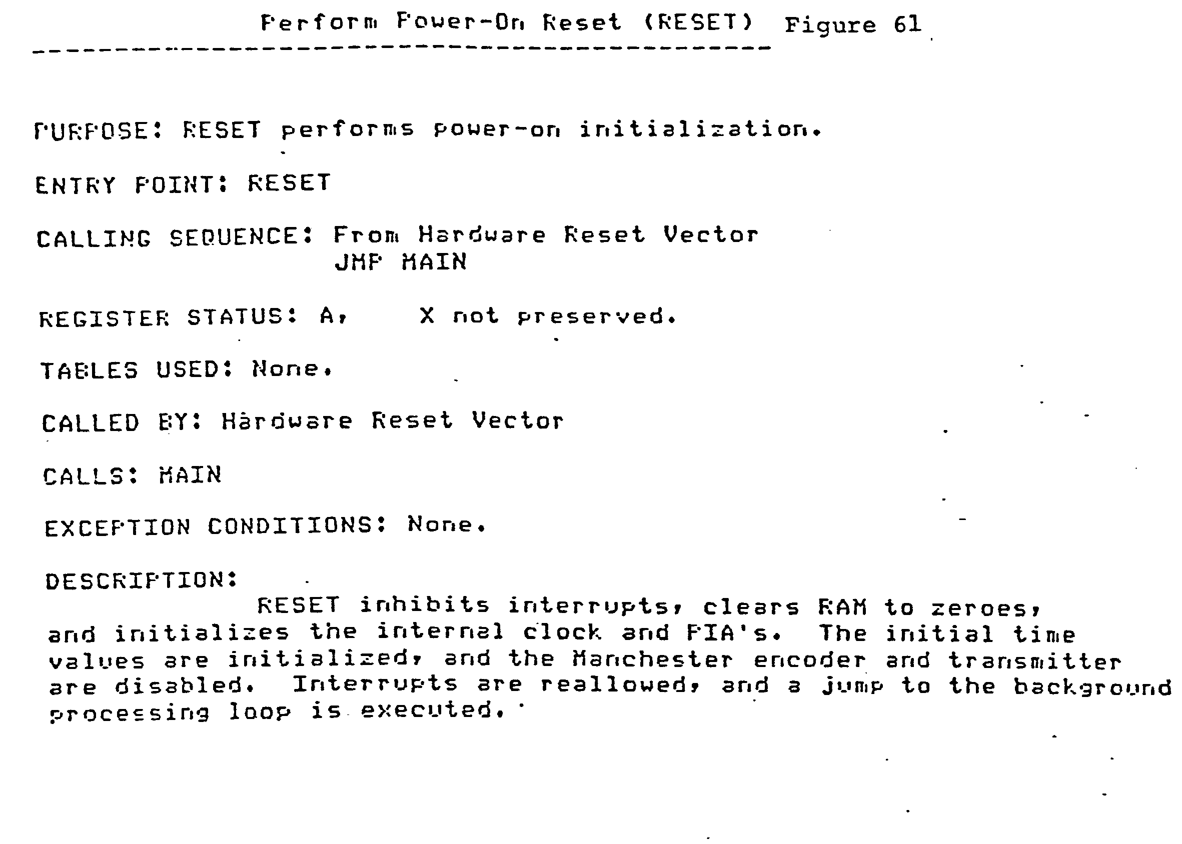

### The Receiver

The receiver 24 at a substation 34 as shown in Figure 4 receives data from fifteen donuts.

In Figure 62 there is shown an overall circuit block diagram for such a receiver 24.

In addition to receiving transmissions from up to fifteen donuts 20, via its antenna 30 and radio receiver 330, the receiver 24 can also receive analog data from up to 48 current transformers and potential transformers generally indicated at 332. The receiver 24 is operated by a type 68000 Central Processing Unit 334. The Manchester coded transmissions from the donuts 20 received by the receiver 330 are transmitted via line 336 to a communication board 106 and thence on data bus 338 to the 68000 CPU 334. The transformer inputs 332 are conditioned in analog board 340 comprising conditioning amplifiers, sample and hold, multiplexing and analog-to-digital conversion circuits under control of analog control board 342. The digitized data is supplied on data bus 338 to the CPU 334. The CPU 334 is provided with a random access memory 346, a programmable read only memory 348 for storing its program, and an electrically erasable read only memory 349 for storing the scaling factors and personality tables.

The central processing unit 334 may be provided with a keyboard 350 and a 16 character single line display 352. It is also provided with an RS232 port 354 for loading and unloading so called personality tables comprising scaling factors and the like for the donuts 20 and the transformer inputs 332. The receiver 24 which is sometimes called herein a remote terminal unit interface, supplies data to a remote terminal unit via current loop 356 from an RS232 communications port on communications board 106.

### The Receiver Software

### Copyright@ 1983,

### Product Development Services, Incorporated (PDS)

### Functional Specification of the Receiver

The remote terminal unit may be a Moore MPS-9000-S manufactured by Moore Systems, Inc., 1730 Technology Drive, San Jose, California 95110, modified to receive and store a table of digital data each second sent on line 357. Unmodified, the MPS-900-S receives inputs from potential and current transformers, temperature sensors and the like at a substation, and converts these measurements to a digital table for transmission to a power control center 54 (Figure 5) or for use in local substation control.

Simultaneous transmissions from two or more donuts 20 are ignored since the garbled message received will not produce a check sum (CRC) that matches the check sum as received. The CRC check portion of the circuit is shown at 337.

### Overview:

An integral part of commercial power generation is monitoring the amount of power delivered to customers and, if necessary, purchase of power from other companies during peak demand periods. It is advantageous to the power company to be able to make measurements at remote substations, and be able to relay all the measurements to a central point for monitoring. Because of the large voltages and currents involved in commercial power distribution, direct measurement is not feasible. Instead, these values are scaled down to easily measured values through the use of Potential Transformers (PT's) for voltage, and Current Transformers (CT's) for current. Recently, we have developed another means for monitoring power line voltage and current. This is the Remote Line Monitor, a donut shaped (hence the nickname "donut") device which clamps around the power line itself, and transmits the measured values to a radio receiver on the ground.

The Remote Terminal Interface (RTI) monitors power line voltage, current, and temperature by means of Potential Transformers (PT's), Current Transformers (CT's), and temperature transducers respectively. These parameters may also be obtained from Remote Line Monitors, or "donuts" which are attached to the power lines themselves. It is the job of the RTI to receive this data, and in the case of P_{T}'s, _{C}T's and temperature transducers, digitize and analyze the data. This data is then used to calculate desired output parameters which include voltage, current, temperature, frequency, kilowatt hours, watts, va, and vars, (the last three being measures of power). These values are then sent to the Remote Terminal Unit (RTU) , and are updated once per second.

Data obtained from PT's, CT's, and temperature transducers must be digitized by the RTI before it can be used. Data obtained in this way is termed "analog" data. Donuts, on the other hand, send their data to the RTI in digital form. For this reason, input received from donuts is said to be "digital" input. Each donut supplies three parameters, (voltage, current, and temperature) thus it is equivalent to three analog inputs.

Virtually all commercial power systems in the United States today are three phase systems. There are two configurations used: the 3 conductor or delta configuration, and the 4 conductor or wye configuration. To calculate power (va, vars) it is necessary to measure the voltage and current in all but one of the conductors. That one conductor is used as a reference point for all voltages measured. For a delta configuration, voltage and current in two of the three conductors must be measured (only two phases). This is referred to as the two wattmeter method. It is desirable to use the two wattmeter method whenever possible because only 2 PT's and CT's are required. For a wye configuration however, voltage and current must be measured in all 3 phases. (The fourth conductor is an ex- . plicit reference point. No such reference is provided in the delta configuration, so one of the phases must be used instead.) This latter method is known as the three wattmeter method.

The program listings for the receiver remote terminal interface are found in Appendix B. They comprise a number of subroutines on separately numbered sets of pages. The subroutines are in alphabetical order in Appendix B. At the top of page 1 of each subroutine the name of the subroutine is given, (e.g., ACIA at the top of the first page of Appendix B). The routine INIT initializes the computer and begins all tasks.

Appendix C comprises equates and macro definitions used in the system. Those headed STCEQU are for the system timing controller (an AM9513 chip). Those headed XECEQU are for the Executive program EXEC in Appendix B. Those headed RTIEQU are unique to the remote terminal interface and used throughout the programs of Appendix B.

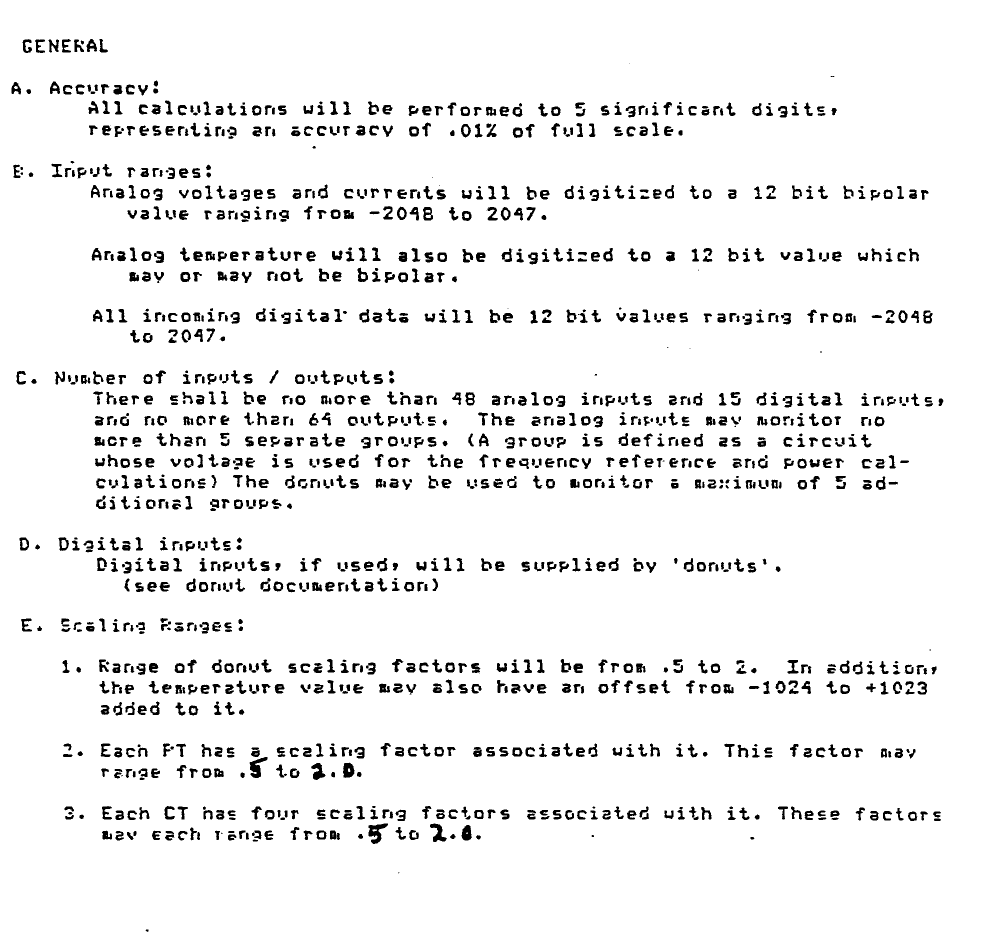

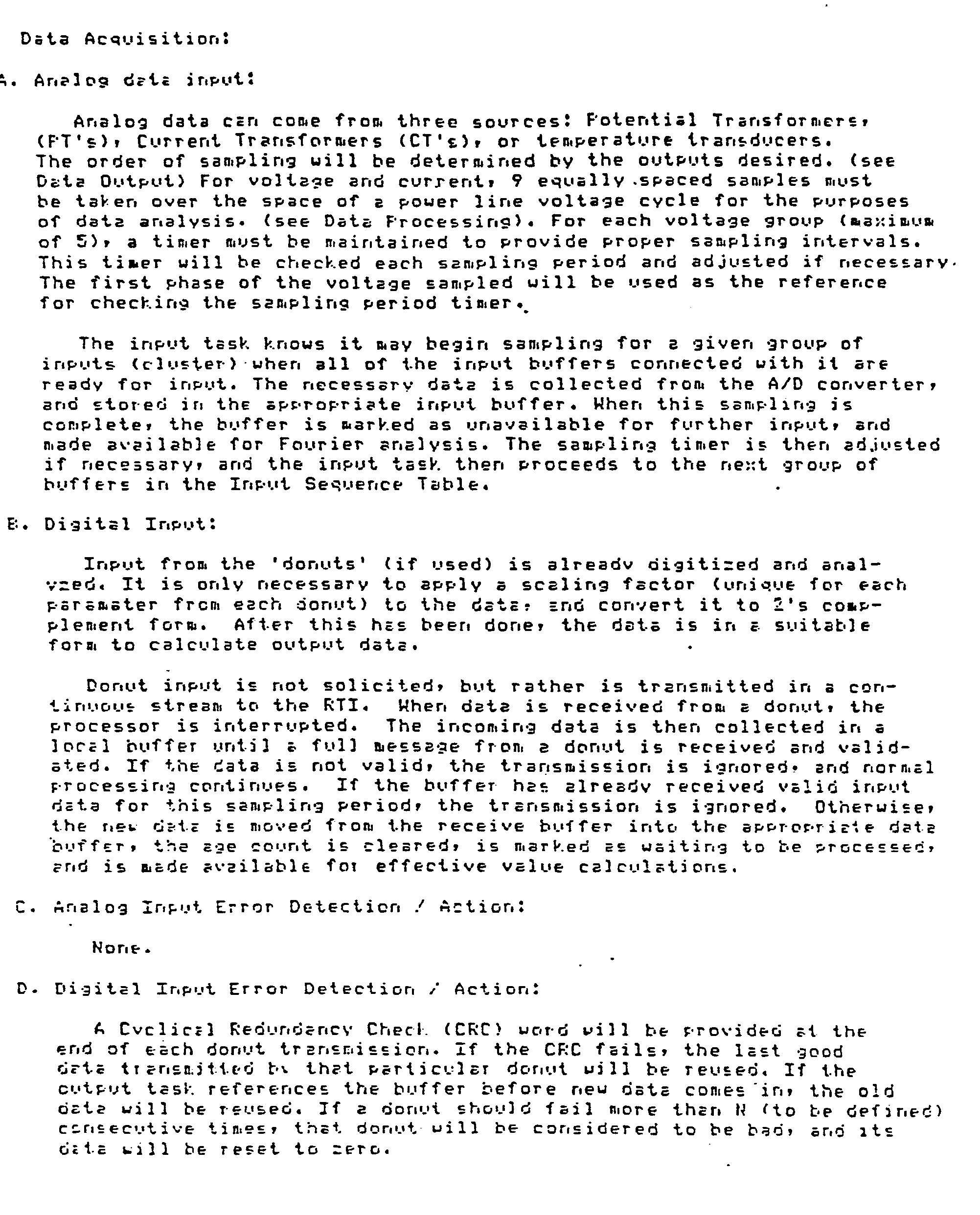

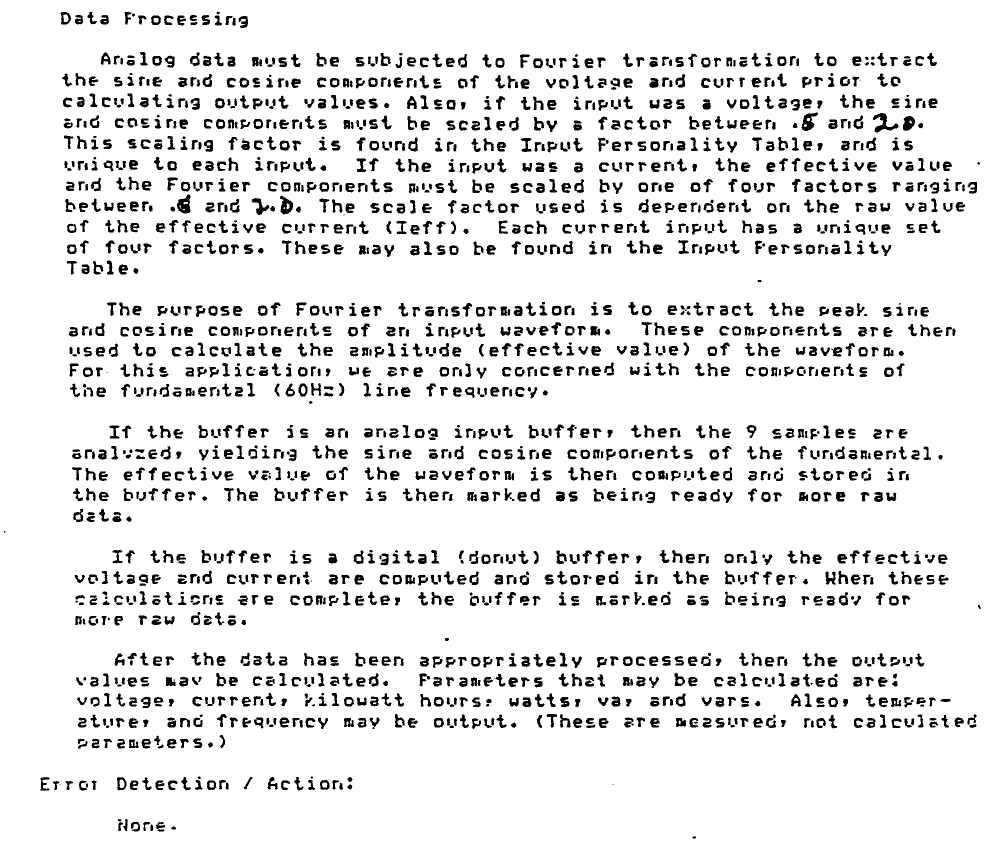

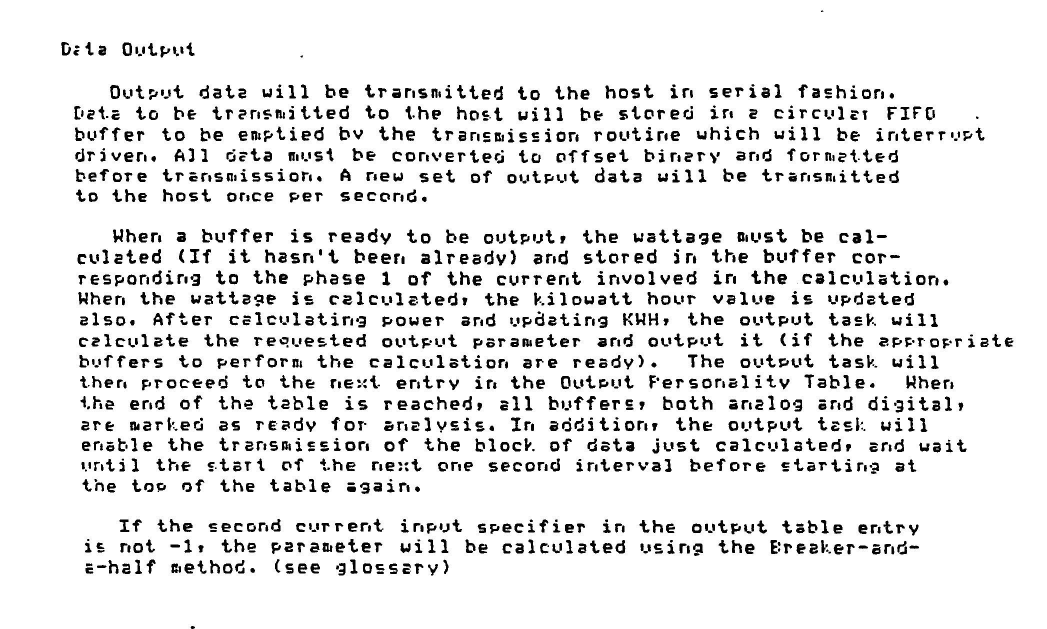

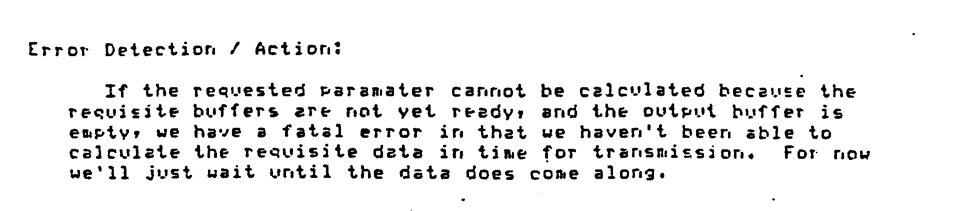

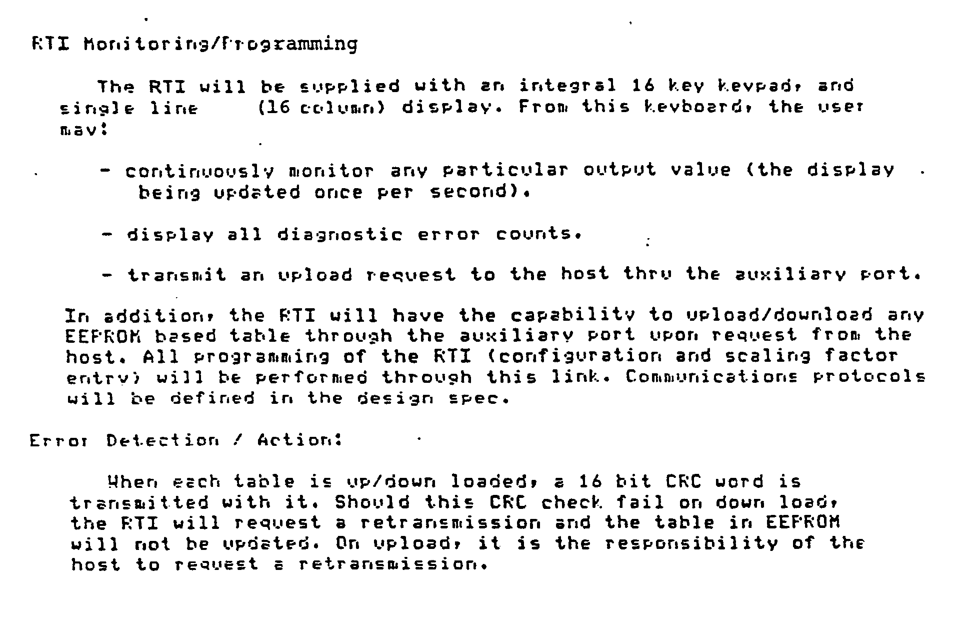

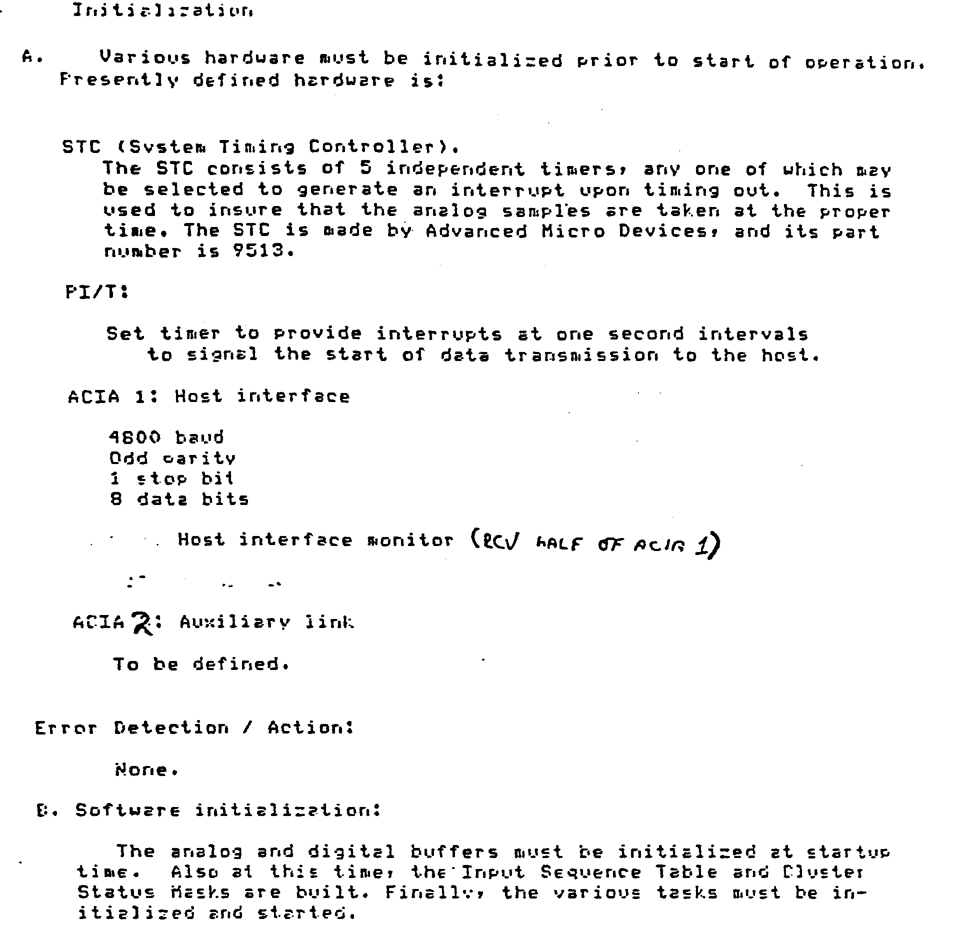

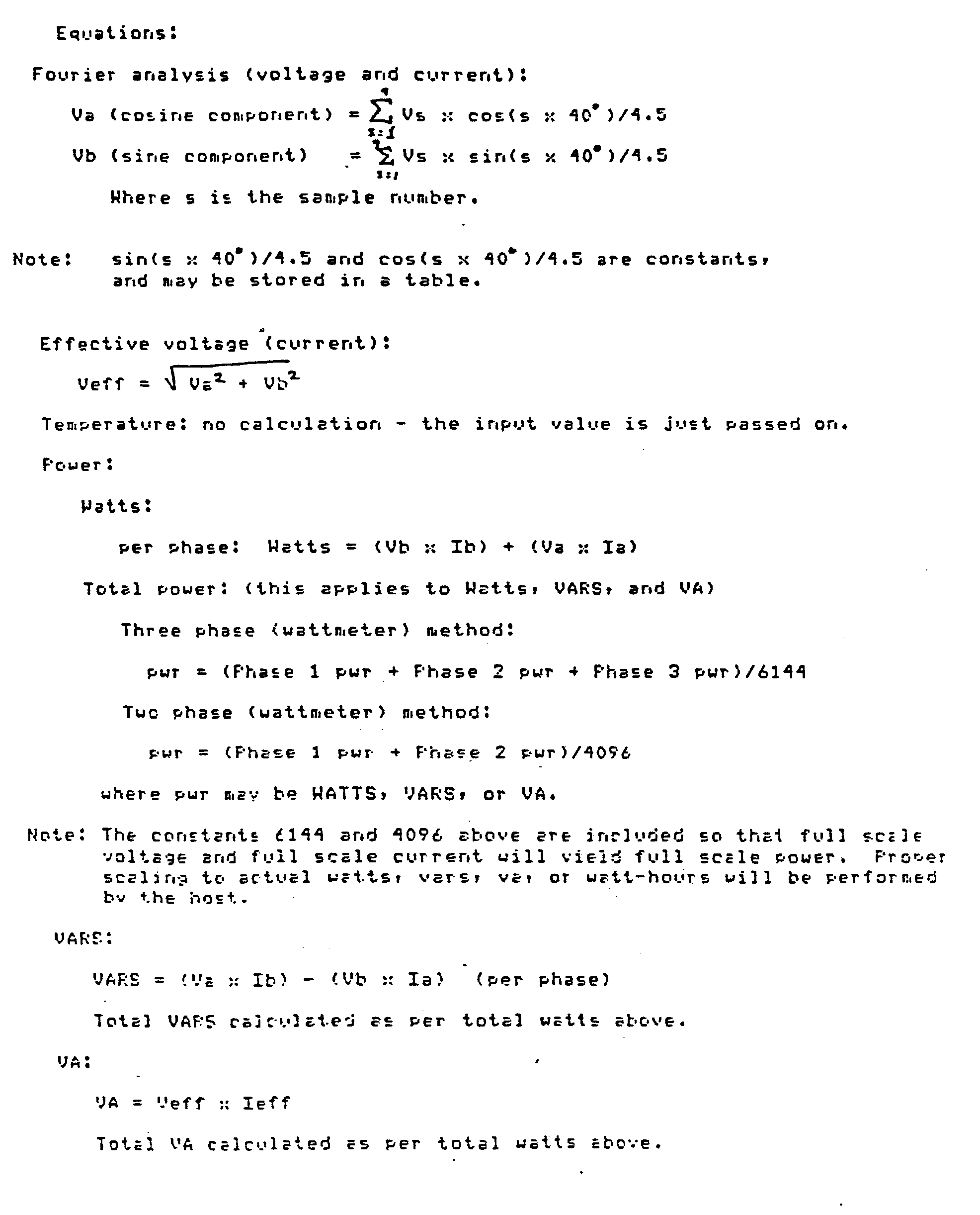

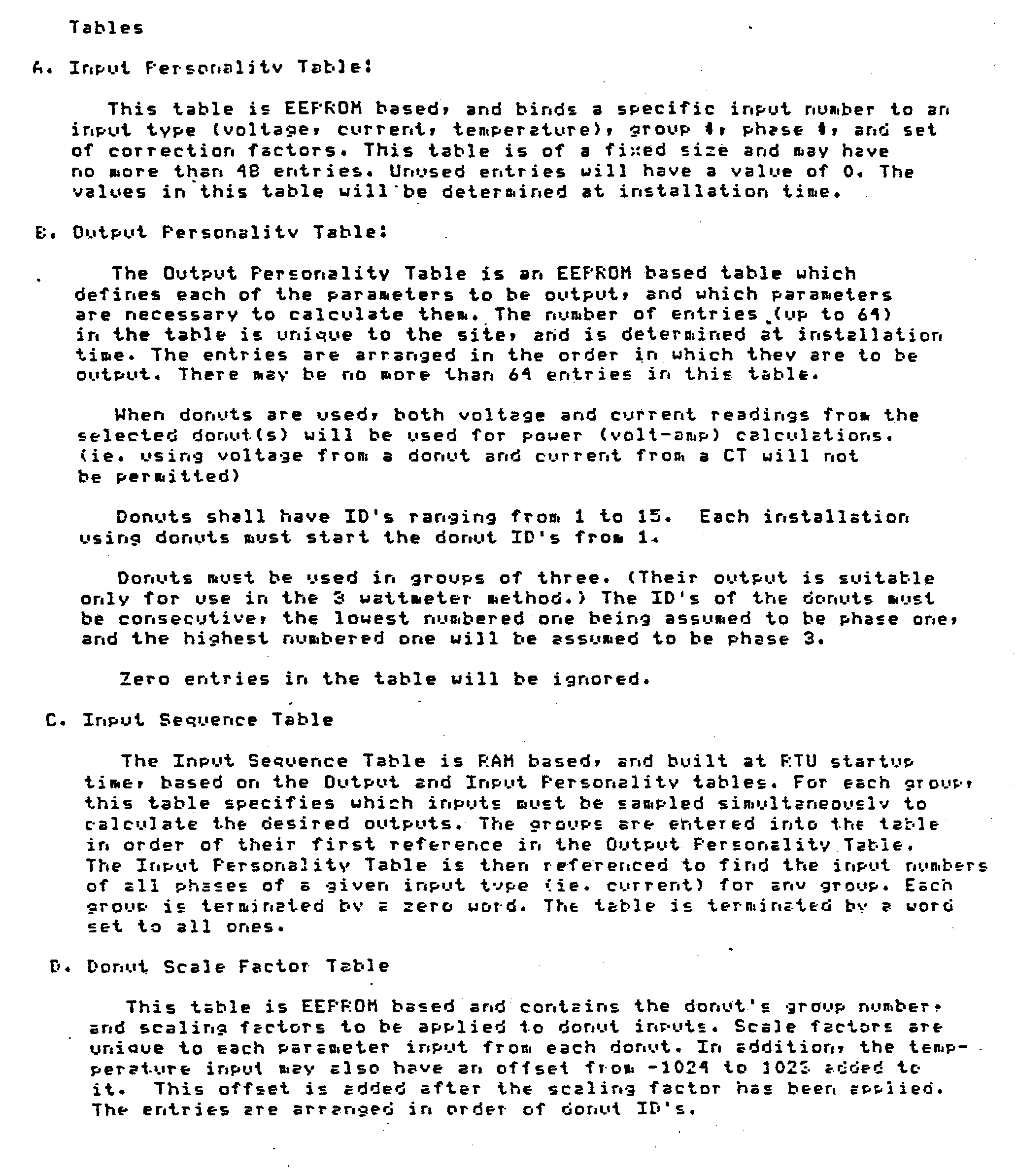

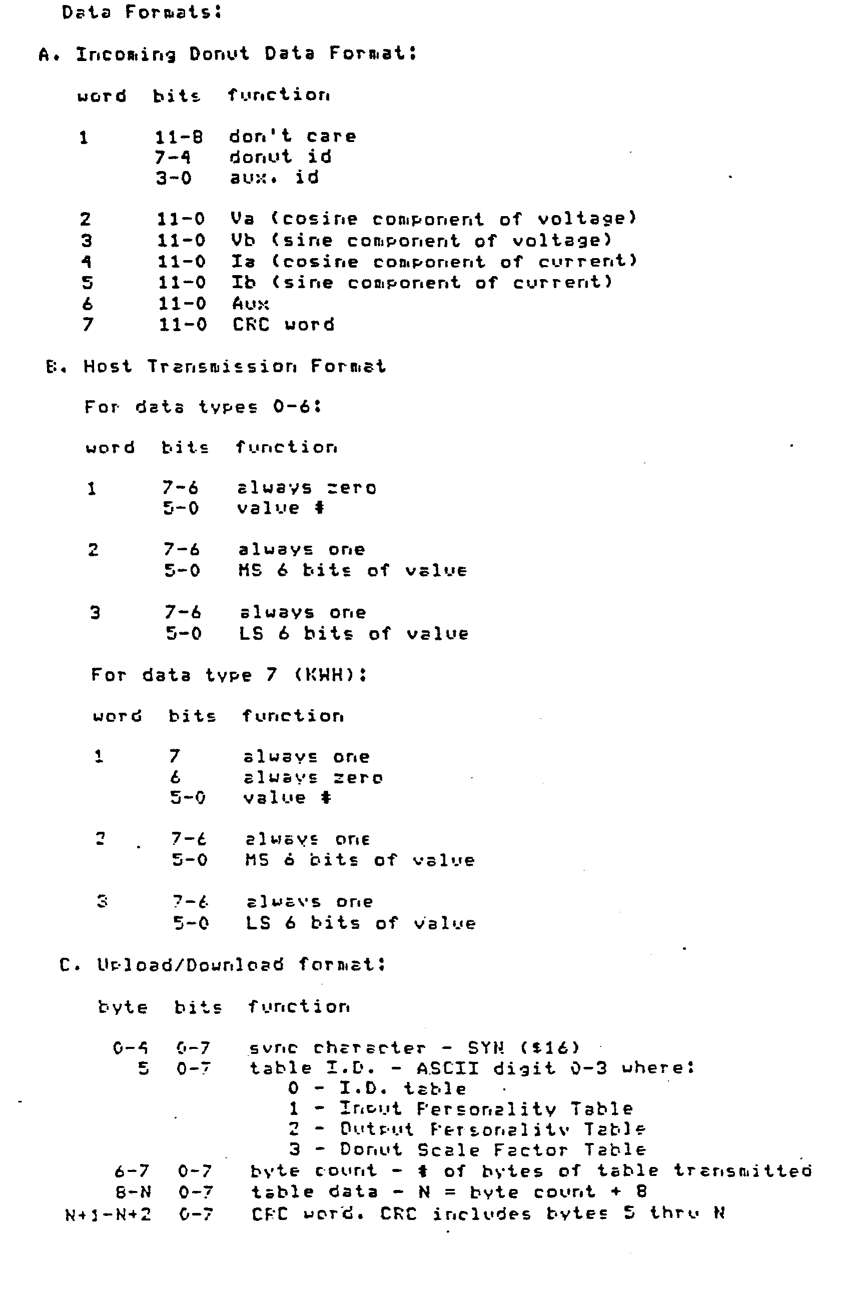

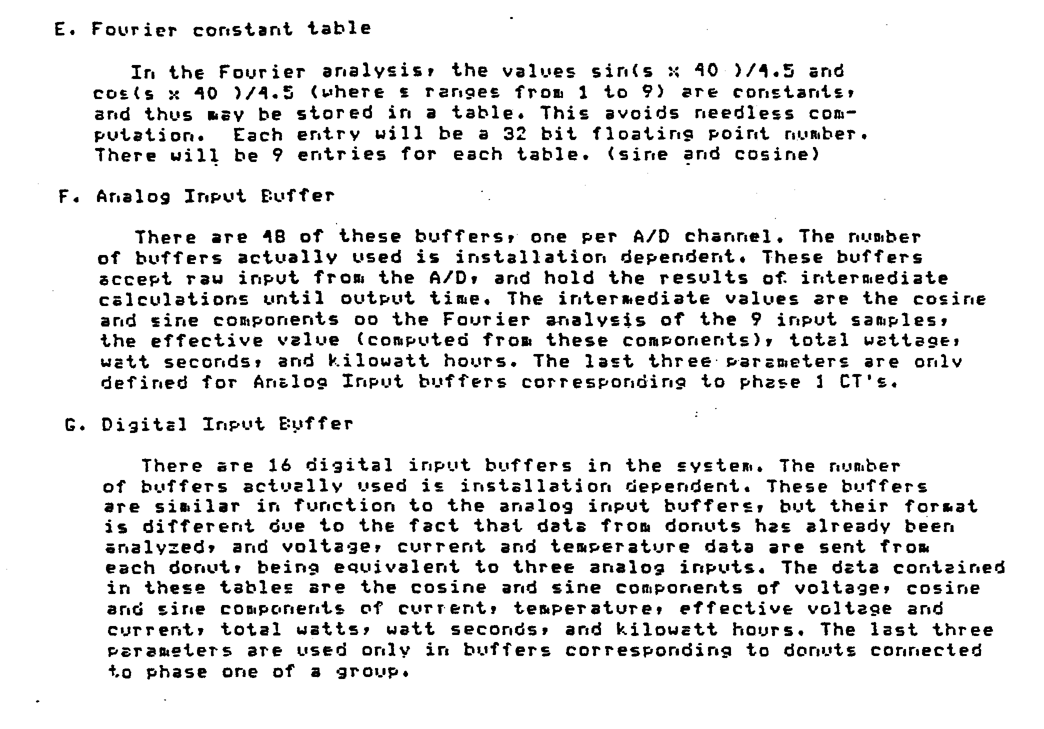

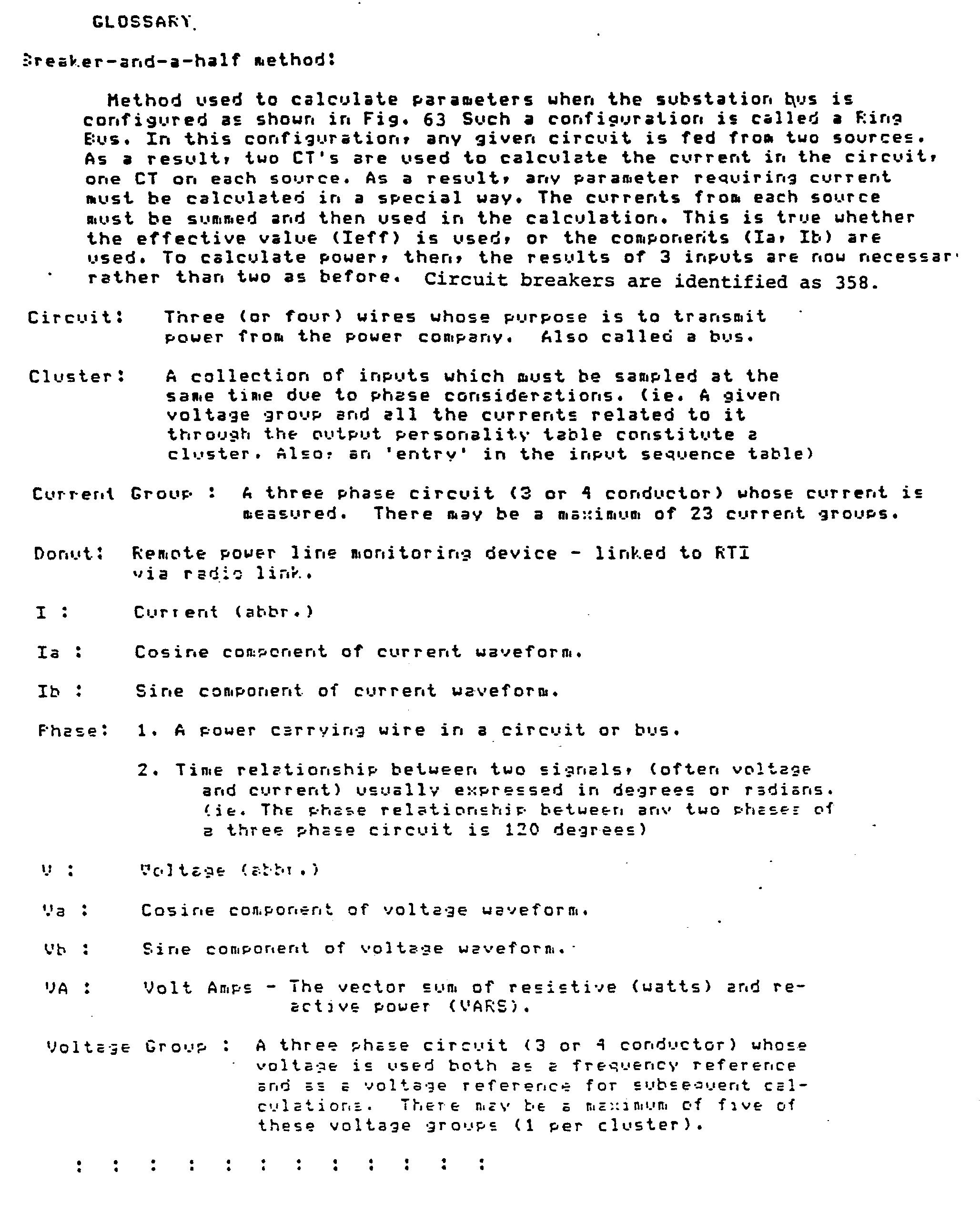

### Receiver Operation

A state diagram for the program of the central processing unit 334 of Figure 62 of the receiver 24 is shown in Figure 64. Processing tasks are indicated by the six-sided blocks. Tables stored in the electrically erasable read only memory 349 are indicated by the elongated oval boxes. Data paths are shown by dotted lines and peripheral interfaces are indicated by zig-zag lines. The transformer inputs 332 and donut input 336 are shown in the upper left. The RS232 port 354 is shown in the lower right and the output RS232 port 32 is indicated in the middle of the diagram.

The donut scale factor table is shown in Figure 65. Since donuts are normally operated in groups of three for three-phased power measurement, word 0 comprises the group number of the donut (GP), followed by the phase number of the donut (PH). The following words are the voltage scale factor, current scale factor, temperature scale factors, and temperature offset respectively. Temperature offset is an 11 bit value, sign extended to 16 bits. All two word values are a floating point. There is, of course, a separate scale factor table for each of the fifteen donuts provided for. The donut scale factor tables are stored in the electrically erasable read only memory 349.

Figure 66 is a table of the digital input buffers. There are sixteen required, one to store the received value of each of the fifteen donuts and one to act as a receiver buffer for the serial port of the communication board 106.

Word Ø comprises, in addition to the donut ID and a number called buffer age, indicating how long since the information in the buffer has been updated; the following flags:
DI(Data In) - Set when all data has been received and is ready for analysis. Clear when ready for new data.
AC(Analysis Complete) - Set when effective value and temperature scaling calculations are complete.
VP(Valid Power) - Set if total watts has already been calculated.
IT(Input Type) - Always 3. Identifies this buffer as donut input.

All single word values are 12 bits, sign extended to 16 bits. All double word values are floating point. Buffer age is the number of times this data has been used. The first buffer (buffer 0) is used to assemble incoming donut data. Words 14-16 are defined for 0 1 donuts only. Word Ø in the buffer number Ø is used for the donut status map. The digital input buffers are stored in the read only memory 346.

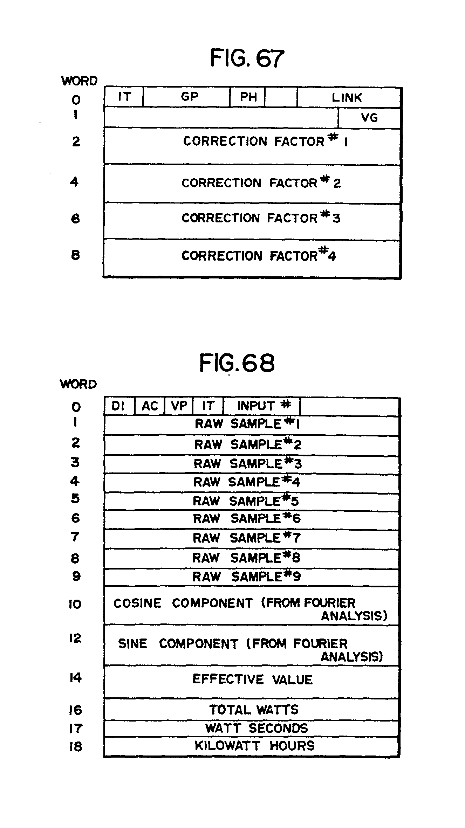

Figure 67 is the input personality table of which there are 48 corresponding to the 48 potential transformer and current transformer inputs. IT identifies the input type which may be voltage, current, or temperature. Link is the input number of the next phase of this group of donuts. It is -1 if there are no other donuts in the group. Correction factor number 1 is used for correcting voltage values. Each of the four correction factors corresponds to a range of input values from the current transformers. Again, as with the donuts, the group number identifies groups of transformers associated with a single power line and PH identifies the phase number of the particular transformer. VG identifies the voltage group that the current is to be associated (that is, sampled) with. It is used, of course, only when the table is used to store values from a current transformer. The input personality tables are stored in the electrically erasable read only memory 349.

48 analog input buffers are provided to store measurements received from the 48 current potential transformers. The form of each of these buffers is shown in Figure 68.

The follow flags are provided:
DI(Data In) - Set when all raw data has been received and sign extended. Clear when buffer is ready for more data.
AC(Analysis Complete) - Set when Fourier analysis and effective value computations are complete.
VP(Valid Power) - Set if total watts value has already been calculated.
IT(Input Type) - 0 = voltage, 1 = current, 2 = temperature.

Words 1-9 and 10-18 are 12 bit values, sign extended to 16 bits. All 2 word values are floating point. Words 16-18 are defined for 0 1 of current inputs only. Words 10-18 are undefined for temperature inputs. VP only applies to buffers associated with Ø 1 current inputs. If IT = 2 (temperature), the first sample will be converted to floating point and stored at offset 10.

In operation, transmissions are received randomly from the donuts 20, transmitted in Manchester code to the serial port to the communications board 106. The checked sum (CRC) is calculated and if it agrees with the check sum (CRC) received, an interrupt is provided to the central processing unit 334, which then transfers the data to data bus 338. The central processing unit 68000 applies the scale factors and temperature offset to the received values, and calculates the Temperature, effective Voltage (V_{EFF}), effective Current (I_{EFF}), Scaled Temperature, Total Watts, Watt Seconds and Kilowatt hours from the received data and stores the data in the appropriate Digital Input Buffer in random access memory 346.

In the analog board 340, each of the 48 transformer inputs is sampled in turn. After its condition has been converted to digital form, an interrupt is generated, and the data is supplied to data bus 338. It should be noted that the analog board 340 causes the inputs from the potential and current transformers 332 to be Fourier sampled nine times just as current and voltage are sampled in the donuts (see Figure 34). Thus, the data supplied to the data bus 338 from the analog board 340 comprises 9 successive values over nine alternating current cycles. After all nine have been stored in the random access memory 346, and the appropriate correction factors (Figure 67) applied, the fundamental sine and cosine Fourier components are calculated just as in the donuts 20.

Then the effective value of current or voltage is calculated and, if appropriate, the Total Watts, Watt Seconds, and Kilowatt hours, and the entire table (Figure 68) stored in the random access memory 346.

When the receiver 24 is initially set up, the appropriate donut scale factors (Figure 65) are loaded through RS232 port 354 into the electrical erasable read only memory 349, and these are used to modify the values received from the donuts 20 before they are recorded in the digital input buffers of the random access memory 346. Similarly, an input personality table (Figure 67) is stored in the electrical erasable read only memory 349 corresponding to each of the current and potential transformers and this is utilized to apply the appropriate corrections to the data received by the analog board 340 before it is recorded in the analog input buffers of the random access memory 346. The scaled data stored in the digital input buffers and the corrected data stored in the analog input buffers is then assembled into a frame or message containing all of the defined data from all of the donuts 20 and all of the transformers 332 and transmitted via transmission link 32 to a receiver which may be the remote terminal interface of the prior art as previously described.

The form of the analog-to-digital, multiplexed input sample and hold circuitry and program in the receiver 24 may be essentially the same as that in the donut. The same is true for the Fourier component calculation program and the calculation of the check sum (CRC). The programs are appropriately modified to run in the 68000 central processing unit with its associated memories.

If harmonic data is desired, then higher Fourier harmonics are calculated in the donuts 20 and transmitted to the receiver 24. The receiver then uses the higher harmonic values to calculate the amplitude of each harmonic it is desired to measure.

The frequency at any donut 20 may be determined, if desired, by measuring the time between transmissions received from the donut as these are an integral multiple (W, see Figure 34) of the line frequency at the donut. Alternatively, the donut may employ an accurate quartz clock to measure the time between zero crossings (Figure 34) and transmit this frequency measurement to the receiver.

If desired, power factor may be calculated from the Fourier components and stored in the input buffers (Figures 66 and 68). Reactive power (Vars) may be calculated from the Fourier components rather than real power (Watts) as selected by an additional flag in each of the Donut Scale Factor Tables (Figure 65) and the Input Personality Table (Figure 67). Alternatively, all of these calculations and others, as well as other information such as frequency, may be stored in expanded Input Buffers (Figures 66 and 68).

The electrical erasable read only memory 349 may be unloaded through the RS232 port 354 when desired to check the values stored therein. They may also be displayed in the display 352 and entered or changed by means of the keyboard 350.

The output from the receiver 24 is a frame of 64 (for example) data values from the Input Buffers (Figures 66 and 68) chosen by an output Personality Table (not shown) stored in the electrically erasable read only memory 349. This frame of values is transmitted to the Moore remote terminal unit once each second. The output personality table may be displayed on display 352 and entered by keyboard 350 or entered on read out through RS232 port 354.

It will thus be seen that a number of separate novel concepts have been applied to develop a practical state estimator module which may be applied to live power lines; a module is capable of measuring the temperature of the power line, the ambient temperature, the voltage and current of the line; the frequency and harmonic content of the line; and transmits this information to a receiver where power information such as real and reactive power and power factor may be calculated.

Thus, we have provided a state estimator module which may be installed to all of the live power lines leading to and from a substation and to both sides of power transformers in the substation, and thus provide the totality of information required for complete remote control of the power station from a power centre, and also provide for local control. Our estimator modules may be installed on live monitored circuits in an existing substation having current and voltage transformers and our receiver used to collect this totality of information and transmit it to a remote terminal unit and thence to a power system control centre.

Some of the important concepts which are included in the system are the metallic toroidal housing for the module (which is a high frequency but not a low frequency shunt about its contents); the supporting hub and spoke means; spring loaded temperature sensors; novel voltage measuring means; transmission of Fourier components; random burst transmission on a single radio channel with the timing between bursts being artfully chosen to minimize simultaneous transmissions from two or more donuts; novel hinge clamp which may be operated by a novel hot stick mounted tool facilitating the mounting of the module to a energized power conductor; and the concept that such hot stick mounted modules when distributed throughout a power delivery system, can provide for total automatic dynamic state estimator control.

## Claims

1. An electrical power line state estimator module comprising:
(A) a generally toroidal shaped two-piece housing;
(B) at least one sensor contained in said housing for measuring at least one characteristic of a power line;
(C) a transmitter in said housing for transmitting through the air measurements made by said sensor;
(D) a hinge clamp operable by a hot stick mounted tool connecting the two pieces of said housing together such that they may be clamped about an energized electrical power line.

2. The module defined in claim 1, wherein said hinge clamp comprises:
a. a pair of clamping jaws having opposed clamping faces,
b. a hinge for said jaws to one side of the said faces,
c. a pair of jaw operating members each attached to one of said jaws between said hinge and said clamping face thereof,
d. a loop of cable about said jaw operating members, and
e. cable pulling means for pulling on said cable and thereby closing said jaws to force said faces toward each other.

3. The module defined in claim 1, wherein said hinge clamp comprises:
a. a pair of clamping jaws having opposed clamping faces,
b. a hinge for said jaws to one side of the said faces,
c. a pair of jaw operating members each attached to one of said jaws between said hinge and said clamping face thereof,
d. sliding means for pulling said jaw operating members together thereby closing said jaws to force said faces toward each other, said sliding means sliding toward and away from said faces,
e. a nut fixed to said hinge, and
f. a barrel screw having an axial splined opening therein and oppositely threaded screw ends, one of said ends threaded into said sliding means and the other threaded into said nut.

4. A module as defined in claim 1, and:
hub and spoke means for mounting said housing to and about a power line conductor.

5. A module as defined in claim 1, wherein said sensor measures current.

6. A module as defined in claim 1, wherein said sensor measures voltage.

7. A module as defined in claim 1, wherein said sensor measures the temperature of said power line.

8. A module as defined in claim 1, wherein said sensor measures the ambient temperature.

9. A module as defined in claim 1, wherein said sensors measure current, voltage and temperature of said power line.

10. A module as defined in claim 9, wherein said sensors also measure the ambient temperature.

11. A module as defined in claim 4 and a plurality of inserts of differing diameters for said hub means for accommodating conductors of differing diameters.

12. A module as defined in claims 5 or 6, wherein said power line is an alternating current power line and wherein said sensor computes the Fourier components of said characteristics.

13. A module as defined in claim 12, and a receiver for receiving said currents and computing one or more characteristics of the power line therefrom.

14. A module as defined in claim 13, wherein said power line is an alternating current power line and wherein the Fourier components of current and voltage are transmitted and said receiver computes at least one power characteristic therefrom.

15. A module as defined in claim 12 wherein said power line is an alternating current power line and wherein said module transmits at intervals which are an integral number of cycles of said power line and said receiver computes the frequency of said power line from the time between received transmissions.

16. The module defined in claim 5 or claim 6, wherein said module measures the temperature of said power line and means responsive to transmissions from said module for determining the dynamic line rating of said power line.

17. The module defined in claim 16, wherein said module also measures the ambient temperature.

18. An alternating current power line state estimator module comprising:-
(A) a generally toroidal shaped housing for mounting about a power line;
(B) means for measuring the amplitude of at least one cyclic characteristic of the power on said line at a plurality of fixed and equally separated time phases of said cyclic characteristic;
(C) means for calculating the Fourier components of said characteristic from said measurements; and
(D) a transmitter for transmitting said components over a communication channel.

19. A sensor module for monitoring a power line conductor characterised by:
a generally toroidally shaped tow-piece housing removably attachable to the conductor;
sensor means for measuring characteristics of the conductor, including conductor temperature, conductor voltage, conductor current, and cyclic characteristics of power transmitted on the conductor;
means for processing the measurements, including means for selecting one of the measured characteristics and means for storing the selected measurement; and
means for transmitting through the air the processed measurement to a remote ground receiver; wherein
the measuring means, processing means, and transmitting means are each contained within the housing which is removably attachable to the conductor while said conductor is energized;
the module being further characterised by a hot stick mounted tool connecting the two pieces of the housing together such that they may be clamped about the energized power line.
